(19) Europäisches Patentamt
European Patent Office
Office européen des brevets

(11) **EP 4 775 645 A1**

(12) **EUROPEAN PATENT APPLICATION**

(43) Date of publication:
**15.07.2026 Bulletin 2026/29**

(21) Application number: **26151090.3**

(22) Date of filing: **09.01.2026**

(51) International Patent Classification (IPC):
***C09K 11/02*** *(2006.01)* ***C09K 11/62*** *(2006.01)*

(52) Cooperative Patent Classification (CPC):
**C09K 11/621; C09K 11/025**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **10.01.2025 KR 20250004237**

(71) Applicant: **Samsung Electronics Co., Ltd.**
**Suwon-si, Gyeonggi-do 16677 (KR)**

(72) Inventors:
- **SON, Dae-Yong**
  **16678 Suwon-si (KR)**
- **CHAE, Sue In**
  **16678 Suwon-si (KR)**
- **JO, A Ra**
  **16678 Suwon-si (KR)**
- **LIM, Mi Hye**
  **16678 Suwon-si (KR)**
- **LEE, Junho**
  **16678 Suwon-si (KR)**
- **LEE, Young Hoon**
  **16678 Suwon-si (KR)**
- **WON, Nayoun**
  **16678 Suwon-si (KR)**
- **BAE, Min Jong**
  **16678 Suwon-si (KR)**
- **KIM, Taekhoon**
  **16678 Suwon-si (KR)**
- **WON, Jong Hoon**
  **16678 Suwon-si (KR)**

(74) Representative: **Elkington and Fife LLP**
**Prospect House**
**8 Pembroke Road**
**Sevenoaks, Kent TN13 1XR (GB)**

# (54) SEMICONDUCTOR NANOPARTICLE, METHOD OF PRODUCING THE SAME AND ELECTRONIC DEVICE INCLUDING THE SAME

(57) A method of manufacturing a semiconductor nanoparticle, a semiconductor nanoparticle manufactured thereby, an electronic device including the semiconductor nanoparticle, and a method of manufacturing the electronic device. The method of manufacturing the semiconductor nanoparticle includes: combining, in a medium including an organic solvent, a first semiconductor nanocrystal including silver, a Group 13 element, and a chalcogen element, or a first particle including the first semiconductor nanocrystal; a sulfur precursor; and a gallium precursor; and heating the medium to a reaction temperature to form a second semiconductor nanocrystal including sulfur and gallium on the first semiconductor nanocrystal or the first particle. The method further includes adding an acid compound to the medium, and the acid compound has a dipole moment of greater than or equal to about 2 debye and less than or equal to about 5 debye.

FIG. 2 A

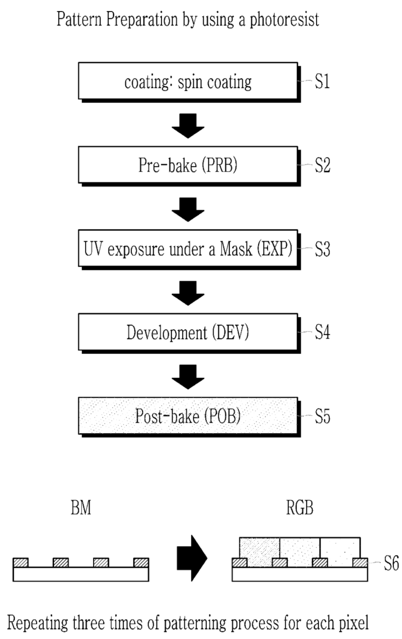


EP 4 775 645 A1

## Description

FIELD OF THE INVENTION

A semiconductor nanoparticle, a method of producing the semiconductor nanoparticle, an ink composition including the semiconductor nanoparticle, a semiconductor nanoparticle composite, a display device comprising the semiconductor nanoparticle, an electronic device including the semiconductor nanoparticle, and a method of manufacturing the electronic device are disclosed.

BACKGROUND OF THE INVENTION

A semiconductor nanoparticle may exhibit different aspects, characteristics, or properties compared to a corresponding bulk material having substantially the same composition. For example, the semiconductor nanoparticle may have different physical properties based on the nanostructure (e.g., bandgap energy, a luminescent property, or the like). The semiconductor nanoparticle may be configured to emit light upon excitation by incident light or an applied voltage. The luminescent nanostructure may find applicability in a variety of devices (e.g., a display panel or an electronic device including the display panel). From an environmental point of view, developing a luminescent nanoparticle that does not contain a harmful heavy metal such as cadmium, and still achieves comparable or an improvement in one or more luminescent or optical properties is of interest and desirable.

SUMMARY OF THE INVENTION

An embodiment is directed to a method of manufacturing a semiconductor nanoparticle exhibiting improved properties with an increased yield.

An embodiment is directed to a semiconductor nanoparticle or a population thereof manufactured from the manufacturing method.

An embodiment relates to a composition (e.g., an ink composition) including the semiconductor nanoparticle or a population thereof.

An embodiment relates to a color conversion panel or a display device including the semiconductor nanoparticle or a population thereof.

An embodiment relates to an electronic device including the semiconductor nanoparticle or a population thereof, e.g., in a color conversion panel of an electronic device or display device.

An embodiment relates to a method of manufacturing the electronic device including the semiconductor nanoparticle or a population thereof, e.g., in a color conversion panel of an electronic device or display device.

Embodiments relate to cadmium-free Ag-In-Ga-S (AIGS) semiconductor nanoparticles and, in particular, to a manufacturing method that enables very high gallium-to-indium ratios (Ga:In ≥ ~20:1) while maintaining high quantum yield and low trap emission. The core inventive concept lies in the use of an acid treatment employing an acid compound with a defined dipole moment (2-5 debye) during or after shell growth, which suppresses gallium-derived surface by-products and stabilises the optical performance of high-Ga AIGS nanoparticles.

The proposed process builds on a core-shell growth approach in which an AIGS core nanocrystal is overcoated with a Ga-S-containing shell (optionally via an intermediate particle). Conventionally, increasing Ga content during shelling leads to amorphous Ga-rich surface layers and degraded photoluminescence. Here, the addition of a polar acid (e.g. trifluoroacetic acid or related halogenated carboxylic/sulfonic acids) selectively removes or passivates gallium by-products and surface defects. This enables formation of a crystalline shell with high Ga incorporation, without the loss of emission efficiency normally associated with such compositions.

Embodiments may be based on the realization that acids above a critical dipole moment threshold permanently remove/passivate Ga-related surface by-products in high-Ga AIGS systems.

Technical effects achieved may be clearly demonstrated: nanoparticles with Ga:In ratios in the range of about 20:1 to 40:1 exhibit absolute quantum yields of ≥90% (often >92%), significantly reduced trap-emission fractions, improved crystallinity (confirmed by TEM/XRD), and higher inorganic residue in TGA, indicating effective ligand/by-product removal. Importantly, these benefits persist after washing and subsequent high-temperature processing, distinguishing the claimed acid treatment from lower-dipole acids that provide only transient improvements.

From a manufacturing and integration perspective, embodiments of the proposed method may be compatible with scalable colloidal synthesis and standard shell-growth chemistries, requiring only an additional acid-treatment step with defined polarity rather than tight stoichiometric control. The resulting nanoparticles may show improved process stability in polymer composites and patterned films, retaining quantum efficiency after 180 °C bake steps. This directly supports their use in ink compositions, colour-conversion layers, and display architectures (e.g. micro-LED, OLED, or LCD backlights), addressing a key bottleneck for high-performance, cadmium-free colour-conversion materials in commercial

devices.

In an embodiment, a method of manufacturing a nanoparticle includes:

combining, in a medium including an organic solvent, a first semiconductor nanocrystal or a first particle including the first semiconductor nanocrystal, wherein the first semiconductor nanocrystal includes silver, a group 13 element, and a chalcogen element, or; a sulfur precursor; and a gallium precursor; and
heating the medium to a reaction temperature to form a second semiconductor nanocrystal including sulfur and gallium on the first semiconductor nanocrystal or the first particle, and
adding an acid compound to the medium, wherein the acid compound has a dipole moment of greater than or equal to about 2 debye and less than or equal to about 5 debye.

The group 13 element may include indium and gallium, and the chalcogen element may include sulfur. In the semiconductor nanoparticle, a mole ratio of gallium to indium may be greater than or equal to about 19.7:1, or greater than or equal to about 20:1 and less than or equal to about 40:1, or less than or equal to about 39:1.

The method may include adding the first semiconductor nanocrystal or the first particle including the first semiconductor nanocrystal and the gallium precursor to the medium including the organic solvent, the sulfur precursor, and an organic ligand. The medium including the organic solvent, the sulfur precursor, and the organic ligand may be pretreated.

The gallium precursor may include gallium bromide and optionally gallium chloride, gallium iodide, or a combination thereof. The gallium precursor may further include or may not include gallium chloride, gallium iodide, or a combination thereof.

The first particle may further includes a second semiconductor nanocrystal that includes gallium and sulfur and disposed on the first semiconductor nanocrystal. Forming the first particle may include combining, in a first medium including a first organic solvent, the first semiconductor nanocrystal, a first sulfur precursor, a first gallium precursor, and optionally a first silver compound; heating the first medium to a first reaction temperature; and separating a particle formed in the first medium to provide a separated first particle, and optionally washing with a washing solvent.

The washing solvent may include an alcohol solvent of C1 to C10.

The washing the separated first particle may include washing the separated first particles with an alcohol solvent of C1 to C10.

The method may further include adding a silver compound to the medium. The silver compound may be added to the medium in an amount of greater than or equal to about 0.01 mole percent (mol%) relative to the gallium precursor, greater than or equal to about 0.03 mol%, greater than or equal to about 0.05 mol%, greater than or equal to about 0.052 mol%, greater than or equal to about 0.1 mol%, greater than or equal to about 0.2 mol%, for example, greater than or equal to about 0.5 mol%, and less than or equal to about 50 mol%, for example, less than or equal to about 25 mol%.

The acid compound may further include a halogen (e.g., fluorine, chlorine, or a combination thereof). The acid compound may include a carboxyl group, a sulfonic acid group, or a combination thereof.

The acid compound may include a halogen-substituted carboxylic acid compound, a halogen-substituted sulfonic acid compound, a sulfonic acid compound including a substituted or unsubstituted aromatic group, or a combination thereof.

The acid compound may include trichloroacetic acid, trifluoroacetic acid, chlorosulfonic acid, p-toluenesulfonic acid, 3,3,3-trichloro-2-(trichloromethyl)propanoic acid, 3,3,3-trichloromethylpropanoic acid, 3,3,3-trichloropropanoic acid, or a combination thereof.

The method may include adding the acid compound to the medium and then stirring for greater than or equal to about 10 minutes, or greater than or equal to about 30 minutes and less than or equal to about 10 hours, or less than or equal to about 2 hours.

In an embodiment, a semiconductor nanoparticle includes silver, indium, gallium, and sulfur, and in the semiconductor nanoparticle, a mole ratio of gallium to indium (Ga:In) is greater than or equal to about 19.2:1 and less than or equal to about 40:1, and the semiconductor nanoparticle has a quantum yield of greater than or equal to about 90% and less than or equal to about 100%.

The semiconductor nanoparticle may include a group 11-13-16 compound including silver, indium, gallium, and sulfur. The semiconductor nanoparticle may include a first semiconductor nanocrystal including a group 11-13-16 compound including silver, indium, gallium, and sulfur; and a second semiconductor nanocrystal including silver, gallium, and sulfur.

In the semiconductor nanoparticle, the mole ratio of gallium to indium (Ga:In) may be greater than or equal to about 19.5:1, greater than or equal to about 20.1:1, greater than or equal to about 20.5:1, greater than or equal to about 21:1, or greater than or equal to about 22.5:1. In the semiconductor nanoparticle, the mole ratio of gallium to indium (Ga:In) may be less than or equal to about 40:1, less than or equal to about 35:1, or less than or equal to about 28:1.

In the semiconductor nanoparticle, a mole ratio of gallium to silver (Ga:Ag) may be greater than or equal to about

1.2:1, greater than or equal to about 1.3:1, greater than or equal to about 1.4:1, greater than or equal to about 1.5:1, greater than or equal to about 1.6:1, or greater than or equal to about 2:1 and less than or equal to about 2.3:1, less than or equal to about 2.2:1, or less than or equal to about 1.7:1.

In the semiconductor nanoparticle, a mole ratio of gallium to a total of indium and gallium (Ga/(In+Ga)) may be greater than about 0.95:1, greater than or equal to about 0.952:1, greater than or equal to about 0.957:1, or greater than or equal to about 0.958:1 and less than or equal to about 0.99:1, less than or equal to about 0.98:1, or less than or equal to about 0.965:1.

The semiconductor nanoparticle may have a charge balance value obtained by Equation 1 of greater than or equal to about 0.95, greater than or equal to about 1, greater than or equal to about 1.1, or greater than or equal to about 1.3 and less than or equal to about 1.44, less than or equal to about 1.35, less than or equal to about 1.15, less than or equal to about 1.13, less than or equal to about 1.1, or less than or equal to about 1.08:

Equation 1

$$\text{Charge balance value} = \{[Ag] + 3\times([In] + [Ga])\}/(2\times[S])$$

Here, [Ag], [In], [Ga], and [S] are mole amounts of silver, indium, gallium, and sulfur in the semiconductor nanoparticle, respectively.

The semiconductor nanoparticle may further include zinc. The semiconductor nanoparticle may include a semiconductor nanocrystal (for example, a third semiconductor nanocrystal or a fourth semiconductor nanocrystal) including zinc, sulfur, and optionally gallium.

The semiconductor nanoparticle may include or may not include sodium. The semiconductor nanoparticle may include or may not include lithium.

The semiconductor nanoparticle may further include a halogen (for example, fluorine, chlorine, or a combination thereof).

The semiconductor nanoparticle may further include a carboxylic acid moiety. The semiconductor nanoparticle may further include an acid compound including a halogen-substituted alkyl group.

In thermogravimetric analysis results, the semiconductor nanoparticle may have a residue amount of greater than or equal to about 80 weight percent (wt%), or greater than or equal to about 81 wt%.

An (absolute) quantum yield of the semiconductor nanoparticle may be in a range of 92% to 98% or 93% to 97%.

The semiconductor nanoparticle may be configured to emit first light. The first light may be green light. The first light may be red light.

A peak emission wavelength of the first light or the semiconductor nanoparticle may be greater than or equal to about 480 nanometers (nm) and less than or equal to about 660 nm.

A peak emission wavelength of the first light or the semiconductor nanoparticle may be greater than or equal to about 500 nm or greater than or equal to about 515 nm and less than or equal to about 580 nm, or less than or equal to about 550 nm.

A peak emission wavelength of the first light or the semiconductor nanoparticle may be greater than or equal to about 600 nm or greater than or equal to about 605 nm and less than or equal to about 660 nm, or less than or equal to about 650 nm.

The first light or the semiconductor nanoparticle may have a full width at half maximum of greater than or equal to about 5 nm, or greater than or equal to about 10 nm and less than or equal to about 50 nm, less than or equal to about 45 nm, or less than or equal to about 36 nm.

The semiconductor nanoparticle may have a trap emission percentage, calculated by the following Equation 1B, that is less than or equal to about 20%, less than or equal to about 19%, less than or equal to about 18%, or less than or equal to about 17%:

$$\text{trap emission percentage} = [\text{trap emission area of emission spectrum/total area of emission spectrum}] \times 100\ (\%) \qquad \text{Equation 1B}$$

In the above equation, the trap emission area refers to an area of a trap emission region (i.e., a region of the emission spectrum at wavelengths greater than or equal to peak emission wavelength plus 50 nanometers, e.g., a region of the emission spectrum in the wavelength range of at least 50 nm longer than a given peak emission wavelength).

The semiconductor nanoparticle may have a size greater than or equal to about 7 nm, greater than or equal to about 7.5 nm, or greater than or equal to about 8 nm, and less than or equal to about 30 nm, less than or equal to about 17 nm, less than or equal to about 15 nm, or less than or equal to about 12 nm; or may be in a range of any combination thereof.

In an embodiment an ink composition may include the aforementioned semiconductor nanoparticle and a liquid vehicle. The semiconductor nanoparticle may be dispersed within the liquid vehicle. The liquid vehicle may include a

polymerizable (or liquid) monomer, an organic solvent, or a combination thereof. The ink composition may be substantially free of a volatile organic solvent. The ink composition may further include a metal oxide nanoparticle.

In an aspect, a semiconductor nanoparticle composite may include a matrix and the semiconductor nanoparticle, wherein the semiconductor nanoparticle is dispersed in the matrix. The semiconductor nanoparticle composite may be a patterned film. The semiconductor nanoparticle composite may be a sheet in which first semiconductor nanoparticles emitting a first light and second semiconductor nanoparticles emitting a second light are mixed, wherein the first light and the second light may be different.

In an embodiment, the semiconductor nanoparticle composite may exhibit an internal quantum efficiency (IQE) or an external quantum efficiency (EQE) of greater than or equal to about 50% and the IQE and the EQE are defined by Equation 2 and Equation 3, respectively:

Equation 2

$$\text{Internal quantum efficiency (IQE, \%)} = [A/(B-B')] \times 100$$

Equation 3

$$\text{External quantum efficiency (EQE, \%)} = [A/B] \times 100$$

wherein:

A: amount of a first light emitted from the semiconductor nanoparticle or the semiconductor nanoparticle composite
B: amount of irradiated incident light provided to the semiconductor nanoparticle composite
B': amount of the irradiated incident light passing through the semiconductor nanoparticle composite.

An internal quantum efficiency (or external quantum efficiency) of the semiconductor nanoparticle composite may be in a range of about 36% to about 100%, about 37% to about 98%, about 39% to about 96%, about 41% to about 92%, about 43% to about 90%, or a range of any combinations thereof.

The semiconductor nanoparticle composite may be heat-treated at 180°C for 30 minutes, and a process maintenance percentage obtained by the Equation 4 may be greater than or equal to about 75%, or greater than or equal to about 90%:

Equation 4

$$\text{Process maintenance percentage (\%)} = [QE2/QE1] \times 100.$$

wherein

QE1: quantum efficiency of the semiconductor nanoparticle composite before the heat treatment
QE2: quantum efficiency of the semiconductor nanoparticle composite after the heat treatment.

The quantum efficiency may be the IQE or the EQE.

In an embodiment, a color conversion layer or a color conversion structure (hereinafter, referred to as a color conversion layer) including the semiconductor nanoparticle or a color conversion region including the semiconductor nanoparticle is provided. In an embodiment, a device may include a color conversion layer including a color conversion region and, optionally, a partition wall (e.g., a black matrix, a bank, a pixel defining layer, etc.) defining each region of the color conversion layer. The color conversion region includes a first region corresponding to a first pixel, the first region includes a first composite configured to emit first light, and the first composite may include a matrix and the semiconductor nanoparticle dispersed in the matrix.

In an embodiment, an electronic device includes a color conversion layer. The color conversion layer includes a semiconductor nanoparticle, and the semiconductor nanoparticle includes silver, indium, gallium, and sulfur, a mole ratio of gallium to indium (Ga/In) is greater than or equal to about 20:1 and less than or equal to about 40:1, and the semiconductor nanoparticle has a quantum yield of greater than or equal to about 90% and less than or equal to about 100%.

In an embodiment, an electronic device (or a display device) includes a color conversion panel or the display panel. The electronic device (or the display panel) includes a composite layer (e.g., a color conversion layer, a color conversion panel, etc.) including a light source and the semiconductor nanoparticle. In an embodiment, the device may include a light emitting panel (or a light source), the color conversion panel, and optionally a light-transmitting layer

positioned between the light emitting panel and the color conversion panel.

The light emitting panel includes a light source, and the light source may be configured to provide incident light to the color conversion layer (or the color conversion panel). The incident light may include blue light and, optionally, green light. The blue light may have a peak wavelength in a range of 440 nm to 460 nm or 450 nm to 455 nm.

The light source may include an organic light emitting diode, a micro LED, a mini LED, a nanorod-containing LED, or a combination thereof.

In an embodiment, the electronic device (the display device) may include a display device for an augmented reality/virtual reality device, a mobile terminal device, a monitor, a notebook, a television, an electronic billboard, a camera, or a vehicle electronic component.

In an embodiment, a method of manufacturing an electronic device including a color conversion layer is provided. The color conversion layer includes a semiconductor nanoparticle, the semiconductor nanoparticle includes silver, indium, gallium, and sulfur, a mole ratio of gallium to indium (Ga/In) is greater than or equal to about 20:1 and less than or equal to about 40:1, and the semiconductor nanoparticle has a quantum yield of greater than or equal to about 90% and less than or equal to about 100%.

The method of manufacturing the electronic device includes producing a light emitting panel; producing a color conversion panel including the color conversion layer; and combining the light emitting panel and the color conversion panel.

The semiconductor nanoparticle of the embodiment may exhibit increased emission efficiency and increased crystallinity together with improved process stability. A polymer composite including the semiconductor nanoparticle of the embodiment may minimize an increase in trap emission and a decrease in emission efficiency caused by high-temperature processing.

## BRIEF DESCRIPTION OF THE DRAWINGS

The above and other aspects, features, and advantages of certain exemplary embodiments will be more apparent from the following detailed description taken in conjunction with the accompanying drawings.

FIG. 1 is a model emission spectrum illustrating a (e.g., normalized) photoluminescence (PL) intensity versus a wavelength (nanometers, nm) including the concept of trap emission percentage.

FIG. 2A is a flowchart showing pattern formation process (photolithography method) using the ink composition of an embodiment.

FIG. 2B is a flowchart showing a pattern forming process (inkjet method) using the ink composition of an embodiment.

FIG. 3A is a schematic cross-sectional view of a color conversion panel according to an embodiment.

FIG. 3B is a cross-sectional view of an electronic device (or display device) including a color conversion panel according to an embodiment.

FIG. 4A is a perspective view illustrating a display panel including a color conversion panel according to an embodiment.

FIG. 4B is an exploded view of a display device according to an embodiment.

FIG. 4C is a cross-sectional view of the display panel of FIG. 4A.

FIG. 4D is an exploded view of a display panel according to an embodiment.

FIG. 5A is a plan view illustrating a pixel arrangement of the display panel of FIG. 4A.

FIGS. 5B, 5C, 5D, and 5E are cross-sectional views showing light emitting devices, respectively, according to an embodiment.

FIG. 6 is a cross-sectional view of the display panel of FIG. 5A taken along line IV-IV.

FIG. 7A is a schematic cross-sectional view of a display device (e.g., a liquid crystal display device) according to an embodiment.

FIG. 7B is a flow chart of a method of manufacturing an electronic device.

FIG. 7C is a schematic cross-sectional view of an electronic device (e.g., a light emitting device) according to an embodiment.

FIG. 8A illustrates thermogravimetric analysis (TGA) analysis results of the semiconductor nanoparticle prepared in Example 1 and Reference Example 1.

FIG. 8B illustrates TGA-Mass analysis (Evolved Gas Analysis) results of the semiconductor nanoparticle prepared in Example 1 and Reference Example 1.

FIG. 9A illustrates transmission electron microscopy (TEM) analysis results of the semiconductor nanoparticle prepared in Reference Example 1.

FIG. 9B illustrates TEM analysis results of the semiconductor nanoparticle prepared in Example 1.

FIG. 10 illustrates X-ray diffraction analysis results of the semiconductor nanoparticle of Example 1 and Reference Example 1.

FIGS. 11 to 15 each illustrate X-ray photoelectron spectroscopy (XPS) analysis results of the semiconductor nanoparticle of Example 1 and Reference Example 1.

DETAILED DESCRIPTION

Advantages and features of the techniques described hereinafter, and methods of achieving them, will become apparent with reference to the exemplary embodiments described below in further detail in conjunction with the accompanying drawings. However, the embodiments should not be construed as being limited to the exemplary embodiments set forth herein. If not defined otherwise, all terms (including technical and scientific terms) as used herein may be defined as commonly understood by one having ordinary skill in the art. The terms defined in a generally-used dictionary may not be interpreted ideally or exaggeratedly unless clearly defined.

In addition, unless explicitly described to the contrary, the word "comprise" and variations such as "comprises" or "comprising," will be understood to imply the inclusion of stated elements but not the exclusion of any other elements.

In the drawings, the thickness of layers, films, panels, regions, etc., are exaggerated for clarity. Like reference numerals designate like elements throughout the specification.

It will be understood that when an element such as a layer, film, region, or substrate is referred to as being "on" another element, it can be directly on the other element or intervening elements may also be present. In contrast, when an element is referred to as being "directly on" another element, there are no intervening elements present.

As used herein, the singular forms "a," "an," and "the" are intended to include the plural forms, including "at least one," unless the context clearly indicates otherwise. For example, the wording "semiconductor nanoparticle" may refer to a single semiconductor nanoparticle or may refer to a plurality of semiconductor nanoparticles. "At least one" is not to be construed as being limited to "a" or "an." "Or" means "and/or." As used herein, the term "and/or" includes any and all combinations of one or more of the associated listed items.

It will be understood that, although the terms "first," "second," "third" etc. may be used herein to describe various elements, components, regions, layers, and/or sections, these elements, components, regions, layers, and/or sections should not be limited by these terms. These terms are only used to distinguish one element, component, region, layer, or section from another element, component, region, layer, or section. Thus, "a first element," "component," "region," "layer," or "section" discussed below could be termed a second element, component, region, layer, or section without departing from the teachings of the present embodiments.

Furthermore, relative terms, such as "lower" or "bottom" and "upper" or "top," may be used herein to describe one element's relationship to another element as illustrated in the Figures. It will be understood that relative terms are intended to encompass different orientations of the device in addition to the orientation depicted in the Figures. For example, if the device in one of the figures is turned over, elements described as being on the "lower" side of other elements would then be oriented on "upper" sides of the other elements. The exemplary term "lower," can therefore, encompasses both an orientation of "lower" and "upper," depending on the particular orientation of the figure. Similarly, if the device in one of the figures is turned over, elements described as "below" or "beneath" other elements would then be oriented "above" the other elements. The exemplary terms "below" or "beneath" can, therefore, encompass both an orientation of above and below.

Exemplary embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within $\pm$ 10%, 5%, or 3% of the stated value.

As used herein, the expression "not including cadmium (or other harmful heavy metal)" may refer to the case in which a concentration of cadmium (or other harmful heavy metal) may be less than or equal to about 100 parts per million by weight (ppmw), less than or equal to about 50 ppmw, less than or equal to about 10 ppmw, less than or equal to about 1 ppmw, less than or equal to about 0.1 ppmw, less than or equal to about 0.01 ppmw, or about zero. In one or more embodiments, substantially no amount of cadmium (or other harmful heavy metal) may be present or, if present, an amount of cadmium (or other harmful heavy metal) may be less than or equal to a detection limit or as an impurity level of a given analysis tool.

Hereinafter, as used herein, when a definition is not otherwise provided, "substituted" refers to replacement of at

least one hydrogen of a moiety or compound by a substituent selected from a C1 to C30 alkyl group, a C2 to C30 alkenyl group, a C2 to C30 alkynyl group, a C6 to C30 aryl group, a C7 to C30 alkylaryl group, a C7 to C30 arylalkyl group, a C6 to C30 aryloxy group, a C6 to C30 arylthio group, a C1 to C30 alkoxy group, a C1 to C30 alkylthio group, a C1 to C30 heteroalkyl group, a C3 to C30 heteroalkylaryl group, a C2 to C30 alkylheteroaryl group, a C2 to C30 heteroarylalkyl group, a C1 to C30 heteroaryloxy group, a C1 to C30 heteroarylthio group, a C3 to C30 cycloalkyl group, a C3 to C15 cycloalkenyl group, a C6 to C30 cycloalkynyl group, a C2 to C30 heterocycloalkyl group, a halogen (-F, -Cl, -Br, or - I), a hydroxy group (-OH), a nitro group ($-NO_2$), a cyano group (-CN), an amino group or an amine group (-NRR' wherein R and R' are each independently hydrogen or a C1 to C6 alkyl group), an azido group ($-N_3$), an amidino group ($-C(=NH)NH_2$), a hydrazino group ($-NHNH_2$), a hydrazono group ($=N(NH_2)$), an aldehyde group (-C(=O)H), a carbamoyl group ($-C(O)NH_2$), a thiol group (-SH), an ester group (-C(=O)OR, wherein R is a C1 to C6 alkyl group or a C6 to C12 aryl group), a carboxyl group (-COOH) or a salt thereof (-C(=O)OM, wherein M is an organic or inorganic cation, a sulfonic acid group ($-SO_3H$) or a salt thereof ($-SO_3M$, wherein M is an organic or inorganic cation), a phosphoric acid group ($-PO_3H_2$) or a salt thereof ($-PO_3MH$ or - $PO_3M_2$, wherein M is an organic or inorganic cation), or a combination thereof. The specified number or range of carbon atoms in a group is exclusive of any substituents.

In addition, when a definition is not otherwise provided below, "hetero" refers to the presence of 1 to 3 heteroatoms such as N, O, P, Si, S, Se, Ge, or B.

In addition, the term "aliphatic hydrocarbon group" as used herein refers to a C1 to C30 linear or branched alkyl group, a C2 to C30 linear or branched alkenyl group, or a C2 to C30 linear or branched alkynyl group, and the term "aromatic organic group" as used herein refers to a C6 to C30 aryl group or a C2 to C30 heteroaryl group.

As used herein, the term "(meth)acrylate" refers to acrylate and/or methacrylate.

As used herein, the term "Group" refers to a Group of Periodic Table.

As used herein, the terms "a nanoparticle" and "a nanostructure" refer to a structure having at least one region or characteristic dimension with a nanoscale dimension. In one or more embodiments, the dimension of the nanoparticle or the nanostructure may be less than about 500 nm, less than about 300 nm, less than about 250 nm, less than about 150 nm, less than about 100 nm, less than about 50 nm, or less than about 30 nm. The nanoparticle or nanostructure may have any shape, such as a nanowire, a nanorod, a nanotube, a multi-pod type shape having two or more pods, a nanodot, or the like, but embodiments are not limited thereto. The nanoparticle or nanostructure may be, for example, substantially crystalline, substantially monocrystalline, polycrystalline, amorphous, or a combination thereof.

A quantum dot may be, for example, a semiconductor-containing nanocrystal particle that can exhibit a quantum confinement or exciton confinement effect, and is a type of a luminescent nanostructure (e.g., capable of emitting light by energy excitation). Herein, a shape of the "quantum dot" or the nanoparticle is not limited unless otherwise expressly defined.

As used herein, the term "dispersion" refers to a dispersion in which a dispersed phase is a solid, and a continuous medium includes a liquid or a solid different from the dispersed phase. It is to be understood that the "dispersion" may be a colloidal dispersion in which the dispersed phase has a dimension of greater than or equal to about 1 nm, for example, greater than or equal to about 2 nm, greater than or equal to about 3 nm, or greater than or equal to about 4 nm and less than or equal to several micrometers ($\mu$m), (e.g., less than or equal to about 2 $\mu$m, less than or equal to about 1 $\mu$m, less than or equal to about 900 nm, less than or equal to about 800 nm, less than or equal to about 700 nm, less than or equal to about 600 nm, or less than or equal to about 500 nm).

Herein, a dimension (a size, a diameter, or a thickness, etc.) may be a value for a single entity or an average value for a plurality of nanoparticles. As used herein, the term "average" (e.g., an average size of the quantum dot) may be a mean value or a median value. In one or more embodiments, the average may be "mean" average.

As used herein, the term "maximum emission wavelength (or peak emission wavelength)" is the wavelength at which a given emission spectrum of the light reaches its maximum.

In one or more embodiments, a quantum efficiency may be readily and reproducibly determined using commercially available equipment (e.g., from Hitachi or Hamamatsu, etc.) and referring to manuals provided by, for example, respective equipment manufacturers. The quantum efficiency (which can be interchangeably used with the term "quantum yield" (QY)) may be measured in a solution state or a solid state (i.e., in a composite). In one or more embodiments, the quantum efficiency (or the quantum yield) is the ratio of photons emitted to photons absorbed by the nanostructure or population thereof. In one or more embodiments, the quantum efficiency may be measured by any method. For example, there may be two methods for measuring the fluorescence quantum yield or efficiency: the absolute method and the relative method. The quantum efficiency measured by the absolute method may be referred to as an absolute quantum efficiency.

In the absolute method, the quantum efficiency may be obtained by detecting the fluorescence of all samples through an integrating sphere. In the relative method, the quantum efficiency of the unknown sample may be calculated by comparing the fluorescence intensity of a standard dye (a standard sample) with the fluorescence intensity of the unknown sample. Coumarin 153, Coumarin 545, Rhodamine 101 inner salt, Anthracene and Rhodamine 6G may be used as standard dyes according to their photoluminescence (PL) wavelengths, but embodiments are not limited thereto.

A full width at half maximum (FWHM) and a peak emission (e.g., photoluminescence (PL) or electroluminescence (EL)) wavelength may be measured, for example, from a luminescence spectrum (for example, a photoluminescence spectrum or an electroluminescent spectrum) obtained by a spectrophotometer such as a fluorescence spectrophotometer or the like.

As used herein, the term "first absorption peak wavelength" refers to a wavelength at which a main peak first appears in a lowest energy region in the ultraviolet-visible (UV-Vis) absorption spectrum.

A semiconductor nanoparticle may be used in various electronic devices, for example, also in a color conversion panel (or an emissive color filter). A liquid crystal display device may include a white light-emitting backlight unit and an absorptive color filter, and the backlight unit may include a quantum dot sheet. In a display device including a quantum dot-containing color conversion panel or an emissive color filter, a quantum dot layer as an emission material is disposed at the front of the device, and blue light (excitation light) provided from a light source is converted into green light or red light by the quantum dot layer. In the color conversion panel, the color conversion of incident light may occur at a relatively front portion of the device, and a wide viewing angle may be implemented by omnidirectional scattering of light. The emissive color filter may realize a reduction in light loss. The color conversion panel may be an electronic device including a color conversion layer or a color conversion structure.

In the display device including the color conversion panel, properties (e.g., an optical property, stability, or the like) of a luminescent nanostructure may have a direct effect on display quality of the device. It may be desired for the luminescent material included in the color conversion panel disposed in a relatively front portion of the device to exhibit not only relatively high luminous efficiency but also relatively high absorbance with respect to incident light. When a patterned film (e.g., a color filter) is used in the display device, a decreased absorbance to the incident light may be a direct cause of a blue light leakage, having an adverse effect on a color reproducibility (e.g., DCI match rate) of the device. An adoption of an absorption type color filter for preventing a blue light leakage problem may lead to an additional decrease in luminous efficiency. Such a lowered absorbance of the semiconductor nanoparticle may result in a reduced luminance in a device including the semiconductor nanoparticle.

Semiconductor nanoparticles may exhibit properties (e.g., optical properties and/or stability) that may be applicable to a device, but many of them may include cadmium-containing compounds (e.g., a cadmium chalcogenide). The cadmium causes a serious environment/health problem and thus is one of the restricted elements in many countries. Therefore, in order to develop cadmium-free environment-friendly nanoparticles, in-depth research on nanocrystals based on Group III-V compounds has been conducted. However, cadmium-free nanoparticles including a Group III-V compound (e.g., indium phosphide) may reach a technological limit in the incident light absorbance and the full width at half maximum. Accordingly, there remains a technological need to develop an environmentally friendly nanoparticle that can exhibit a higher absorbance, a narrower full width at half maximum, and a higher luminous efficiency in comparison with a cadmium-free nanoparticle based on a Group III-V compound, such as an indium phosphide. An AIGS-containing semiconductor nanoparticle, for example, a nanoparticle including a semiconductor nanocrystal including silver, indium, gallium, and sulfur (including a group 11-13-16 compound), may have a potential to meet such technical needs; however, the AIGS-containing semiconductor nanoparticle still has technical drawbacks (e.g., in terms of process stability) in practical device applications.

A color conversion layer including a semiconductor nanoparticle as a color conversion material may include or may not include a light source that provides incident light of a relatively short wavelength (for example, a blue light-emitting diode such as a Blue LED or a Blue OLED). The incident light (e.g., blue light) may have higher energy (e.g., less than or equal to about - 2.75 electronvolts (eV)) compared to the color-converted light such as red light or green light. It may be desirable to provide a color conversion layer capable of maintaining light conversion efficiency and color purity even under repeated irradiation of the incident light to the color conversion layer. The preparation of the color conversion layer may include formation of a composite including a semiconductor nanoparticle, for example, a polymer composite or a pattern thereof, which may involve a high-temperature process. The present inventors have identified that, when AIGS-containing semiconductor nanoparticles (e.g., a silver indium gallium sulfide-containing semiconductor nanoparticles) are exposed to such high-temperature processes, a substantial decrease in light conversion efficiency and, in particular, a significant increase in trap emission (i.e., long-wavelength emission) may be observed compared to before the exposure. For the use of AIGS-containing semiconductor nanoparticles as a color conversion layer, it may be necessary to ensure the stability of the AIGS semiconductor nanoparticles (e.g., process durability in terms of emission property and trap emission).

To address these issues, in an AIGS-containing semiconductor nanoparticle, formation of a shell having a relatively increased thickness may be considered. In an embodiment, the shell may include a semiconductor nanocrystal including gallium and sulfur. An increase in thickness of the shell may, for example, lead to an increase in a ratio of gallium to indium in the semiconductor nanoparticle. In this regard, the present inventors have confirmed that, when following a shell coating method according to the related art, there are technical difficulties in manufacturing a semiconductor nanoparticle having a desired shell thickness while maintaining improved optical properties. For example, in a conventional shell coating method, a shell is formed by reacting a Ga precursor and an S precursor in the presence of an AIGS-containing semiconductor nanocrystal; however, an increase in an amount of the gallium precursor may negatively affect formation of

a shell of desired quality (e.g., exhibiting desired crystallinity). Therefore, a semiconductor nanoparticle prepared according to the related art and having an increased Ga/In value may exhibit significantly decreased optical properties (e.g., quantum efficiency). Without wishing to be bound by any theory, when using an increased amount of a gallium precursor in a method according to the related art, a manufactured nanoparticle may include a large amount of Ga residues and an amorphous layer on a surface thereof, and such residues or the amorphous layer may scatter or absorb light provided to the semiconductor nanoparticle, thereby causing a decrease in a light conversion efficiency (PLQY).

A manufacturing method of an embodiment addresses such technical problems, and a semiconductor nanoparticle manufactured by a method of an embodiment may exhibit increased light conversion efficiency even when a ratio of gallium to indium is increased and may also exhibit high stability.

The semiconductor nanoparticle of an embodiment may achieve a desired emission property (e.g., an increased quantum yield with reduced full width at half maximum) without including cadmium, and may exhibit enhanced stability.

In an embodiment, the semiconductor nanoparticle may not contain cadmium. The semiconductor nanoparticle may not contain mercury, lead, or a combination thereof. In an embodiment, a semiconductor nanoparticle or a semiconductor nanocrystal includes a group 11-13-16 compound including silver, a group 13 element (e.g., indium and/or gallium), and a chalcogen element (e.g., sulfur). The semiconductor nanoparticle may have a size greater than or equal to about 2 nm, greater than or equal to about 5 nm, greater than or equal to about 7 nm, greater than or equal to about 7.8 nm, or greater than or equal to about 8 nm and less than or equal to about 50 nm, less than or equal to about 30 nm, less than or equal to about 12 nm, or less than or equal to about 10 nm. A semiconductor nanoparticle based on a group 11-13-16 compound according to an embodiment may achieve improved optical properties and stability by adjusting its composition (e.g., a mole ratio between elements or a charge balance value as described herein) as described herein.

The semiconductor nanoparticle of an embodiment includes Ag, In, Ga, and S, or a group 11-13-16 compound including Ag, In, Ga, and S, and may exhibit an increased level of absorbance compared to, for example, a semiconductor nanoparticle based on an indium phosphide. The semiconductor nanoparticle of an embodiment exhibits enhanced stability and, therefore, may maintain or implement desired levels of optical properties (e.g., light conversion efficiency) even after a process at a relatively high temperature (e.g., a post-bake process), which may be required for composite formation. The semiconductor nanoparticle of the embodiment may be manufactured according to the method described herein (including addition of an acid compound in a shelling process), and thus may emit light of a desired wavelength with relatively improved efficiency even when a content of gallium relative to indium is high. The semiconductor nanoparticle of an embodiment may be prepared by the method described herein (e.g., involving the formation and separation of intermediate particles), and thus, may emit light of a desired wavelength with relatively improved efficiency even when the amount ratio of gallium to indium is relatively high. The semiconductor nanoparticle of an embodiment may be prepared by the method described herein and may have the composition described herein. The semiconductor nanoparticle of an embodiment may maintain light emission efficiency at a desired level even after a film-forming process involving a relatively high-temperature baking process, while exhibiting an improved level of optical properties (e.g., high quantum yield and narrow full width at half maximum) and may suppress trap emission to a desired level.

Without wishing to be bound by any theory, in a method of an embodiment, when a semiconductor nanocrystal layer with a high content of gallium is formed, the generation of by-products (e.g., gallium oxide) that may otherwise negatively affect the property of the semiconductor nanoparticle can be suppressed, which is believed to contribute to securing improved optical property and stability of the semiconductor nanoparticle.

Therefore, in the semiconductor nanoparticle of the embodiment, a mole ratio of gallium to indium (Ga:In) may be greater than or equal to about 19.2:1, greater than or equal to about 19.5:1, greater than or equal to about 19.7:1, greater than or equal to about 19.9:1, greater than or equal to about 20:1, greater than about 20:1, or greater than or equal to about 23:1. In the semiconductor nanoparticle of the embodiment, the mole ratio of gallium to indium (Ga:In) may be greater than or equal to about 20.1:1, greater than or equal to about 20.2:1, greater than or equal to about 20.3:1, greater than or equal to about 20.4:1, greater than or equal to about 20.5:1, greater than or equal to about 20.6:1, greater than or equal to about 20.7:1, greater than or equal to about 20.8:1, greater than or equal to about 20.9:1, greater than or equal to about 21:1, greater than or equal to about 21.1:1, greater than or equal to about 21.3:1, greater than or equal to about 21.5:1, greater than or equal to about 21.7:1, greater than or equal to about 21.9:1, greater than or equal to about 22:1, greater than or equal to about 22.1:1, greater than or equal to about 22.3:1, greater than or equal to about 22.5:1, greater than or equal to about 22.7:1, greater than or equal to about 22.9:1, greater than or equal to about 23:1, or greater than or equal to about 23.1:1, greater than or equal to about 23.3:1, greater than or equal to about 23.5:1, greater than or equal to about 23.7:1, or greater than or equal to about 23.9:1; less than or equal to about 40:1, less than or equal to about 38:1, less than or equal to about 36:1, less than or equal to about 35:1, less than or equal to about 34:1, less than or equal to about 33:1, less than or equal to about 32:1, less than or equal to about 31:1, less than or equal to about 30:1, less than or equal to about 29:1, less than or equal to about 28:1, less than or equal to about 27:1, less than or equal to about 26:1, less than or equal to about 25:1, less than or equal to about 24:1, less than or equal to about 23.8:1, less than or equal to about 23.6:1, less than or equal to about 23.4:1, less than or equal to about 23:1, less than or equal to about 22.8:1, less than or equal to about 22.6:1, less than or equal to about 22.4:1, less than or equal to about 22.2:1, less than or equal to about 21.8:1, less than or equal to

about 21.6:1, less than or equal to about 21.4:1, less than or equal to about 21.2:1, less than or equal to about 21:1, less than or equal to about 20.8:1, or less than or equal to about 20.6:1; or a combined range thereof.

In the semiconductor nanoparticle of the embodiment, a mole ratio of silver to indium (Ag:In) may be greater than or equal to about 4.9:1, greater than or equal to about 5:1, greater than or equal to about 5.1:1, greater than or equal to about 5.2:1, greater than or equal to about 5.5:1, greater than or equal to about 5.7:1, greater than or equal to about 5.9:1, greater than or equal to about 6:1, greater than or equal to about 6.5:1, greater than or equal to about 7:1, greater than or equal to about 7.5:1, greater than or equal to about 8:1, greater than or equal to about 8.5:1, greater than or equal to about 9:1, greater than or equal to about 9.5:1, greater than or equal to about 10:1, greater than or equal to about 10.4:1, greater than or equal to about 11:1, greater than or equal to about 11.5:1, greater than or equal to about 11.8:1, greater than or equal to about 12:1, greater than or equal to about 12.5:1, greater than or equal to about 13:1, greater than or equal to about 13.2:1, greater than or equal to about 13.5:1, greater than or equal to about 13.7:1, greater than or equal to about 13.9:1, greater than or equal to about 14:1, greater than or equal to about 14.2:1, greater than or equal to about 14.4:1, greater than or equal to about 14.5:1, greater than or equal to about 15:1, greater than or equal to about 15.1:1, greater than or equal to about 15.2:1, greater than or equal to about 15.3:1, greater than or equal to about 16:1, greater than or equal to about 16.5:1, greater than or equal to about 17:1, greater than or equal to about 17.5:1, greater than or equal to about 18:1, greater than or equal to about 18.5:1, greater than or equal to about 19:1, greater than or equal to about 19.5:1, or greater than or equal to about 20:1; less than or equal to about 30:1, less than or equal to about 29.5:1, less than or equal to about 29:1, less than or equal to about 28:1, less than or equal to about 27:1, less than or equal to about 26:1, less than or equal to about 25:1, less than or equal to about 24:1, less than or equal to about 23:1, less than or equal to about 22:1, less than or equal to about 21:1, less than or equal to about 20:1, less than or equal to about 19.4:1, less than or equal to about 18.2:1, less than or equal to about 17.3:1, less than or equal to about 16.4:1, less than or equal to about 16.2:1, less than or equal to about 16:1, less than or equal to about 15.6:1, less than or equal to about 15.4:1, less than or equal to about 14.8:1, less than or equal to about 14.4:1, less than or equal to about 13.8:1, less than or equal to about 13.2:1, less than or equal to about 13:1, less than or equal to about 12.4:1, less than or equal to about 12.2:1, less than or equal to about 11.9:1, less than or equal to about 11.6:1, less than or equal to about 11.4:1, less than or equal to about 10.5:1, or less than or equal to about 10.3:1; or a combined range thereof.

In the semiconductor nanoparticle, a mole ratio of sulfur to indium (S:In) may be greater than or equal to about 20:1, greater than or equal to about 25:1, greater than or equal to about 27:1, greater than or equal to about 29:1, greater than or equal to about 30:1, greater than or equal to about 30.5:1, greater than or equal to about 31:1, greater than or equal to about 33:1, greater than or equal to about 35:1, greater than or equal to about 36:1, greater than or equal to about 36.5:1, greater than or equal to about 37:1, greater than or equal to about 37.3:1, greater than or equal to about 37.5:1, greater than or equal to about 38:1, or greater than or equal to about 39:1; less than or equal to about 48:1, less than or equal to about 45:1, less than or equal to about 42:1, less than or equal to about 41:1, less than or equal to about 40:1, less than or equal to about 39:1, less than or equal to about 38.5:1, less than or equal to about 37.7:1, less than or equal to about 37:1, less than or equal to about 36.3:1, less than or equal to about 35.2:1, less than or equal to about 34:1, less than or equal to about 32:1, or less than or equal to about 31.5:1; or a combined range thereof.

In the semiconductor nanoparticle, a mole ratio of indium to sulfur (In:S) may be greater than or equal to about 0.01:1, greater than or equal to about 0.015:1, greater than or equal to about 0.02:1, greater than or equal to about 0.025:1, or greater than or equal to about 0.03:1; less than or equal to about 0.1:1, less than or equal to about 0.07:1, less than or equal to about 0.05:1, less than or equal to about 0.04:1, or less than or equal to about 0.03:1; or a combined range thereof.

In the semiconductor nanoparticle, a mole ratio of gallium to sulfur (Ga:S) may be greater than or equal to about 0.45:1, greater than or equal to about 0.48:1, greater than or equal to about 0.49:1, greater than or equal to about 0.51:1, greater than or equal to about 0.52:1, greater than or equal to about 0.53:1, greater than or equal to about 0.54:1, greater than or equal to about 0.55:1, greater than or equal to about 0.56:1, greater than or equal to about 0.57:1, greater than or equal to about 0.58:1, greater than or equal to about 0.59:1, greater than or equal to about 0.6:1, greater than or equal to about 0.63:1, greater than or equal to about 0.65:1, greater than or equal to about 0.67:1, greater than or equal to about 0.69:1, greater than or equal to about 0.7:1, greater than or equal to about 0.72:1, greater than or equal to about 0.74:1, greater than or equal to about 0.76:1, or greater than or equal to about 0.78:1; less than or equal to about 1:1, less than or equal to about 0.95:1, less than or equal to about 0.9:1, less than or equal to about 0.85:1, less than or equal to about 0.8:1, less than or equal to about 0.79:1, less than or equal to about 0.75:1, less than or equal to about 0.77:1, less than or equal to about 0.75:1, less than or equal to about 0.73:1, less than or equal to about 0.71:1, less than or equal to about 0.7:1, less than or equal to about 0.69:1, less than or equal to about 0.68:1, less than or equal to about 0.65:1, less than or equal to about 0.64:1, less than or equal to about 0.61:1, less than or equal to about 0.6:1, less than or equal to about 0.56:1, less than or equal to about 0.54:1, less than or equal to about 0.52:1, or less than or equal to about 0.5:1; or a combined range thereof.

In the semiconductor nanoparticle, a mole ratio of silver to sulfur (Ag:S) may be greater than or equal to about 0.33:1, greater than or equal to about 0.35:1, greater than or equal to about 0.355:1, greater than or equal to about 0.37:1, greater than or equal to about 0.375:1, greater than or equal to about 0.39:1, greater than or equal to about 0.4:1, or greater

than or equal to about 0.41:1; less than or equal to about 0.5:1, less than or equal to about 0.45:1, less than or equal to about 0.44:1, less than or equal to about 0.43:1, less than or equal to about 0.42:1, less than or equal to about 0.41:1, less than or equal to about 0.4:1, less than or equal to about 0.39:1, less than or equal to about 0.38:1, less than or equal to about 0.36:1, or less than or equal to about 0.34:1; or a combined range thereof.

In the semiconductor nanoparticle, a mole ratio of gallium to silver (Ga:Ag) may be greater than or equal to about 1:1, greater than or equal to about 1.1:1, greater than or equal to about 1.15:1, greater than or equal to about 1.2:1, greater than or equal to about 1.25:1, greater than or equal to about 1.3:1, greater than or equal to about 1.35:1, greater than or equal to about 1.38:1, greater than or equal to about 1.4:1, greater than or equal to about 1.45:1, greater than or equal to about 1.5:1, greater than or equal to about 1.55:1, greater than or equal to about 1.6:1, greater than or equal to about 1.65:1, greater than or equal to about 1.7:1, greater than or equal to about 1.75:1, greater than or equal to about 1.8:1, greater than or equal to about 1.85:1, greater than or equal to about 1.9:1, greater than or equal to about 1.95:1, greater than or equal to about 2:1, or greater than or equal to about 2.05:1; less than or equal to about 3:1, less than or equal to about 2.9:1, less than or equal to about 2.8:1, less than or equal to about 2.7:1, less than or equal to about 2.6:1, less than or equal to about 2.5:1, less than or equal to about 2.4:1, less than or equal to about 2.3:1, less than or equal to about 2.2:1, less than or equal to about 2.1:1, less than or equal to about 2:1, less than or equal to about 1.9:1, less than or equal to about 1.8:1, less than or equal to about 1.75:1, less than or equal to about 1.7:1, less than or equal to about 1.65:1, less than or equal to about 1.6:1, less than or equal to about 1.58:1, less than or equal to about 1.56:1, less than or equal to about 1.52:1, less than or equal to about 1.48:1, less than or equal to about 1.46:1, less than or equal to about 1.44:1, or less than or equal to about 1.42:1; or a combined range thereof.

In the semiconductor nanoparticle, a mole ratio of gallium to a total of indium and gallium (Ga:(In+Ga)) may be greater than about 0.95:1, greater than or equal to about 0.951:1, greater than or equal to about 0.952:1, greater than or equal to about 0.953:1, greater than or equal to about 0.954:1, greater than or equal to about 0.955:1, greater than or equal to about 0.956:1, greater than or equal to about 0.957:1, greater than or equal to about 0.958:1, greater than or equal to about 0.959:1, or greater than or equal to about 0.96:1; less than or equal to about 0.99:1, less than or equal to about 0.985:1, less than or equal to about 0.98:1, less than or equal to about 0.975:1, less than or equal to about 0.97:1, less than or equal to about 0.965:1, or less than or equal to about 0.962:1; or a combined range thereof.

In the semiconductor nanoparticle, a mole ratio of indium to a total of indium and gallium (In:(In+Ga)) may be less than about 0.05:1, less than or equal to about 0.049:1, less than or equal to about 0.048:1, less than or equal to about 0.047:1, less than or equal to about 0.046:1, less than or equal to about 0.045:1, less than or equal to about 0.044:1, less than or equal to about 0.043:1, less than or equal to about 0.042:1, less than or equal to about 0.041:1, less than or equal to about 0.04:1, less than or equal to about 0.039:1, less than or equal to about 0.038:1, less than or equal to about 0.037:1, less than or equal to about 0.036:1, less than or equal to about 0.035:1, or less than or equal to about 0.03:1; greater than or equal to about 0.01:1, greater than or equal to about 0.011:1, greater than or equal to about 0.015:1, greater than or equal to about 0.02:1, greater than or equal to about 0.023:1, greater than or equal to about 0.025:1, greater than or equal to about 0.026:1, greater than or equal to about 0.027:1, greater than or equal to about 0.028:1, greater than or equal to about 0.029:1, greater than or equal to about 0.03:1, greater than or equal to about 0.035:1, greater than or equal to about 0.04:1, or greater than or equal to about 0.041:1; or a combined range thereof.

In the semiconductor nanoparticle, a mole ratio of a total of indium and gallium to silver ((In+Ga):Ag) may be greater than or equal to about 1.2:1, greater than or equal to about 1.3:1, greater than or equal to about 1.34:1, greater than or equal to about 1.35:1, greater than or equal to about 1.4:1, greater than or equal to about 1.41:1, greater than or equal to about 1.43:1, greater than or equal to about 1.44:1, greater than or equal to about 1.45:1, greater than or equal to about 1.46:1, greater than or equal to about 1.47:1, greater than or equal to about 1.48:1, greater than or equal to about 1.5:1, greater than or equal to about 1.53:1, greater than or equal to about 1.54:1, greater than or equal to about 1.57:1, greater than or equal to about 1.58:1, greater than or equal to about 1.59:1, greater than or equal to about 1.6:1, greater than or equal to about 1.63:1, greater than or equal to about 1.65:1, greater than or equal to about 1.68:1, greater than or equal to about 1.7:1, greater than or equal to about 1.83:1, greater than or equal to about 1.9:1, greater than or equal to about 1.94:1, greater than or equal to about 2:1, greater than or equal to about 2.1:1, greater than or equal to about 2.15:1, or greater than or equal to about 2.19:1; less than or equal to about 3.5:1, less than or equal to about 3:1, less than or equal to about 2.4:1, less than or equal to about 2.37:1, less than or equal to about 2.3:1, less than or equal to about 2.25:1, less than or equal to about 2.2:1, less than or equal to about 2:1, less than or equal to about 1.96:1, less than or equal to about 1.95:1, less than or equal to about 1.9:1, less than or equal to about 1.7:1, less than or equal to about 1.62:1, or less than or equal to about 1.48:1; or a combined range thereof.

In the semiconductor nanoparticle, a mole ratio of a total of indium and gallium to sulfur ((In+Ga):S) may be greater than or equal to about 0.3:1, greater than or equal to about 0.4:1, greater than or equal to about 0.45:1, greater than or equal to about 0.5:1, greater than or equal to about 0.52:1, greater than or equal to about 0.53:1, greater than or equal to about 0.54:1, greater than or equal to about 0.55:1, greater than or equal to about 0.56:1, greater than or equal to about 0.57:1, greater than or equal to about 0.58:1, greater than or equal to about 0.59:1, greater than or equal to about 0.6:1, greater than or equal to about 0.61:1, greater than or equal to about 0.62:1, greater than or equal to about 0.64:1, greater

than or equal to about 0.68:1, greater than or equal to about 0.7:1, greater than or equal to about 0.72:1, greater than or equal to about 0.75:1, greater than or equal to about 0.77:1, greater than or equal to about 0.78:1, greater than or equal to about 0.79:1, or greater than or equal to about 0.81:1; less than or equal to about 0.9:1, less than or equal to about 0.88:1, less than or equal to about 0.86:1, less than or equal to about 0.84:1, less than or equal to about 0.82:1, less than or equal to about 0.78:1, less than or equal to about 0.73:1, less than or equal to about 0.71:1, less than or equal to about 0.69:1, less than or equal to about 0.67:1, less than or equal to about 0.66:1, or less than or equal to about 0.65:1; or a combined range thereof.

In the semiconductor nanoparticle, a mole ratio of silver to a total of silver, indium, and gallium (Ag:(Ag+In+Ga)) may be greater than or equal to about 0.31:1, greater than or equal to about 0.33:1, greater than or equal to about 0.34:1, greater than or equal to about 0.35:1, greater than or equal to about 0.37:1, greater than or equal to about 0.38:1, greater than or equal to about 0.39:1, greater than or equal to about 0.4:1, greater than or equal to about 0.41:1, greater than or equal to about 0.42:1, greater than or equal to about 0.43:1, or greater than or equal to about 0.44:1; less than or equal to about 0.55:1, less than or equal to about 0.5:1, less than or equal to about 0.45:1, less than or equal to about 0.42:1, less than or equal to about 0.4:1, less than or equal to about 0.36:1, less than or equal to about 0.33:1, less than or equal to about 0.32:1, or less than or equal to about 0.28:1; or a combined range thereof.

In the semiconductor nanoparticle, a mole ratio of gallium to a total of gallium, indium, and silver (Ga:(Ga+In+Ag)) may be greater than or equal to about 0.45:1, greater than or equal to about 0.46:1, greater than or equal to about 0.47:1, greater than or equal to about 0.48:1, greater than or equal to about 0.49:1, greater than or equal to about 0.5:1, greater than or equal to about 0.51:1, greater than or equal to about 0.52:1, greater than or equal to about 0.53:1, greater than or equal to about 0.54:1, greater than or equal to about 0.55:1, greater than or equal to about 0.56:1, greater than or equal to about 0.57:1, greater than or equal to about 0.58:1, greater than or equal to about 0.59:1, greater than or equal to about 0.595:1, greater than or equal to about 0.6:1, greater than or equal to about 0.61:1, greater than or equal to about 0.63:1, greater than or equal to about 0.64:1, or greater than or equal to about 0.65:1; less than or equal to about 0.85:1, less than or equal to about 0.8:1, less than or equal to about 0.77:1, less than or equal to about 0.74:1, less than or equal to about 0.73:1, less than or equal to about 0.72:1, less than or equal to about 0.71:1, less than or equal to about 0.69:1, less than or equal to about 0.67:1, less than or equal to about 0.658:1, less than or equal to about 0.64:1, less than or equal to about 0.62:1, less than or equal to about 0.61:1, less than or equal to about 0.59:1, less than or equal to about 0.56:1, less than or equal to about 0.54:1, less than or equal to about 0.53:1, less than or equal to about 0.49:1, or less than or equal to about 0.485:1; or a combined range thereof.

In the semiconductor nanoparticle, a mole ratio of sulfur to a total of silver, indium, and gallium (S:(Ag+In+Ga)) may be greater than or equal to about 0.85:1, greater than or equal to about 0.87:1, greater than or equal to about 0.88:1, greater than or equal to about 0.89:1, greater than or equal to about 0.9:1, greater than or equal to about 0.92:1, greater than or equal to about 0.94:1, greater than or equal to about 0.95:1, greater than or equal to about 0.96:1, greater than or equal to about 0.97:1, greater than or equal to about 0.98:1, greater than or equal to about 0.99:1, greater than or equal to about 1:1, greater than or equal to about 1.02:1, greater than or equal to about 1.03:1, greater than or equal to about 1.04:1, greater than or equal to about 1.05:1, greater than or equal to about 1.06:1, greater than or equal to about 1.07:1, greater than or equal to about 1.08:1, greater than or equal to about 1.09:1, greater than or equal to about 1.1:1, or greater than or equal to about 1.2:1; less than or equal to about 1.5:1, less than or equal to about 1.45:1, less than or equal to about 1.35:1, less than or equal to about 1.15:1, less than or equal to about 1.13:1, less than or equal to about 1.12:1, less than or equal to about 1.11:1, less than or equal to about 1.1:1, less than or equal to about 1.09:1, less than or equal to about 1.08:1, less than or equal to about 0.9:1, or less than or equal to about 0.89:1; or a combined range thereof.

The semiconductor nanoparticle may have a charge balance value obtained by Equation 1 of greater than or equal to about 0.95, greater than or equal to about 0.98, greater than or equal to about 1, or greater than or equal to about 1.01 and less than or equal to about 1.45, less than or equal to about 1.4, less than or equal to about 1.35, less than or equal to about 1.3, less than or equal to about 1.25, less than or equal to about 1.2, less than or equal to about 1.15, less than or equal to about 1.1, less than or equal to about 1.09, less than or equal to about 1.08, less than or equal to about 1.07, less than or equal to about 1.06, or less than or equal to about 1.05:

Equation 1

$$\text{charge balance value} = \{[Ag] + 3\times([In] + [Ga])\} / (2\times[S])$$

Here, [Ag], [In], [Ga], and [S] are mole amounts of silver, indium, gallium, and sulfur in the semiconductor nanoparticle, respectively.

The semiconductor nanoparticle may further include a halogen (e.g., chlorine, bromine, or a combination thereof). In an embodiment, the semiconductor nanoparticle may further include an acid compound, and the halogen may constitute a portion of the acid compound. In an embodiment, the semiconductor nanoparticle may include a halogen-substituted acid compound.

In the semiconductor nanoparticle, a content of the halogen (e.g., chlorine, bromine, or a combination thereof) may be from 0.4 mole percent (mol%) to less than or equal to about 3200 mol% based on indium, that is, from 0.004 mol to less than or equal to about 32 mol of halogen (chlorine, bromine, or a combination thereof) per 1 mol of indium.

In the semiconductor nanoparticle, the content of the halogen (e.g., chlorine, bromine, or a combination thereof) may be, based on indium (e.g., per 1 mol of indium), greater than or equal to about 0.01 mol% (e.g., greater than or equal to about 0.0001 mol), greater than or equal to about 0.03 mol%, greater than or equal to about 0.05 mol%, greater than or equal to about 0.08 mol%, greater than or equal to about 0.1 mol%, greater than or equal to about 0.15 mol%, greater than or equal to about 0.25 mol%, greater than or equal to about 0.3 mol%, greater than or equal to about 0.35 mol%, greater than or equal to about 0.4 mol%, greater than or equal to about 0.45 mol%, greater than or equal to about 0.5 mol%, greater than or equal to about 0.6 mol%, greater than or equal to about 0.7 mol%, greater than or equal to about 0.8 mol%, greater than or equal to about 0.9 mol%, greater than or equal to about 1 mol%, greater than or equal to about 1.5 mol%, greater than or equal to about 2 mol%, greater than or equal to about 2.5 mol%, greater than or equal to about 3 mol%, greater than or equal to about 3.5 mol%, greater than or equal to about 4 mol%, greater than or equal to about 4.5 mol%, greater than or equal to about 5 mol%, greater than or equal to about 5.5 mol%, greater than or equal to about 6 mol%, greater than or equal to about 6.5 mol%, greater than or equal to about 7 mol%, greater than or equal to about 7.5 mol%, greater than or equal to about 8 mol%, greater than or equal to about 8.5 mol%, greater than or equal to about 9 mol%, greater than or equal to about 10 mol%, greater than or equal to about 13 mol%, greater than or equal to about 15 mol%, greater than or equal to about 17 mol%, greater than or equal to about 20 mol%, greater than or equal to about 25 mol%, greater than or equal to about 30 mol%, greater than or equal to about 35 mol%, greater than or equal to about 40 mol%, greater than or equal to about 45 mol%, greater than or equal to about 50 mol%, greater than or equal to about 60 mol%, greater than or equal to about 70 mol%, greater than or equal to about 80 mol%, greater than or equal to about 90 mol%, greater than or equal to about 100 mol%, greater than or equal to about 150 mol%, greater than or equal to about 200 mol%, greater than or equal to about 250 mol%, greater than or equal to about 300 mol%, greater than or equal to about 350 mol%, greater than or equal to about 400 mol%, or greater than or equal to about 450 mol%.

The amount of the halogen (e.g., chlorine, bromine, or a combination thereof) may be, based on indium (e.g., per 1 mol of indium), less than or equal to about 3200 mol% (e.g., less than or equal to about 32 mol, Br:In is about 32-fold), less than or equal to about 3000 mol%, less than or equal to about 2500 mol%, less than or equal to about 2000 mol%, less than or equal to about 1500 mol%, less than or equal to about 1000 mol%, less than or equal to about 900 mol%, less than or equal to about 800 mol%, less than or equal to about 700 mol%, less than or equal to about 600 mol%, less than or equal to about 500 mol%, less than or equal to about 380 mol%, less than or equal to about 230 mol%, less than or equal to about 120 mol%, less than or equal to about 110 mol%, less than or equal to about 100 mol%, less than or equal to about 85 mol%, less than or equal to about 75 mol%, less than or equal to about 65 mol%, less than or equal to about 55 mol%, less than or equal to about 44 mol%, less than or equal to about 42 mol%, less than or equal to about 37 mol%, less than or equal to about 23 mol%, less than or equal to about 19 mol%, less than or equal to about 14 mol%, less than or equal to about 7.2 mol%, less than or equal to about 6.8 mol%, less than or equal to about 4.3 mol%, less than or equal to about 3.9 mol%, or less than or equal to about 2.3 mol%.

In an embodiment, the semiconductor nanoparticle may include (for example, on a surface thereof) an acid compound or a moiety derived therefrom (e.g., a carboxylate group), and the acid compound may have a dipole moment (unit: Debye, omitted hereinafter) greater than or equal to about 2, greater than or equal to about 2.1, greater than or equal to about 2.2, greater than or equal to about 2.3, greater than or equal to about 2.4, greater than or equal to about 2.5, greater than or equal to about 2.6, greater than or equal to about 2.7, greater than or equal to about 2.8, greater than or equal to about 2.9, greater than or equal to about 3, greater than or equal to about 3.1, greater than or equal to about 3.2, greater than or equal to about 3.3, greater than or equal to about 3.4, or greater than or equal to about 3.5. The acid compound may have a dipole moment that is less than or equal to about 5, less than or equal to about 4.5, less than or equal to about 4, less than or equal to about 3.9, less than or equal to about 3.7, or less than or equal to about 3.6.

The acid compound may include a carboxyl group, a sulfonic acid group, or a combination thereof. The acid compound may include a halogen-substituted carboxylic acid compound, a halogen-substituted sulfonic acid compound, a sulfonic acid compound including a substituted or unsubstituted aromatic group, or a combination thereof. The acid compound may include trichloroacetic acid, trifluoroacetic acid, chlorosulfonic acid, p-toluenesulfonic acid, trichloro(trichloromethyl)propanoic acid (3,3,3-trichloro-2-(trichloromethyl)propanoic acid), 3,3,3-trichloromethylpropanoic acid, trichloropropanoic acid, (3,3,3-trichloropropanoic acid), or a combination thereof. In an embodiment, the acid compound may include or may not include a halogen (e.g., fluorine, chlorine, or a combination thereof).

The acid compound may be a compound represented by Chemical formula A or Chemical formula B:

Chemical formula A $CR_3$-L-COOA

Chemical formula B X-$SO_2$-OA

In the chemical formula A or B, R is the same or different and is independently hydrogen; a halogen (e.g., fluorine, chlorine, bromine, or iodine); or a substituted (e.g., halogen-substituted) or unsubstituted C1 to C10 aliphatic hydrocarbon group (e.g., an alkyl group, an alkenyl group, an alkynyl group, or a mono-, di-, or trihaloalkyl), provided that one or more R is a halogen (e.g., fluorine, chlorine, bromine, or iodine);

L is a direct bond, a substituted or unsubstituted C1 to C30 aliphatic hydrocarbon group (e.g., an alkylene group such as a methylene, ethylene, propylene, or butylene group, or an alkenylene group), a substituted or unsubstituted C6 to C20 arylene group (e.g., a phenylene group), or a combination thereof;
X is a halogen (e.g., fluorine, chlorine, bromine, or iodine) or a substituted or unsubstituted aromatic hydrocarbon group (e.g., a substituted or unsubstituted aryl group); and
A is hydrogen or a portion connected to the semiconductor nanoparticle.

In the definition of L, one or more methylenes of the aliphatic hydrocarbon group may be substituted with -CO-, -O-, an ester (-COO- or -OCO-), -CONH-, -NH-, -S-, -SO-, or a combination thereof.
In the semiconductor nanoparticle, the concentration of indium may vary in a radial direction. In the semiconductor nanoparticle, the indium content in an inner portion of the particle may differ from that in an outer portion of the particle. In an embodiment, the indium content in a surface-adjacent portion (e.g., an outermost layer or shell) of the particle may be lower than the indium content in an inner portion (e.g., a core) of the particle.
In an embodiment, the zinc content (concentration) in the surface-adjacent portion (e.g., the outermost layer) of the particle may be greater than the zinc content (concentration) in an inner portion (e.g., a core) of the particle. In the semiconductor nanoparticle, the concentration of zinc may be greater in the outer region of the particle than in the inner region. The core or the first semiconductor nanocrystal may not include zinc. In the shell, gallium may exhibit a radial concentration gradient (e.g., increasing or decreasing in the radial direction e.g., toward a surface of the particle). In the shell, the concentration of gallium in a surface-adjacent portion of the particle may be greater than the concentration of gallium in a portion adjacent to the core.
The semiconductor nanoparticle may have a core-shell structure including a core and a shell disposed on the core. The core may include a first semiconductor nanocrystal, and the shell may include a second semiconductor nanocrystal. The shell may be a multilayer shell, and the multilayer shell may include a first shell layer disposed on the core, a second shell layer disposed on the first shell layer, and a third shell layer disposed on the second shell layer. The first shell layer may include a second semiconductor nanocrystal. The second shell layer or the third shell layer may include an additional semiconductor nanocrystal that includes zinc, sulfur, and optionally gallium (e.g., a zinc chalcogenide or a zinc gallium chalcogenide), and may include the third semiconductor nanocrystal and/or a fourth semiconductor nanocrystal.
In an embodiment, the semiconductor nanoparticle or the first semiconductor nanocrystal may include silver, a group 13 element, and a chalcogen element (or a group 11-13-16 compound including silver, a group 13 element, and a chalcogen element). The first semiconductor nanocrystal may or may not further include zinc. The group 13 element may include indium, gallium, or a combination thereof. The chalcogen element may contain sulfur and optionally selenium. The first semiconductor nanocrystal may include silver, a Group 13 metal (e.g., indium, gallium, or a combination thereof), and a Group 16 element (e.g., sulfur, and optionally selenium). The first semiconductor nanocrystal may include a quaternary alloy semiconductor material based on a Group 11-13-16 compound including silver, indium, gallium, and sulfur. The semiconductor nanoparticle or the first semiconductor nanocrystal may include a silver indium gallium sulfide (hereinafter, abbreviated as AIGS). The first semiconductor nanocrystals may include $Ag(In_xGa_{1-x})S_2$ (x is greater than 0 and less than or equal to 1, e.g., about 0.5). The mole ratios between the components in the first semiconductor nanocrystal may be adjusted so that the final semiconductor nanoparticle may have a desired composition and an optical property (e.g., a maximum emission wavelength).
In the first semiconductor nanocrystal, a mole ratio of Ga to a total of In and Ga (Ga:(In+Ga)) may be greater than about 0:1, greater than or equal to about 0.1:1, greater than or equal to about 0.2:1, greater than or equal to about 0.3:1, greater than or equal to about 0.4:1, or greater than or equal to about 0.45:1. In the first semiconductor nanocrystal, a mole ratio of Ga to a total of In and Ga (Ga:(In+Ga)) may be less than or equal to about 0.55:1, less than or equal to about 0.5:1, less than or equal to about 0.49:1, less than or equal to about 0.45:1, less than or equal to about 0.42:1, less than or equal to about 0.33:1, or less than or equal to about 0.25:1.
The semiconductor nanoparticle may further include a second semiconductor nanocrystal including gallium, sulfur, and optionally silver and having a composition different from that of the first semiconductor nanocrystal; an additional semiconductor nanocrystal (e.g., a third semiconductor nanocrystals and/or a fourth semiconductor nanocrystals); or a combination thereof. The second semiconductor nanocrystal may include a Group 13-16 compound, a Group 11-13-16 compound, or a combination thereof. The Group 13-16 compound may include a gallium sulfide, a gallium selenide, an indium sulfide, an indium selenide, an indium gallium sulfide, an indium gallium selenide, an indium gallium selenide sulfide, or a combination thereof. The second semiconductor nanocrystal may include gallium and a chalcogen element (sulfur, and optionally selenium). The second semiconductor nanocrystal may include a ternary alloy semiconductor material including silver, gallium, and sulfur. The molar ratio between each component in the second semiconductor nanocrystal can be adjusted to achieve the desired composition and optical properties of the final semiconductor nanoparticle.

The additional semiconductor nanocrystal may include zinc, sulfur, and optionally gallium. In an embodiment, a third semiconductor nanocrystal may include zinc, gallium, and sulfur. A fourth semiconductor nanocrystal may include zinc and sulfur. The third semiconductor nanocrystal may include a zinc gallium sulfide. The fourth semiconductor nanocrystal may include a zinc sulfide.

The second semiconductor nanocrystal may cover at least a portion of the first semiconductor nanocrystal. The bandgap energy of the second semiconductor nanocrystal may differ from that of the first semiconductor nanocrystal. The bandgap energy of the second semiconductor nanocrystal may be greater than the bandgap energy of the first semiconductor nanocrystal. The bandgap energy of the second semiconductor nanocrystal may be less than the bandgap energy of the first semiconductor nanocrystal. The bandgap energy of the additional semiconductor nanocrystal (e.g., a third semiconductor nanocrystal or a fourth semiconductor nanocrystal) may be greater than the bandgap energy of the second semiconductor nanocrystal. The bandgap energy of an additional semiconductor nanocrystal (e.g., a third semiconductor nanocrystal or a fourth semiconductor nanocrystal) may be greater than the bandgap energy of the first semiconductor nanocrystal. A layer including the third semiconductor nanocrystal or the fourth semiconductor nanocrystal may be an outermost layer of the semiconductor nanoparticle.

In an embodiment, the semiconductor nanoparticle may have a core/multi-layer shell structure, such as AgInGaS/AgGaS, AgInGaS/AgGaS/GaS, AgInGaS/AgGaS/ZnGaS, AgInGaS/AgGaS/ZnS, or AgInGaS/AgGaS/ZnGaS/ZnS.

The size (or average size) of the first semiconductor nanocrystal may be greater than or equal to about 0.5 nm, greater than or equal to about 1 nm, greater than or equal to about 1.5 nm, greater than or equal to about 1.7 nm, greater than or equal to about 1.9 nm, greater than or equal to about 2 nm, greater than or equal to about 2.1 nm, greater than or equal to about 2.3 nm, greater than or equal to about 2.5 nm, greater than or equal to about 2.7 nm, greater than or equal to about 2.9 nm, greater than or equal to about 3 nm, greater than or equal to about 3.1 nm, greater than or equal to about 3.3 nm, greater than or equal to about 3.5 nm, greater than or equal to about 3.7 nm, greater than or equal to about 3.9 nm, greater than or equal to about 4 nm, or greater than or equal to about 4.2 nm. The size (average size) of the first semiconductor nanocrystal may be less than or equal to about 6 nm, less than or equal to about 5.5 nm, less than or equal to about 5 nm, less than or equal to about 4.5 nm, less than or equal to about 4 nm, less than or equal to about 3.5 nm, less than or equal to about 3 nm, less than or equal to about 2.5 nm, less than or equal to about 2 nm, or less than or equal to about 1.5 nm. The size (or average size) of the first semiconductor nanocrystal may be within a range of combinations of the foregoing.

The thickness of the second semiconductor nanocrystal or a layer including the same may be greater than or equal to about 0.1 nm, greater than or equal to about 0.2 nm, or greater than or equal to about 0.3 nm. The thickness of the second semiconductor nanocrystal or a layer including the same may be less than or equal to about 4 nm, less than or equal to about 3.5 nm, less than or equal to about 3 nm, less than or equal to about 2.5 nm, less than or equal to about 2 nm, less than or equal to about 1.5 nm, less than or equal to about 1 nm, or less than or equal to about 0.8 nm. The thickness of the second semiconductor nanocrystal or a layer including the same may be within a range of combinations of the foregoing.

When present, a dimension (e.g., thickness) of the third semiconductor nanocrystal or a layer including the same may be greater than or equal to about 0.1 nm, greater than or equal to about 0.3 nm, greater than or equal to about 0.5 nm, greater than or equal to about 0.7 nm, or greater than or equal to about 1 nm. The dimension (e.g., thickness) of the third semiconductor nanocrystal or a layer including the same may be less than or equal to about 2 nm, less than or equal to about 1.5 nm, less than or equal to about 1 nm, or less than or equal to about 0.8 nm. The thickness of the third semiconductor nanocrystal layer may be within a range of 0.1 nm to 5 nm, 0.2 nm to 4 nm, 0.3 nm to 3.5 nm, 0.4 nm to 3 nm, 0.5 nm to 2.5 nm, 0.6 nm to 2 nm, 0.7 nm to 1.5 nm, 0.8 nm to 1.2 nm, 0.9 nm to 1 nm, or a combination thereof.

In an embodiment, the size or average particle size (hereinafter simply referred to as "size") of the semiconductor nanoparticle may be greater than or equal to about 1 nm, greater than or equal to about 1.5 nm, greater than or equal to about 2 nm, greater than or equal to about 2.5 nm, greater than or equal to about 3 nm, greater than or equal to about 3.5 nm, greater than or equal to about 4 nm, greater than or equal to about 4.5 nm, greater than or equal to about 5 nm, greater than or equal to about 5.5 nm, greater than or equal to about 6 nm, greater than or equal to about 6.5 nm, greater than or equal to about 7 nm, greater than or equal to about 7.5 nm, greater than or equal to about 8 nm, greater than or equal to about 8.5 nm, greater than or equal to about 9 nm, greater than or equal to about 9.5 nm, greater than or equal to about 10 nm, or greater than or equal to about 10.5 nm. The size of the semiconductor nanoparticle may be less than or equal to about 50 nm, less than or equal to about 48 nm, less than or equal to about 46 nm, less than or equal to about 44 nm, less than or equal to about 42 nm, less than or equal to about 40 nm, less than or equal to about 35 nm, less than or equal to about 30 nm, less than or equal to about 25 nm, less than or equal to about 20 nm, less than or equal to about 18 nm, less than or equal to about 16 nm, less than or equal to about 14 nm, less than or equal to about 12 nm, less than or equal to

about 11 nm, less than or equal to about 10 nm, less than or equal to about 8 nm, less than or equal to about 7 nm, less than or equal to about 6 nm, or less than or equal to about 4 nm. The size of the semiconductor nanoparticle may be within a range of combinations of the foregoing.

In an embodiment, the size of the semiconductor nanoparticle may be a particle diameter. The size of the semiconductor nanoparticle may be obtained from an image identified by an electron microscopy (e.g., transmission electron microscopy) analysis. The size (e.g., diameter) of the semiconductor nanoparticle may be an equivalent diameter obtained by a calculation involving converting the two-dimensional area of a particle obtained from an electron microscopy image into a circle. Such particle size can be reproducibly and easily obtained using various image processing programs (e.g., ImageJ or an in-house programs created using a coding language) from microscope images. The particle size may be a value (e.g., a nominal particle size) calculated from the composition and peak emission wavelength of the semiconductor nanoparticle.

The semiconductor nanoparticle may have an average size greater than or equal to about 5 nm, or greater than or equal to about 5.1 nm, or greater than or equal to about 5.2 nm, and less than or equal to about 10 nm, less than or equal to about 7 nm, less than or equal to about 6.5 nm, less than or equal to about 6 nm, or less than or equal to about 5.4 nm.

The semiconductor nanoparticle may have a size distribution, represented by a standard deviation, that is less than or equal to about 20%, less than or equal to about 19%, less than or equal to about 18%, less than or equal to about 17%, less than or equal to about 16%, less than or equal to about 15%, less than or equal to about 14%, less than or equal to about 13%, less than or equal to about 12%, less than or equal to about 11%, or less than or equal to about 10% of the average size. The standard deviation may be greater than or equal to about 5%, greater than or equal to about 10%, or greater than or equal to about 12%.

The semiconductor nanoparticle of the embodiment may be manufactured by the method described herein. Research has been conducted on environmentally friendly InP-containing quantum dots as emission materials in color conversion layer-based displays. A semiconductor nanocrystal based on a group 11-13-16 compound (including, for example, silver, indium, gallium, and sulfur) may provide increased incident-light absorbance, and active studies thereon are ongoing. To be applied as a color conversion material in a color conversion layer, the semiconductor nanoparticle may undergo a film formation process. The film formation process may involve contact with a monomer and, for example, a high-temperature process of 180°C or greater, and, as confirmed by the present inventors, in such a film formation process, the semiconductor nanoparticle may experience a substantial decrease in optical properties (e.g., emission efficiency).

To prevent such substantial decrease, a semiconductor nanoparticle may be formed by carrying out a reaction of sulfur and gallium (and optionally a silver compound) in the presence of the semiconductor nanocrystal based on a group 11-13-16 compound. The semiconductor nanoparticle formed by such a reaction may exhibit a significantly increased mole ratio of gallium to indium compared to the semiconductor nanocrystal based on a group 11-13-16 compound, and the stability of the particle may increase as the mole ratio of gallium to indium increases. However, as confirmed by the present inventors, as the mole ratio of gallium to indium increases - for example, when the mole ratio of gallium to indium increases to about 19 or greater, or about 20 or greater - the emission efficiency of the resulting semiconductor nanoparticle may substantially, for example, dramatically decrease. Without wishing to be bound by any theory, it is believed that by-products including gallium formed during the progression of the reaction may negatively affect the emission properties of the final semiconductor nanoparticle.

The semiconductor nanoparticle of the embodiment may maintain an improved emission property even at an increased size by additionally adding an acid compound to the reaction medium as described herein when increasing a size of the semiconductor nanoparticle by contacting a sulfur precursor and a gallium precursor (and a silver precursor) in the presence of the semiconductor nanocrystal based on a group 11-13-16 compound.

Accordingly, in an embodiment, a method of manufacturing the semiconductor nanoparticle includes preparing a reaction medium including an organic solvent, mixing a first semiconductor nanocrystal including silver, a group 13 element, and a chalcogen element or a first particle including the first semiconductor nanocrystal; a sulfur precursor; and a gallium precursor in the reaction medium; and heating the reaction medium to a reaction temperature to form a semiconductor nanocrystal including sulfur and gallium on the first semiconductor nanocrystal or the first particle. The method further includes adding an acid compound to the reaction medium, and the acid compound has a dipole moment (unit: Debye, hereinafter, unless otherwise specified for dipole moment, unit is Debye) greater than or equal to about 2 and less than or equal to about 5.

In the method, the acid compound may be added during formation of the semiconductor nanocrystal or after completion of formation of the semiconductor nanocrystal (for example, after cooling the medium to a temperature below the reaction temperature, less than or equal to about 180°C, less than or equal to about 100°C, or less than or equal to about 50°C to room temperature, and including the medium or reaction solution (e.g., a crude solution) containing semiconductor nanoparticles having a desired size).

In the method of the embodiment, a reaction between the sulfur precursor and the gallium precursor in the presence of an AIGS-containing semiconductor nanocrystal (hereinafter, a core) or a particle containing the AIGS-containing semiconductor nanocrystal may result in formation of a semiconductor nanocrystal shell layer including gallium and sulfur on the core. By adjusting a ratio between the precursors in the shelling formation, a mole ratio of gallium to indium (Ga:In) in the final semiconductor nanoparticle may be increased, and compared to semiconductor nanoparticles having a lower mole ratio of gallium to indium, the semiconductor nanoparticle having an increased mole ratio of gallium to indium may exhibit technical improvements, for example, in terms of light conversion efficiency and stability in a composite.

However, the present inventors have found that the semiconductor nanoparticle having an increased mole ratio of gallium to indium may exhibit a lowered quantum efficiency, for example, compared to a semiconductor nanoparticle having a lower mole ratio of gallium to indium (e.g., in a solution of the particle). Without wishing to be bound by any theory, this is believed to be because, due to an increased amount of a Ga source provided during the synthesis, unreacted Ga by-products or an amorphous layer may be formed on a surface of the manufactured semiconductor nanoparticle, and these may scatter or absorb light, thereby lowering a light conversion efficiency. Such by-products may have sufficient reactivity to further react with a surface of the synthesized semiconductor nanoparticle (e.g., etching the surface), which may cause a change in the surface of the semiconductor nanoparticle over time.

Surprisingly, the present inventors have found that, according to the method of the embodiment, the mole ratio of Ga/In in the manufactured particle may be increased while substantially suppressing or preventing formation of such by-products (e.g., Ga by-products or an amorphous layer). In the method of the embodiment, during shell coating, by adding an acid compound having a dipole moment of greater than or equal to about 2 to the reaction system, surface Ga by-products or a surface amorphous layer generated due to an excessive Ga supply source (e.g., a gallium precursor) may be effectively removed.

In the method of the embodiment, the first semiconductor nanocrystal including silver, a group 13 element, and a chalcogen element (hereinafter, also referred to as a core) or a first particle including the first semiconductor nanocrystal (hereinafter, also referred to as an intermediate particle); the sulfur precursor; and the gallium precursor are mixed or contacted in a medium including an organic solvent and optionally an organic ligand. The mixing or contacting may include preparing a medium including the organic solvent, the sulfur precursor, and the organic ligand; and adding the first particle and the gallium precursor to the prepared medium.

The method may include pretreating the medium (e.g., under a vacuum state). The medium (including, for example, the sulfur precursor and optionally an organic ligand) may be pretreated under a vacuum state before addition of the first semiconductor nanocrystal (or the first particle including the first semiconductor nanocrystal) and/or the gallium precursor. A pretreatment temperature may be lower than the reaction temperature. The pretreatment temperature may be, for example, greater than or equal to about 80°C, greater than or equal to about 100°C, or greater than or equal to about 120°C and less than or equal to about 200°C, or less than or equal to about 180°C.

A manner of adding the first semiconductor nanocrystal (or the first particle including the first semiconductor nanocrystal), the gallium precursor, the sulfur precursor, and/or the organic ligand (e.g., an addition order or an addition form) is not particularly limited. The first semiconductor nanocrystal (or the first particle including the first semiconductor nanocrystal) may be dispersed in an appropriate organic solvent and added to the reaction medium, but is not limited thereto. The gallium precursor may be dispersed in an appropriate organic solvent (e.g., octadecene, or an aliphatic or aromatic phosphine compound such as TOP, or an aliphatic or aromatic phosphine oxide compound such as TOPO) and added to the reaction medium, but is not limited thereto. In an embodiment, the medium (for example, including the sulfur precursor) may be pretreated to a predetermined temperature under a vacuum state before addition of the first semiconductor nanocrystal (or the first particle including the first semiconductor nanocrystal) or the gallium precursor.

In the method of the embodiment, the gallium precursor may include a gallium halide. The gallium halide may include a gallium bromide. In the method of the embodiment, use of gallium bromide as the gallium precursor (and optionally, adding a silver compound as described below) may contribute to controlling a composition of the final semiconductor nanoparticle as described herein. For example, when $GaBr_3$ is used as the gallium precursor, excessive Ag on the surface may be removed, thereby suppressing a trap ratio, and accordingly, the resulting final nanoparticle may exhibit enhanced stability and a suppressed trap ratio compared to semiconductor nanoparticles manufactured by the related art. In an embodiment, when the gallium precursor includes a mixture of gallium bromide and gallium chloride (or gallium iodide), an amount of gallium chloride (or gallium iodide) per 1 mole of gallium bromide may be greater than or equal to about 0.001 mole, greater than or equal to about 0.005 mole, greater than or equal to about 0.01 mole, greater than or equal to about 0.05 mole, greater than or equal to about 0.1 mole, greater than or equal to about 0.2 mole, greater than or equal to about 0.3 mole, greater than or equal to about 0.4 mole, greater than or equal to about 0.5 mole, greater than or equal to about 0.6 mole, or greater than or equal to about 0.7 mole and less than or equal to about 5 mole, less than or equal to about 3 mole, less than or equal to about 2 mole, less than or equal to about 1.5 mole, less than or equal to about 1 mole, less than or equal to about 0.8 mole, less than or equal to about 0.4 mole, or less than or equal to about 0.2 mole.

In the method of the embodiment, after adding the gallium precursor, the first semiconductor nanocrystal or the first particle including the first semiconductor nanocrystal may be added, but the method is not limited thereto. In the method of the embodiment, after adding the first semiconductor nanocrystal or the first particle including the first semiconductor nanocrystal, the gallium precursor may be added.

The method of the embodiment may further include adding a silver compound to the medium. A manner of adding the silver compound to the (reaction) medium (e.g., an addition order or an addition form) is also not particularly limited. The silver compound may be added in a state dissolved in an appropriate organic solvent (e.g., an organic solvent described herein, such as an amine solvent including oleylamine, or a phosphine solvent including trioctylphosphine). A timing of adding the silver compound is also not particularly limited and may be appropriately selected. The silver compound may be added to the (reaction) medium before or after addition of the first semiconductor nanocrystal, the gallium precursor, the sulfur precursor, or a combination thereof. In an embodiment, the silver compound may be added to the (reaction) medium after the pretreatment.

Detailed information regarding the first semiconductor nanocrystal is as described herein. The first semiconductor nanocrystal may include silver (Ag), indium, gallium, and sulfur. A method of manufacturing the first semiconductor nanocrystal is not particularly limited and may be appropriately selected. In an embodiment, the first semiconductor nanocrystal may be obtained by contacting (or reacting) required precursors depending on the composition - e.g., a silver precursor, an indium precursor, a gallium precursor, and a sulfur precursor - at a predetermined core formation reaction temperature (e.g., about 180°C to about 300°C or about 200°C to about 280°C) in a solution including an organic ligand and an organic solvent for a predetermined time and then separating the product.

In an embodiment, the manufactured first semiconductor nanocrystal may be separated and optionally washed. The separation and washing may be performed by the method described herein.

In the method of the embodiment, the core formation reaction temperature may be greater than or equal to about 120°C, greater than or equal to about 180°C, greater than or equal to about 190°C, greater than or equal to about 200°C, greater than or equal to about 205°C, greater than or equal to about 210°C, greater than or equal to about 220°C, greater than or equal to about 230°C, greater than or equal to about 240°C, greater than or equal to about 245°C, greater than or equal to about 250°C, greater than or equal to about 255°C, greater than or equal to about 260°C, greater than or equal to about 265°C, greater than or equal to about 270°C, greater than or equal to about 275°C, greater than or equal to about 280°C, greater than or equal to about 285°C, greater than or equal to about 290°C, greater than or equal to about 295°C, greater than or equal to about 300°C, greater than or equal to about 305°C, greater than or equal to about 310°C, greater than or equal to about 315°C, greater than or equal to about 320°C, greater than or equal to about 330°C, greater than or equal to about 335°C, greater than or equal to about 340°C, or greater than or equal to about 345°C. The core formation reaction temperature may be less than or equal to about 380°C, less than or equal to about 375°C, less than or equal to about 370°C, less than or equal to about 365°C, less than or equal to about 360°C, less than or equal to about 355°C, less than or equal to about 350°C, less than or equal to about 340°C, less than or equal to about 330°C, less than or equal to about 320°C, less than or equal to about 310°C, less than or equal to about 300°C, less than or equal to about 290°C, less than or equal to about 280°C, less than or equal to about 270°C, less than or equal to about 260°C, or less than or equal to about 250°C. A core formation reaction time is not particularly limited and may be appropriately selected in consideration of a desired size of the first semiconductor nanocrystal, an emission wavelength of the first semiconductor nanocrystal or a final semiconductor nanoparticle, a reactivity of a precursor, and a reaction temperature. The core formation reaction time may be greater than or equal to about 1 minute, greater than or equal to about 3 minutes, greater than or equal to about 5 minutes, greater than or equal to about 10 minutes, greater than or equal to about 20 minutes, or greater than or equal to about 30 minutes. The core formation reaction time may be about 1 minute to about 2 hours, about 5 minutes to about 90 minutes, about 10 minutes to about 70 minutes, or a combination thereof.

In the method of the embodiment, the medium (including, for example, precursors and the first semiconductor nanocrystal or a particle including the first semiconductor nanocrystal) is heated (e.g., to a reaction temperature). In the medium heated to the reaction temperature, a reaction between compounds may occur in the presence of the core (or the first particle), and a semiconductor nanoparticle (or the first particle) including the core (or the first particle) and a second semiconductor nanocrystal, or a crude solution including the same, may be obtained. The predetermined temperature may be greater than or equal to about 120°C and less than or equal to about 380°C. The predetermined temperature may be the reaction temperature. The predetermined temperature may be greater than or equal to about 220°C and less than or equal to about 280°C.

In the method of the embodiment, the predetermined temperature may be greater than or equal to about 120°C, greater than or equal to about 180°C, greater than or equal to about 190°C, greater than or equal to about 200°C, greater than or equal to about 205°C, greater than or equal to about 210°C, greater than or equal to about 240°C, greater than or equal to about 245°C, greater than or equal to about 250°C, greater than or equal to about 255°C, greater than or equal to about 260°C, greater than or equal to about 265°C, greater than or equal to about 270°C, greater than or equal to about 275°C, greater than or equal to about 280°C, greater than or equal to about 285°C, greater than or equal to about 290°C, greater than or equal to about 295°C, greater than or equal to about 300°C, greater than or equal to about 305°C, greater than or equal to about 310°C, greater than or equal to about 315°C, greater than or equal to about 320°C, greater than or equal to about 330°C, greater than or equal to about 335°C, greater than or equal to about 340°C, or greater than or equal to about 345°C. The predetermined temperature may be less than or equal to about 380°C, less than or equal to about 375°C, less than or equal to about 370°C, less than or equal to about 365°C, less than or equal to about 360°C, less than or equal to

about 355°C, less than or equal to about 350°C, less than or equal to about 340°C, less than or equal to about 330°C, less than or equal to about 320°C, less than or equal to about 310°C, less than or equal to about 300°C, less than or equal to about 290°C, less than or equal to about 280°C, less than or equal to about 270°C, less than or equal to about 260°C, or less than or equal to about 250°C.

In an embodiment, the medium (optionally including the sulfur precursor) may be heated to an injection temperature under a vacuum or an inert atmosphere, and the first semiconductor nanocrystal (or the first particle including the first semiconductor nanocrystal) and the gallium precursor (and optionally the sulfur precursor) may be added to the medium heated to the injection temperature. The method of the embodiment may heat the medium or reaction mixture (including the first semiconductor nanocrystal, the gallium precursor, the sulfur precursor, and the silver compound) to the reaction temperature. The ranges of the injection temperature and the reaction temperature are as described herein.

A method of manufacturing the semiconductor nanoparticle of the embodiment may include an intermediate separation process, in which a particle formed during formation of the semiconductor nanoparticle (e.g., during a shelling process), such as the first particle, is separated and optionally washed and then reintroduced into the reaction. The first particle further include the second semiconductor nanocrystal that is disposed on the first semiconductor nanocrystal and includes gallium and sulfur. For example, details regarding the second semiconductor nanocrystal are as described herein.

The method of the embodiment may include adding the first semiconductor nanocrystal and the first gallium precursor, the first sulfur precursor, or both to the first (reaction) medium including a first organic solvent (and optionally the first sulfur precursor). The method may further include adding a first silver compound to the first medium. In the method, the first medium may be pretreated (e.g., under a vacuum). The first medium (including, for example, the first sulfur precursor) may be pretreated under a vacuum state before addition of the first semiconductor nanocrystal or the first gallium precursor. A pretreatment temperature may be lower than the first reaction temperature. The pretreatment temperature is as described herein.

A manner of adding the first semiconductor nanocrystal, the first gallium precursor, and the first sulfur precursor (e.g., addition order or addition form) is not particularly limited. The first semiconductor nanocrystal may be dispersed in an appropriate organic solvent and added to the reaction medium, but is not limited thereto. The method of the embodiment may include heating the first medium (including the first organic solvent and optionally the first sulfur precursor) to a first injection temperature under a vacuum or an inert atmosphere, and adding the first semiconductor nanocrystal, the first gallium precursor, the first sulfur precursor, or a combination thereof to the medium heated to the first injection temperature. The method of the embodiment may include heating a reaction mixture including the first semiconductor nanocrystal, the first gallium precursor, the first sulfur precursor, and the first silver compound to a first reaction temperature.

In an embodiment, in the intermediate separation process, the first semiconductor nanocrystal may be mixed (or contacted) with the first sulfur precursor, the first gallium precursor, and optionally the first silver compound in the first medium including the first organic solvent, and the first medium may be heated to a first reaction temperature (e.g., for a first reaction time) to form a first particle (hereinafter, also referred to as an intermediate particle). Accordingly, formation of the intermediate particle may include performing a first reaction between the sulfur precursor and the gallium precursor (and optionally the silver compound) in the presence of the first semiconductor nanocrystal including the group 13 element and the chalcogen element.

Without wishing to be bound by any theory, a second semiconductor nanocrystal (including gallium sulfide or silver gallium sulfide) may be formed on the first semiconductor nanocrystal by the reaction, and a mole ratio of gallium to indium in the resulting particle may increase. The first reaction time may be appropriately controlled in consideration of the precursors, the reaction temperature, and an emission peak wavelength of the intermediate particle or the final semiconductor nanoparticle. In an embodiment, the first reaction time may be greater than or equal to about 30 minutes, greater than or equal to about 35 minutes, greater than or equal to about 40 minutes, greater than or equal to about 45 minutes, greater than or equal to about 50 minutes, greater than or equal to about 55 minutes, greater than or equal to about 60 minutes, greater than or equal to about 65 minutes, greater than or equal to about 70 minutes, greater than or equal to about 75 minutes, greater than or equal to about 80 minutes, greater than or equal to about 90 minutes, greater than or equal to about 2 hours, greater than or equal to about 150 minutes, greater than or equal to about 3 hours, greater than or equal to about 190 minutes, greater than or equal to about 200 minutes, greater than or equal to about 210 minutes, greater than or equal to about 220 minutes, greater than or equal to about 230 minutes, greater than or equal to about 4 hours, greater than or equal to about 250 minutes, greater than or equal to about 260 minutes, greater than or equal to about 270 minutes, or greater than or equal to about 280 minutes. The first reaction time may be less than or equal to about 10 hours, less than or equal to about 6 hours, less than or equal to about 5 hours, less than or equal to about 4 hours, or less than or equal to about 3 hours. In an embodiment, the reaction time may be greater than or equal to about 1 hour and less than or equal to about 5 hours, or greater than or equal to about 2 hours and less than or equal to about 4 hours, or greater than or equal to about 3 hours and less than or equal to about 3 hours 30 minutes.

The formed first particle may be separated from the first medium. After the first reaction, an antisolvent may be added to the first reaction medium to promote precipitation of the intermediate particle (e.g., coordinated with the organic ligand). The separated first particle may be washed with a washing solvent before being added to the second medium. The antisolvent, precipitation, and washing may be performed as described herein. The present inventors have surprisingly confirmed that when a semiconductor nanoparticle is manufactured through a subsequent reaction as described below from the first particle that has undergone such separation and optional washing, the resulting nanoparticle may have the composition described herein and may exhibit desired optical properties (e.g., an emission wavelength, increased quantum yield, suppressed trap emission, a significantly reduced full width at half maximum (FWHM)) and may exhibit improved process stability during composite formation.

The separated intermediate particle may be mixed (or contacted) with the second sulfur precursor, the second gallium precursor, and optionally the second silver compound in the second medium including the second organic solvent, and the second medium may be heated to a second reaction temperature (e.g., for a second reaction time) to form a semiconductor particle. The second reaction time is not particularly limited and may be appropriately selected in consideration of a desired composition, size, types of precursors, and a reaction temperature of the semiconductor nanoparticle.

Details regarding the first and second organic solvents, the first and second media, the first and second sulfur precursors, the first and second gallium precursors, the first and second silver compounds, and details regarding the first and second injection temperatures and the first and second reaction temperatures are as described herein for the organic solvent, the medium, the sulfur precursor, the gallium precursor, and the silver compound.

In the method of the embodiment, a manner of adding a precursor to the (e.g., heated) reaction medium may include a shot addition (e.g., syringe addition), a dropwise addition, or a combination thereof.

The injection temperature (e.g., the first and second injection temperatures) may be greater than or equal to about 120°C (e.g., greater than or equal to about 180°C, or greater than or equal to about 190°C, greater than or equal to about 200°C) and less than or equal to about 280°C (e.g., less than or equal to about 250°C), and the reaction temperature may be greater than or equal to about 190°C or greater than or equal to about 240°C and less than or equal to about 380°C, or less than or equal to about 280°C. The reaction temperature may be higher than the injection temperature. A difference between the injection temperature and the reaction temperature may be greater than or equal to about 5°C, greater than or equal to about 10°C, greater than or equal to about 15°C, greater than or equal to about 20°C, greater than or equal to about 30°C, greater than or equal to about 40°C, greater than or equal to about 50°C, greater than or equal to about 60°C, greater than or equal to about 70°C, greater than or equal to about 80°C, greater than or equal to about 90°C, or greater than or equal to about 100°C. The difference between the injection temperature and the reaction temperature may be less than or equal to about 200°C, less than or equal to about 190°C, less than or equal to about 180°C, less than or equal to about 170°C, less than or equal to about 160°C, less than or equal to about 150°C, less than or equal to about 140°C, less than or equal to about 130°C, less than or equal to about 120°C, less than or equal to about 110°C, less than or equal to about 100°C, less than or equal to about 90°C, less than or equal to about 80°C, less than or equal to about 70°C, less than or equal to about 60°C, less than or equal to about 50°C, less than or equal to about 40°C, less than or equal to about 30°C, or less than or equal to about 20°C.

The injection temperature may be greater than or equal to about 120°C, greater than or equal to about 190°C, greater than or equal to about 200°C, greater than or equal to about 210°C, greater than or equal to about 220°C, greater than or equal to about 230°C, greater than or equal to about 240°C, or greater than or equal to about 250°C. The injection temperature may be less than or equal to about 280°C, less than or equal to about 275°C, less than or equal to about 270°C, less than or equal to about 265°C, less than or equal to about 260°C, less than or equal to about 255°C, less than or equal to about 250°C, less than or equal to about 240°C, less than or equal to about 230°C, less than or equal to about 220°C, less than or equal to about 210°C, less than or equal to about 200°C, less than or equal to about 190°C, less than or equal to about 180°C, less than or equal to about 170°C, less than or equal to about 160°C, or less than or equal to about 150°C.

The reaction temperature (e.g., the first and second reaction temperatures) may be greater than or equal to about 210°C, greater than or equal to about 220°C, greater than or equal to about 230°C, greater than or equal to about 240°C, greater than or equal to about 245°C, greater than or equal to about 250°C, greater than or equal to about 255°C, greater than or equal to about 260°C, greater than or equal to about 265°C, greater than or equal to about 270°C, greater than or equal to about 275°C, greater than or equal to about 280°C, greater than or equal to about 285°C, greater than or equal to about 290°C, greater than or equal to about 295°C, greater than or equal to about 300°C, greater than or equal to about 305°C, greater than or equal to about 310°C, greater than or equal to about 315°C, greater than or equal to about 320°C, greater than or equal to about 330°C, greater than or equal to about 335°C, greater than or equal to about 340°C, or greater than or equal to about 345°C. The reaction temperature may be less than or equal to about 380°C, less than or equal to about 375°C, less than or equal to about 370°C, less than or equal to about 365°C, less than or equal to about 360°C, less than or equal to about 355°C, less than or equal to about 350°C, less than or equal to about 340°C, less than or equal to about 330°C, less than or equal to about 320°C, less than or equal to about 310°C, less than or equal to about 300°C, less

than or equal to about 290°C, less than or equal to about 280°C, less than or equal to about 270°C, less than or equal to about 260°C, or less than or equal to about 250°C.

The reaction time (e.g., the first and second reaction times) may be appropriately controlled in consideration of the precursors, the reaction temperature, and other factors. The reaction time may be greater than or equal to about 30 minutes, greater than or equal to about 35 minutes, greater than or equal to about 40 minutes, greater than or equal to about 45 minutes, greater than or equal to about 50 minutes, greater than or equal to about 55 minutes, greater than or equal to about 60 minutes, greater than or equal to about 65 minutes, greater than or equal to about 70 minutes, greater than or equal to about 75 minutes, or greater than or equal to about 80 minutes. The reaction time (e.g., the first and second reaction times) may be less than or equal to about 500 minutes, less than or equal to about 400 minutes, less than or equal to about 350 minutes, less than or equal to about 300 minutes, less than or equal to about 250 minutes, or less than or equal to about 200 minutes.

A type of the silver precursor (e.g., for the core formation) is not particularly limited and may be appropriately selected. The silver precursor or silver compound may include a silver powder, an alkylated silver compound, a silver alkoxide, a silver carboxylate, a silver acetylacetonate, a silver nitrate, a silver sulfate, a silver halide, a silver cyanide, a silver hydroxide, a silver oxide, a silver peroxide, a silver carbonate, or a combination thereof. The silver precursor may include a silver nitrate, a silver acetate, a silver acetylacetonate, or a combination thereof.

A type of the indium precursor (e.g., for the core formation) is not particularly limited and may be appropriately selected. The indium precursor may include an indium powder, an alkylated indium compound, an indium alkoxide, an indium carboxylate, indium nitrate, indium perchlorate, indium sulfate, indium acetylacetonate, an indium halide, indium cyanide, indium hydroxide, indium oxide, indium peroxide, indium carbonate, or a combination thereof. The indium precursor may include indium oleate, indium myristate (i.e., an indium carboxylate), indium acetate, indium hydroxide, indium chloride, indium bromide, indium iodide, or a combination thereof.

A type of a sulfur precursor (e.g., the first or second sulfur precursor, hereinafter referred to simply as the sulfur precursor) is not particularly limited and may be appropriately selected. The sulfur precursor may include a dispersion or a reaction product of sulfur in an organic solvent (e.g., octadecene sulfide (S-ODE), trioctylphosphine sulfide (S-TOP), tributylphosphine sulfide (S-TBP), triphenylphosphine sulfide (S-TPP), trioctylamine sulfide (S-TOA)), a trimethylsilylalkyl sulfide, trimethylsilyl sulfide, mercaptopropyl silane, ammonium sulfide, sodium sulfide, a C1 to C30 thiol compound (e.g., alpha-toluenethiol, octanethiol, dodecanethiol, octadecenthiol), an isothiocyanate compound (e.g., cyclohexyl isothiocyanate), an alkylene trithiocarbonate (e.g., ethylene trithiocarbonate), allyl mercaptan, a thiourea compound (e.g., dialkylthiourea having a C1 to C40 alkyl group, such as dimethylthiourea, diethylthiourea, ethylmethylthiourea, dipropylthiourea), or a combination thereof. The sulfur precursor may include a thiol compound, an isothiocyanate compound, a thiourea compound, or a combination thereof.

Where present, a selenium precursor may include selenium-trioctylphosphine (Se-TOP), selenium-tributylphosphine (Se-TBP), selenium-triphenylphosphine (Se-TPP), or a combination thereof.

The types of the gallium precursor used in manufacturing the first/second semiconductor nanocrystal or an additional semiconductor nanocrystal are not particularly limited and may be appropriately selected. A gallium precursor may include gallium powder, an alkylated gallium compound, a gallium alkoxide, a gallium carboxylate, a gallium nitrate, a gallium perchlorate, a gallium sulfate, a gallium acetylacetonate, a gallium halide, a gallium cyanide, a gallium hydroxide, a gallium oxide, a gallium peroxide, a gallium carbonate, or a combination thereof. The gallium precursor may include a gallium chloride, a gallium iodide, a gallium bromide, a gallium acetate, a gallium acetylacetonate, a gallium oleate, a gallium palmitate, a gallium stearate, a gallium myristate, a gallium hydroxide, or a combination thereof.

The organic ligand (e.g., a first or second organic ligand, hereinafter referred to as the organic ligand) may include RCOOH, $RNH_2$, $R_2NH$, $R_3N$, RSH, $RH_2PO$, $R_2HPO$, $R_3PO$, $RH_2P$, $R_2HP$, $R_3P$, ROH, RCOOR', $RPO(OH)_2$, RHPOOH, $R_2POOH$, or a combination thereof, where R and R' are each independently a substituted or unsubstituted C1 to C40 (or C3 to C24) aliphatic hydrocarbon group (e.g., an alkyl group, an alkenyl group, or an alkynyl group), a substituted or unsubstituted C6 to C40 (or C6 to C24) aromatic hydrocarbon group (e.g., a C6 to C20 aryl group), or a combination thereof. The organic ligand may be bound to the surface of the formed nanoparticle. The organic ligand may include methanethiol, ethanethiol, propanethiol, butanethiol, pentanethiol, hexanethiol, heptanethiol, octanethiol, nonanethiol, decanethiol, dodecanethiol, hexadecanethiol, octadecanethiol, benzylthiol; methylamine, ethylamine, propylamine, butylamine, pentylamine, hexylamine, octylamine, dodecylamine, hexadecylamine, octadecylamine, dimethylamine, diethylamine, dipropylamine; methanoic acid, ethanoic acid, propanoic acid, butanoic acid, pentanoic acid, hexanoic acid, heptanoic acid, octanoic acid, dodecanoic acid, hexadecanoic acid, octadecanoic acid, oleic acid, benzoic acid; substituted or unsubstituted methylphosphine (e.g., trimethylphosphine, methyldiphenylphosphine), substituted or unsubstituted ethylphosphine (e.g., triethylphosphine, ethyldiphenylphosphine), substituted or unsubstituted propylphosphine, butylphosphine, pentylphosphine, octylphosphine (e.g., trioctylphosphine (TOP)); substituted or unsubstituted methylphosphine oxide (e.g., trimethylphosphine oxide, methyldiphenylphosphine oxide), ethylphosphine oxide (e.g., triethylphosphine oxide, ethyldiphenylphosphine oxide), propylphosphine oxide, butylphosphine oxide, octylphosphine oxide (e.g., trioctylphosphine oxide (TOPO)); diphenylphosphine, triphenylphosphine compound, or an oxide thereof;

phosphonic acid, hexylphosphonic acid, octylphosphonic acid, dodecylphosphonic acid, tetradecylphosphonic acid, hexadecylphosphonic acid, octadecylphosphonic acid, a C5 to C20 alkylphosphonic acid, or a combination thereof. The organic ligand may be used alone or as a mixture of two or more.

The organic solvent, (e.g., a first or second organic solvent) may be at least one of an amine solvent (e.g., a C1 to C50 aliphatic amine), a nitrogen-containing heterocyclic compound such as pyridine; a C6 to C40 aliphatic hydrocarbon (e.g., an alkane, alkene, or alkyne) such as hexadecane, octadecane, octadecene, or squalane; a C6 to C30 aromatic hydrocarbon such as phenyldodecane, phenyltetradecane, or phenylhexadecane; a phosphine substituted with a C6 to C22 alkyl group such as trioctylphosphine; a phosphine oxide substituted with a C6 to C22 alkyl group such as trioctylphosphine oxide; a C12 to C22 aromatic ether such as phenyl ether or benzyl ether; or a combination thereof. The amine solvent may be a compound having one or more (e.g., two or three) C1 to C50, C2 to C45, C3 to C40, C4 to C35, C5 to C30, C6 to C25, C7 to C20, C8 to C15, or C6 to C22 aliphatic hydrocarbon groups (alkyl, alkenyl, or alkynyl). In an embodiment, the amine solvent may include a C6 to C22 primary amine such as hexadecylamine or oleylamine; a C6 to C22 secondary amine such as dioctylamine; a C6 to C22 tertiary amine such as trioctylamine; or a combination thereof.

In an embodiment, an amount and a ratio of a first gallium precursor (for forming the first particle) and a second gallium precursor (for the second reaction) may also be appropriately selected in consideration of the types of the precursors and a composition of the final semiconductor nanoparticle. In an embodiment, a mole ratio of the first gallium precursor to the second gallium precursor may be in a range of 1:0.1 to 1:10, 1:0.3 to 1:3, 1:0.4 to 1:2.5, 1:0.5 to 1:2, 1:0.6 to 1:1.8, 1:0.65 to 1:1.3, 1:0.7 to 1:1.2, 1:0.8 to 1:1.1, or a combination thereof, but is not limited thereto. In the method of an embodiment, a mole ratio of the second gallium precursor to the first gallium precursor may be greater than or equal to about 0.1:1, greater than or equal to about 0.15:1, greater than or equal to about 0.2:1, greater than or equal to about 0.25:1, greater than or equal to about 0.3:1, greater than or equal to about 0.35:1, greater than or equal to about 0.4:1, greater than or equal to about 0.45:1, greater than or equal to about 0.5:1, greater than or equal to about 0.55:1, greater than or equal to about 0.6:1, greater than or equal to about 0.64:1, greater than or equal to about 0.7:1, greater than or equal to about 0.76:1, greater than or equal to about 0.8:1, greater than or equal to about 0.81:1, greater than or equal to about 0.9:1, greater than or equal to about 0.91:1, greater than or equal to about 0.94:1, greater than or equal to about 1:1, greater than or equal to about 1.07:1, greater than or equal to about 1.1:1, greater than or equal to about 1.15:1, greater than or equal to about 1.2:1, greater than or equal to about 1.25:1, greater than or equal to about 1.3:1, greater than or equal to about 1.35:1, greater than or equal to about 1.4:1, greater than or equal to about 1.46:1, or greater than or equal to about 1.5:1.

An amount of an organic ligand and each precursor in the reaction medium may be appropriately selected in consideration of a type of the solvent, types of the organic ligand and the precursors, and desired particle size and composition. A mole ratio among the precursors may be appropriately selected in consideration of a desired mole ratio in the final nanoparticles and reactivity among the precursors. A manner of adding each precursor is not particularly limited. Each precursor may be added once or may be added two or more times, up to ten times. Addition of the precursors may be performed simultaneously or sequentially. The reaction may be performed under an inert gas atmosphere, in air, or under vacuum, but is not limited thereto.

The method of an embodiment further includes adding an acid compound having a dipole moment of greater than or equal to about 2 to the medium (e.g., the reaction medium or a crude solution) (hereinafter, also referred to as acid treatment). In an embodiment, the acid compound may be added to the reaction mixture including the nanoparticles during formation of the second semiconductor nanocrystal (e.g., during the second reaction), or may be added to the crude solution after completing formation of the second semiconductor nanocrystal (e.g., by the second reaction). In an embodiment, the acid compound may be added to the crude solution obtained by adding an additional organic ligand such as trioctylphosphine to the reaction solution after completion of the reaction.

A temperature for adding the acid compound is not particularly limited and may be appropriately selected. The addition temperature of the acid compound may be greater than or equal to about 10°C, greater than or equal to about 20°C, or greater than or equal to about 30°C and less than or equal to about 100°C, less than or equal to about 80°C, or less than or equal to about 60°C.

Such acid treatment may provide improvement in emission properties even in the final semiconductor nanoparticles (e.g., those having a high mole ratio of gallium to indium). Without wishing to be bound by any theory, it is believed that a by-product (e.g., a gallium-containing by-product) present on a surface of the synthesized semiconductor nanoparticle may be substantially removed by the acid treatment, and the acid compound added may further passivate gallium atoms exposed on the surface, thereby modifying the surface of the resulting particle and providing improved emission properties. Furthermore, the present inventors have found that in the final semiconductor nanoparticle having a high mole ratio of gallium to indium, an acid treatment using an organic acid compound having a dipole moment of less than 2 may temporarily improve emission properties (e.g., prior to a washing process), but such improved emission properties may return to the original state during subsequent washing. In contrast, an acid treatment using an acid compound having a dipole moment of greater than or equal to about 2, as in the method of an embodiment, may provide improvement in emission properties that is maintained even after an extended washing process.

Details regarding the acid compound used in the method of an embodiment are as described herein. An amount of the acid compound used in the acid treatment is not particularly limited and may be appropriately selected. In an embodiment, an amount of the acid compound used in the acid treatment may be greater than or equal to about 1 gram (g) per 100 milliliters (mL) of the reaction solution, greater than or equal to about 5 g per 100 mL, greater than or equal to about 10 g per 100 mL, greater than or equal to about 15 g per 100 mL, greater than or equal to about 20 g per 100 mL, or greater than or equal to about 25 g per 100 mL. In an embodiment, an amount of the acid compound used in the acid treatment may be less than or equal to about 50 g per 100 mL of the reaction solution, less than or equal to about 40 g per 100 mL, less than or equal to about 35 g per 100 mL, or less than or equal to about 30 g per 100 mL.

The present inventors have found that in semiconductor nanoparticles having a high gallium content relative to indium, an increase of a by-product (e.g., a gallium by-product) present on the particle surface may cause an absorption peak at a wavelength of 370 nm in a UV-Vis absorption spectrum. In the method according to an embodiment, when acid treatment is performed, such a peak at 370 nm may disappear, and instead, a peak at a wavelength of about 315 nm may be generated.

A semiconductor nanoparticle obtained according to the method of an embodiment may have, in a UV-Vis absorption spectrum, a ratio of absorbance at 450 nm to absorbance at 315 nm (hereinafter, Abs 450/Abs 315) that is less than or equal to about 0.08, less than or equal to about 0.07, less than or equal to about 0.06, less than or equal to about 0.05, or less than or equal to about 0.04. In an embodiment, the Abs 450/Abs 315 may be greater than or equal to about 0.01, greater than or equal to about 0.02, or greater than or equal to about 0.03. A semiconductor nanoparticle obtained according to the method of an embodiment may have, in a UV-Vis absorption spectrum, a ratio of absorbance at 450 nm to absorbance at 370 nm (hereinafter, Abs 450/Abs 370) that is greater than or equal to about 0.09, greater than or equal to about 0.1, greater than or equal to about 0.12, greater than or equal to about 0.14, or greater than or equal to about 0.16. In an embodiment, the Abs 450/Abs 370 may be less than or equal to about 0.3, less than or equal to about 0.25, less than or equal to about 0.2, or less than or equal to about 0.18.

The present inventors have found that in semiconductor nanoparticles having a high content of gallium relative to indium, a crystal lattice may not be clearly observed in a transmission electron microscopy image (e.g., an HR-TEM image). In the method according to an embodiment, after undergoing acid treatment, the semiconductor nanoparticle may exhibit a crystal lattice that is clearly observable even under transmission electron microscopy. As confirmed by the inventors, the semiconductor nanoparticle according to an embodiment may exhibit improved crystallinity when analyzed by X-ray diffraction, even when having a high gallium content. In an embodiment, when analyzed by X-ray diffraction, the semiconductor nanoparticle may exhibit a clear peak (hereinafter, a first peak) in a range of two-theta ($2\theta$) of from about 15° to about 25° (e.g., having a full width at half maximum of greater than or equal to about 2°, greater than or equal to about 2.5°, greater than or equal to about 3°, or greater than or equal to about 4° and less than about 10°, less than or equal to about 8°, or less than or equal to about 6°). In an embodiment, the semiconductor nanoparticle may exhibit, in a range of $2\theta$ of from about 25° to about 30°, a peak (a second peak) that may be assigned to, for example, the (112) plane, and a ratio of an intensity of the first peak to an intensity of the second peak may be greater than or equal to about 0.1, greater than or equal to about 0.13, greater than or equal to about 0.15, or greater than or equal to about 0.2 and less than or equal to about 1, less than or equal to about 0.8, less than or equal to about 0.5, less than or equal to about 0.4, or less than or equal to about 0.3.

The semiconductor nanoparticle of an embodiment may exhibit, in a range of $2\theta$ of from about 10° to about 25°, peak intensities due to gallium by-products that are significantly reduced (e.g., less than or equal to about 15%, less than or equal to about 10%, less than or equal to about 8%, or less than or equal to about 5% of the intensity of the second peak), or such peaks may not be observed.

When analyzed by XPS, the semiconductor nanoparticle of an embodiment may include fluorine and may exhibit an F1s peak (or its maximum intensity) in a range of about 686 eV to about 690 eV, or about 687 eV to about 689 eV, for example at about 687.37 eV.

In XPS analysis of the semiconductor nanoparticle of an embodiment, Ga, In, Ag, and S peaks may exhibit a tendency to shift to higher energy. Ranges of energy (eV) in XPS analysis may be as shown in the drawings.

The present inventors have found that, in the method according to an embodiment, the acid treatment may also change a mode of presence of organic compounds existing in the semiconductor nanoparticle. When the semiconductor nanoparticle subjected to acid treatment according to the method of an embodiment is washed once or more and analyzed by TGA-Mass, a resulting DTGA curve may exhibit a peak corresponding to decomposition of a carboxylic acid compound at about 250°C to about 300°C (or about 270°C to about 290°C or about 280°C to about 288°C), and a peak (or its apex) at m/z = 45, corresponding to a carboxylic acid, may be present at about 250°C to about 300°C.

The semiconductor nanoparticle of an embodiment may exhibit a reduced amount of an organic ligand or organic material, or an increased amount of an inorganic material, after the acid treatment.

Therefore, the semiconductor nanoparticle subjected to the acid treatment according to the method of an embodiment may exhibit, in thermogravimetric analysis, a residue amount based on a total weight of the semiconductor nanoparticle of greater than or equal to about 80 wt%, greater than or equal to about 81 wt%, or greater than or equal to

about 82 wt% and/or less than or equal to about 100 wt%, less than or equal to about 99 wt%, less than or equal to about 95 wt%, or less than or equal to about 90 wt%. The semiconductor nanoparticle subjected to the acid treatment according to the method of an embodiment may exhibit, in thermogravimetric analysis, an organic material content based on the total weight of the semiconductor nanoparticle of less than or equal to about 20 wt%, less than or equal to about 19 wt%, or less than or equal to about 18 wt%. The semiconductor nanoparticle subjected to the acid treatment according to the method of an embodiment may exhibit, in thermogravimetric analysis, an organic material content based on the total weight of the semiconductor nanoparticle of greater than or equal to about 5 wt%, greater than or equal to about 10 wt%, greater than or equal to about 15 wt%, or greater than or equal to about 17 wt%.

The method may further include adding an antisolvent to the finally obtained reaction solution (e.g., the crude solution) and stirring for a predetermined time to separate and wash the semiconductor nanoparticles (e.g., the nanoparticles coordinated with the organic ligand). By addition of the antisolvent and washing, the nanoparticles (e.g., the nanoparticles coordinated with the organic ligand) may be separated (e.g., precipitated).

The antisolvent may be a polar solvent that is miscible with the solvent used in the reaction but cannot disperse the nanocrystals. The antisolvent may be selected depending on the solvent used in the reaction and may be for example, acetone, ethanol, butanol, isopropanol, ethanediol, water, tetrahydrofuran (THF), dimethylsulfoxide (DMSO), diethylether, formaldehyde, acetaldehyde, a solvent having a similar solubility parameter to the foregoing solvents, or a combination thereof. The separation may be performed by centrifugation, precipitation, chromatography, or distillation. Separated nanocrystals may be washed by adding to a washing solvent as needed. The washing solvent is not particularly limited, and a solvent having a solubility parameter similar to that of the organic solvent or ligand may be used. The antisolvent or washing solvent may be alcohols; alkane solvents, such as hexane, heptane, octane, or the like; aromatic solvents, such as toluene, benzene, or the like; halogenated solvent, such as chloroform or the like; or a combination thereof, but is not limited thereto.

In an embodiment, a predetermined amount of the acid compound may be added to the reaction solution (the crude solution) after completion of the reaction, and the mixture may be stirred for a predetermined time (e.g., from about 30 minutes to about 2 hours, from about 40 minutes to about 90 minutes, from about 50 minutes to about 80 minutes, or from about 60 minutes to about 70 minutes). Then, a washing solvent (e.g., an alcohol such as ethanol and optionally an aromatic solvent, e.g., toluene) may be added in excess (e.g., greater than or equal to about 0.3 times, greater than or equal to about 1 time, greater than or equal to about 1.5 times, greater than or equal to about 2 times, or greater than or equal to about 3 times a volume of the crude solution), and washing may be performed by high-speed stirring for a predetermined time (e.g., greater than or equal to about 3 minutes, greater than or equal to about 5 minutes) (e.g., at greater than or equal to about 1000 rpm, greater than or equal to about 3000 rpm, or greater than or equal to about 6000 rpm).

In an embodiment, the method may include preparing an additional reaction medium including an organic solvent and an organic ligand for the separated semiconductor nanoparticle; heating the additional reaction medium; and, in the additional reaction medium, contacting (e.g., reacting) a zinc precursor, a gallium precursor, and a sulfur precursor in the presence of the obtained particle (e.g., the semiconductor nanoparticle), for example at a reaction temperature, to further form a third semiconductor nanocrystal. The third semiconductor nanocrystal may include zinc gallium sulfide (ZnGaS). Details regarding the third semiconductor nanocrystal are as described herein.

The method may further include preparing an additional reaction medium including the organic solvent and the organic ligand; heating the additional reaction medium; and, in the additional reaction medium, in the presence of the formed semiconductor nanoparticle, contacting (e.g., reacting) a zinc precursor and a chalcogen precursor (e.g., the sulfur precursor), for example at the reaction temperature, to provide a fourth semiconductor nanocrystal including a zinc chalcogenide or an outer layer including the same on a surface of the semiconductor nanoparticle. Details regarding the fourth semiconductor nanocrystal are as described herein.

In an embodiment, a reaction temperature for forming the third semiconductor nanocrystal or the fourth semiconductor nanocrystal may be greater than or equal to about 120°C, greater than or equal to about 130°C, greater than or equal to about 150°C, greater than or equal to about 180°C, greater than or equal to about 200°C, greater than or equal to about 205°C, or greater than or equal to about 208°C and less than or equal to about 240°C, less than or equal to about 230°C, less than or equal to about 225°C, or less than or equal to about 215°C. A reaction time for forming the third semiconductor nanocrystal or the fourth semiconductor nanocrystal may be greater than or equal to about 10 minutes, greater than or equal to about 30 minutes, greater than or equal to about 40 minutes, greater than or equal to about 1 hour, greater than or equal to about 80 minutes, or greater than or equal to about 90 minutes and less than or equal to about 5 hours, less than or equal to about 4 hours, less than or equal to about 3 hours, less than or equal to about 2 hours, less than or equal to about 90 minutes, or less than or equal to about 70 minutes.

A type of the zinc precursor is not particularly limited and may be appropriately selected. For example, a zinc precursor may include Zn metal powder, an alkylated Zn compound, a Zn alkoxide, a Zn carboxylate, a Zn nitrate, a Zn perchlorate, a Zn sulfate, a Zn acetylacetonate, a Zn halide, a Zn cyanide, a Zn hydroxide, a Zn oxide, a Zn peroxide, or a combination thereof. The zinc precursor may be dimethylzinc, diethylzinc, zinc acetate, zinc acetylacetonate, zinc iodide,

zinc bromide, zinc chloride, zinc fluoride, zinc carbonate, zinc cyanide, zinc nitrate, zinc oxide, zinc peroxide, zinc perchlorate, zinc sulfate, or the like. In an embodiment, during formation of the second semiconductor nanocrystal, the zinc precursor may include a Zn halide.

Details regarding the gallium precursor and the sulfur precursor are as described herein.

The semiconductor nanoparticle thus prepared may be dispersed in a dispersion solvent. The semiconductor nanoparticle thus prepared may form an organic solvent dispersion. The organic solvent dispersion may include or may not include water and/or an organic solvent miscible with water. The dispersion solvent may be appropriately selected. The dispersion solvent may include the aforementioned organic solvent. The dispersion solvent may include a substituted or unsubstituted C1 to C40 aliphatic hydrocarbon, a substituted or unsubstituted C6 to C40 aromatic hydrocarbon, or a combination thereof.

In an embodiment, the semiconductor nanoparticle may be configured to emit green light. A peak emission wavelength of the green light or the semiconductor nanoparticle may be greater than or equal to about 500 nm, or greater than or equal to about 505 nm and less than or equal to about 580 nm, or less than or equal to about 550 nm. The peak emission wavelength of the green light or the semiconductor nanoparticle may be greater than or equal to about 500 nm, greater than or equal to about 505 nm, greater than or equal to about 510 nm, greater than or equal to about 514 nm, greater than or equal to about 515 nm, greater than or equal to about 517 nm, greater than or equal to about 519 nm, greater than or equal to about 520 nm, greater than or equal to about 525 nm, greater than or equal to about 530 nm, greater than or equal to about 535 nm, greater than or equal to about 540 nm, or greater than or equal to about 545 nm; and less than or equal to about 580 nm, less than or equal to about 575 nm, less than or equal to about 570 nm, less than or equal to about 565 nm, less than or equal to about 560 nm, less than or equal to about 555 nm, less than or equal to about 550 nm, less than or equal to about 545 nm, less than or equal to about 540 nm, less than or equal to about 535 nm, less than or equal to about 530 nm, less than or equal to about 525 nm, less than or equal to about 520 nm, or less than or equal to about 515 nm.

In an embodiment, the semiconductor nanoparticle may be configured to emit red light. A peak emission wavelength of the red light or the semiconductor nanoparticle may be greater than or equal to about 600 nm, greater than or equal to about 605 nm, greater than or equal to about 610 nm, and less than or equal to about 650 nm, or less than or equal to about 640 nm, or less than or equal to about 630 nm.

In an embodiment, the semiconductor nanoparticle may exhibit a quantum yield (e.g., an absolute quantum yield) of greater than or equal to about 70%. The quantum yield may be an absolute quantum yield. The (e.g., absolute) quantum yield may be greater than or equal to about 70%, greater than or equal to about 71%, greater than or equal to about 72%, greater than or equal to about 73%, greater than or equal to about 74%, greater than or equal to about 75%, greater than or equal to about 76%, greater than or equal to about 77%, greater than or equal to about 78%, greater than or equal to about 79%, greater than or equal to about 80%, greater than or equal to about 81%, greater than or equal to about 82%, greater than or equal to about 83%, greater than or equal to about 84%, greater than or equal to about 85%, greater than or equal to about 86%, greater than or equal to about 87%, greater than or equal to about 88%, greater than or equal to about 89%, greater than or equal to about 90%, greater than or equal to about 91%, greater than or equal to about 92%, greater than or equal to about 93%, greater than or equal to about 94%, or greater than or equal to about 95%; and may be less than or equal to about 100%, less than or equal to about 99.5%, less than or equal to about 99%, less than or equal to about 98%, or less than or equal to about 97%.

The semiconductor nanoparticle or the green light may have a full width at half maximum (FWHM) that is greater than or equal to about 5 nm, greater than or equal to about 10 nm, greater than or equal to about 15 nm, greater than or equal to about 20 nm, greater than or equal to about 25 nm, or greater than or equal to about 30 nm; and less than or equal to about 70 nm, less than or equal to about 65 nm, less than or equal to about 60 nm, less than or equal to about 55 nm, less than or equal to about 50 nm, less than or equal to about 45 nm, less than or equal to about 40 nm, less than or equal to about 38 nm, less than or equal to about 36 nm, less than or equal to about 35 nm, less than or equal to about 34 nm, less than or equal to about 33 nm, less than or equal to about 32 nm, less than or equal to about 31 nm, less than or equal to about 30 nm, less than or equal to about 29 nm, less than or equal to about 28 nm, less than or equal to about 27 nm, less than or equal to about 26 nm, or less than or equal to about 25 nm.

In an embodiment, the first light (e.g., a green light or a red light) may include band-edge emission. In an embodiment, the light emitted from the semiconductor nanoparticle may further include defect site emission or trap emission. The band-edge emission may be centered at a higher energy (lower wavelength) with a smaller offset from the absorption onset energy compared to the trap emission. The band-edge emission may have a narrower wavelength distribution than that of the trap emission. The band-edge emission may have a normal (e.g., Gaussian) wavelength distribution.

In the photoluminescence spectrum of the semiconductor nanoparticle or a composite including the same, the percentage of the area or peak area of trap emission (Trap) (e.g., the area of the emission peak portion above the peak emission wavelength + 50 nm) relative to the total peak area (A) may be less than or equal to about 25%, less than or equal to about 24%, less than or equal to about 23%, less than or equal to about 22%, less than or equal to about 21%, less than or equal to about 20%, less than or equal to about 15%, less than or equal to about 12%, less than or equal to about 10%, less

than or equal to about 9%, less than or equal to about 8%, less than or equal to about 7%, less than or equal to about 6%, less than or equal to about 5%, less than or equal to about 4%, less than or equal to about 3%, or less than or equal to about 2%:

Equation 5

$$\text{Trap emission percentage (\%)} = [\text{Trap}/\text{A}] \times 100$$

In Equation 5, Trap is the area of the trap emission, and A is the total area of the emission peak. (See FIG. 1)

The present inventors have found that in a semiconductor nanoparticle based on a group 13-16 compound including silver, there is a limitation in suppressing and eliminating trap emission. Providing a zinc chalcogenide layer may increase the stability of the semiconductor nanoparticle; however, the present inventors have found that the formation of the zinc chalcogenide layer may increase the trap emission of the final particle. The semiconductor nanoparticle of an embodiment may exhibit a photoluminescence spectrum in which the trap emission is substantially suppressed or eliminated, for example, by having the structure and composition described herein.

The shape of the produced semiconductor nanoparticle is not particularly limited and may include, for example, a spherical shape, a polyhedral shape, a pyramidal shape, a multipod shape, a cubic shape, a nanotube, a nanowire, a nanofiber, a nanosheet, or a combination thereof, but is not limited thereto.

The produced semiconductor nanoparticle may include an organic ligand and/or an organic solvent on its surface. The organic ligand and/or the organic solvent may be bound to the surface of the semiconductor nanoparticle of an embodiment. The organic ligand and the organic solvent are as described herein.

In an embodiment, a semiconductor nanoparticle composite may include a matrix; and the semiconductor nanoparticle described herein, wherein the semiconductor nanoparticle may be dispersed in the matrix. The semiconductor nanoparticle composite (hereinafter, can be referred to as "composite") may further contain a metal oxide fine particle. The composite or the semiconductor nanoparticle may be configured to emit first light (e.g., green light or red light). In an embodiment, the composite may be in the form of a patterned film. The composite may further include a semiconductor nanoparticle configured to emit second light different from the first light. In an embodiment, the composite may have a sheet form. The sheet may further include a semiconductor nanoparticle (e.g., an additional semiconductor nanoparticle) configured to emit second light different from the first light.

The semiconductor nanoparticle described herein or the composite including the semiconductor nanoparticle may exhibit an increased level of blue light absorbance (e.g., an improved incident light absorbance) and/or improved optical properties (e.g., an increased luminescent efficiency and a narrower full width at half maximum), and may emit light of a desired wavelength (e.g., first light).

The semiconductor nanoparticle composite may include the semiconductor nanoparticle or a population thereof (e.g., in a predetermined amount) and exhibit increased light absorbance. An incident light absorbance (e.g., blue light absorbance) of the composite may be greater than or equal to about 70%, greater than or equal to about 73%, greater than or equal to about 75%, greater than or equal to about 77%, greater than or equal to about 80%, greater than or equal to about 83%, greater than or equal to about 85%, greater than or equal to about 87%, greater than or equal to about 90%, greater than or equal to about 93%, greater than or equal to about 94%, greater than or equal to about 95%, greater than or equal to about 96%, greater than or equal to about 97%, greater than or equal to about 98%, or greater than or equal to about 99%. The incident light absorbance (e.g., blue light absorbance) of the composite may be about 70% to about 100%, about 80% to about 98%, about 95% to about 99%, about 96% to about 98%, or a combination thereof.

The incident light absorbance of the composite may be calculated according to Equation 6:

Equation 6

$$\text{incident light absorbance} = [(B-B')/B] \times 100\%$$

wherein, in Equation 6,

B is an amount of incident light provided to the composite, and
B' is an amount of incident light passing through the composite.
A light conversion efficiency (CE) (e.g., an external quantum efficiency or an internal quantum efficiency) of the composite may be greater than or equal to about 50%, greater than or equal to about 55%, greater than or equal to about 60%, greater than or equal to about 65%, greater than or equal to about 70%, or greater than or equal to about 75%:

Equation 2

$$\text{Internal quantum efficiency (\%)} = [A/(B-B')] \times 100$$

Equation 3

$$\text{External quantum efficiency (\%)} = [A/B] \times 100$$

wherein:

A: amount of the first light emitted from the composite
B: amount of the irradiated incident light
B': amount of the incident light passing through the composite.

According to the findings of the present inventors, in the case of a luminescent particle (e.g., a semiconductor nanoparticle) including a semiconductor nanocrystal based on a group 11-13-16 compound, even when the desired level of optical property is achieved, a significantly reduced property may be observed when the luminescent particle (e.g., the semiconductor nanoparticle) is incorporated into a composite for a practical device application. The semiconductor nanoparticle of an embodiment may provide a composite exhibiting improved optical properties by having the above-described compositional and/or structural characteristics and may exhibit a high retention rate of optical properties even in the form of a thin film. The semiconductor nanoparticle of an embodiment may exhibit significantly improved stability (e.g., thermal stability and ambient stability).

Accordingly, a composite including the semiconductor nanoparticle of an embodiment may have a process retention rate (i.e., process maintenance percentage), as defined by Equation 4, that is greater than or equal to about 70%, greater than or equal to about 75%, greater than or equal to about 80%, greater than or equal to about 85%, greater than or equal to about 90%, or greater than or equal to about 100%:

Equation 4

$$\text{Process retention rate (\%)} = [QE2 / QE1] \times 100$$

In the above equation, QE1 is the internal quantum efficiency or external quantum efficiency of the semiconductor nanoparticle-polymer composite before heat treatment after polymerization, and QE2 is the internal quantum efficiency or external quantum efficiency of the semiconductor nanoparticle-polymer composite after heat treatment.

The process retention rate (process maintenance percentage) may be in a range of about 10% to about 150%, about 20% to about 130%, about 25% to about 100%, about 30% to about 99%, about 68% to about 95%, about 70% to about 85%, or a combination thereof.

In an embodiment, the semiconductor nanoparticle composite may be prepared from an ink composition. The ink composition may include a liquid vehicle; and a plurality of the semiconductor nanoparticles of an embodiment. The semiconductor nanoparticle may be dispersed in the liquid vehicle.

The liquid vehicle may include a liquid monomer, an organic solvent, or a combination thereof. The ink composition may further include a metal oxide nanoparticle e.g., dispersed in the liquid vehicle. The ink composition may further include a dispersant (for dispersing the nanoparticles and/or the metal oxide nanoparticles). The dispersant may include a carboxylic acid group-including organic compound (a monomer or a polymer). The liquid vehicle may include or may not substantially include an (e.g., volatile) organic solvent. The ink composition may be a solvent-free system.

The liquid monomer may include a (photo)polymerizable monomer including a carbon-carbon double bond. The composition may optionally further include a (thermal or photo) initiator. The polymerization of the composition may be initiated by light or heat.

Details of the nanoparticle(s) in the composition (or composite) are as described herein. An amount of the semiconductor nanoparticle in the composition (or composite) may be appropriately adjusted in consideration of a desired end use (e.g., a color filter, or the like). In an embodiment, an amount of the semiconductor nanoparticle in the composition (or composite) may be greater than or equal to about 1 weight percent (wt%), for example, greater than or equal to about 2 wt%, greater than or equal to about 3 wt%, greater than or equal to about 4 wt%, greater than or equal to about 5 wt%, greater than or equal to about 6 wt%, greater than or equal to about 7 wt%, greater than or equal to about 8 wt%, greater than or equal to about 9 wt%, greater than or equal to about 10 wt%, greater than or equal to about 15 wt%, greater than or equal to about 20 wt%, greater than or equal to about 25 wt%, greater than or equal to about 30 wt%, greater than or equal to about 35 wt%, or greater than or equal to about 40 wt% based on the solid content of the composition or composite

(hereinafter, the solid content may be a solid content of the composition or a solid content of the composite). The amount of the semiconductor nanoparticle may be less than or equal to about 70 wt%, for example, less than or equal to about 65 wt%, less than or equal to about 60 wt%, less than or equal to about 55 wt%, or less than or equal to about 50 wt%, based on the solid content of the composition or composite. A weight percentage of a given component with respect to a total solid content in a composition may represent an amount of the given component in the composite described herein.

In an embodiment, an ink composition may be a semiconductor nanoparticle-including photoresist composition applicable in a photolithography manner. In an embodiment, an ink composition may be a semiconductor nanoparticle-including composition capable of providing a pattern in a printing manner (e.g., a droplet discharging method such as an inkjet printing). The composition according to an embodiment may not include a conjugated (or conductive) polymer (except for a cardo binder to be described herein). The composition according to an embodiment may include a conjugated polymer. Herein, the conjugated polymer refers to a polymer (e.g., polyphenylenevinylene, or the like) having a conjugated double bond in the main chain.

In the composition according to an embodiment, the dispersant may ensure dispersibility of the nanoparticle (e.g., the semiconductor nanoparticle). In an embodiment, the dispersant may be a binder (or a binder polymer). The binder may include a carboxylic acid group (e.g., in the repeating unit). The binder may be an insulating polymer. The binder may be a carboxylic acid group-including compound (a monomer or a polymer).

In the composition (or the composite), an amount of the dispersant may be greater than or equal to about 0.5 wt%, for example, greater than or equal to about 1 wt%, greater than or equal to about 5 wt%, greater than or equal to about 10 wt%, greater than or equal to about 15 wt%, or greater than or equal to about 20 wt%, based on the total solid content of the composition (or composite). The amount of the dispersant may be less than or equal to about 55 wt%, less than or equal to about 35 wt%, less than or equal to about 33 wt%, or less than or equal to about 30 wt%, based on the total solid content of the composition (or composite).

In the composition (or the liquid vehicle), a liquid monomer or a polymerizable (e.g., photopolymerizable) monomer (hereinafter, referred to as a monomer) including the carbon-carbon double bond may include a (e.g., photopolymerizable) (meth)acryl-including monomer. The monomer may be a precursor for an insulating polymer.

An amount of the (photopolymerizable) monomer, based on a total weight or a total solid content of the composition, may be greater than or equal to about 0.5 wt%, for example, greater than or equal to about 1 wt%, greater than or equal to about 2 wt%, greater than or equal to about 3 wt%, greater than or equal to about 5 wt%, or greater than or equal to about 10 wt%. An amount of the (photopolymerizable) monomer, based on a total weight or a total solid content of the composition, may be less than or equal to about 30 wt%, for example, less than or equal to about 28 wt%, less than or equal to about 25 wt%, less than or equal to about 23 wt%, less than or equal to about 20 wt%, less than or equal to about 18 wt%, less than or equal to about 17 wt%, less than or equal to about 16 wt%, or less than or equal to about 15 wt%.

The (photo)initiator included in the composition may be used for (photo)polymerization of the aforementioned monomer. The initiator is a compound accelerating a radical reaction (e.g., radical polymerization of monomer) by producing radical chemical species under a mild condition (e.g., by heat or light). The initiator may be a thermal initiator or a photoinitiator. The initiator is not particularly limited and may be appropriately selected.

In the composition, an amount of the initiator may be appropriately adjusted considering types and amounts of the polymerizable monomers. In an embodiment, the amount of the initiator may be greater than or equal to about 0.01 wt%, for example, greater than or equal to about 1 wt%, and less than or equal to about 10 wt%, for example, less than or equal to about 9 wt%, less than or equal to about 8 wt%, less than or equal to about 7 wt%, less than or equal to about 6 wt%, or less than or equal to about 5 wt%, based on the total weight (or the total solid content) of the composition, but is not limited thereto.

The composition (or composite) may further include a (multi- or monofunctional) thiol compound having at least one thiol group at the terminal end (or a moiety derived therefrom, such as a moiety produced by a reaction between a thiol and a carbon-carbon double bond, for example, a sulfide group), metal oxide particulate, or a combination thereof.

The metal oxide particulate (e.g., metal oxide nanoparticle) may include $TiO_2$, $SiO_2$, $BaTiO_3$, $Ba_2TiO_4$, ZnO, or a combination thereof. In the composition (or composite), an amount of the metal oxide particulates may be greater than or equal to about 1 wt%, greater than or equal to about 2 wt%, greater than or equal to about 3 wt%, greater than or equal to about 5 wt%, or greater than or equal to about 10 wt% and less than or equal to about 50 wt%, less than or equal to about 40 wt%, less than or equal to about 30 wt%, less than or equal to about 25 wt%, less than or equal to about 20 wt%, less than or equal to about 15 wt%, less than or equal to about 10 wt%, less than or equal to about 7 wt%, less than or equal to about 5 wt%, or less than or equal to about 3 wt%, based on the total solid content.

A diameter of the metal oxide particulate is not particularly limited, and may be appropriately selected. The diameter of the metal oxide particulates may be greater than or equal to about 100 nm, for example greater than or equal to about 150 nm, or greater than or equal to about 200 nm and less than or equal to about 1000 nm, or less than or equal to about 800 nm.

The polythiol compound may be a dithiol compound, a trithiol compound, a tetrathiol compound, or a combination thereof. For example, the thiol compound may be ethylene glycol bis(3-mercaptopropionate), ethylene glycol dimercapto

acetate, trimethylolpropane tris(3-mercaptopropionate), pentaerythritol tetrakis(3-mercaptopropionate), pentaerythritol tetrakis(2-mercaptoacetate), 1,6-hexanedithiol, 1,3-propanedithiol, 1,2-ethanedithiol, polyethylene glycol dithiol including 1 to 10 ethylene glycol repeating units, or a combination thereof.

An amount of the thiol compound (or moieties derived therefrom) may be less than or equal to about 50 wt%, less than or equal to about 40 wt%, less than or equal to about 30 wt%, less than or equal to about 20 wt%, less than or equal to about 10 wt%, less than or equal to about 9 wt%, less than or equal to about 8 wt%, less than or equal to about 7 wt%, less than or equal to about 6 wt%, or less than or equal to about 5 wt%, based on the total solid content. The amount of the thiol compound (or moieties derived therefrom) may be greater than or equal to about 0.1 wt%, for example, greater than or equal to about 0.5 wt%, greater than or equal to about 1 wt%, greater than or equal to about 5 wt%, greater than or equal to about 10 wt%, greater than or equal to about 15 wt%, greater than or equal to about 18 wt%, or greater than or equal to about 20 wt%, based on the total solid content.

The composition or the liquid vehicle may include an organic solvent. In an embodiment, the composition or the liquid vehicle may not include an organic solvent. If present, the type of organic solvent that may be used is not particularly limited. The type and amount of the organic solvent is appropriately determined in consideration of the types and amounts of the aforementioned main components (i.e., nanoparticles, dispersants, polymerizable monomers, initiators, thiol compounds, or the like, if present) and other additives to be described herein. The composition may include a solvent in a residual amount except for a desired amount of the (non-volatile) solid. In an embodiment, examples of the organic solvent may be an ethylene glycols, such as ethylene glycol, diethylene glycol, polyethylene glycol, and the like; a glycol ether solvent, such as ethylene glycol monomethylether, ethylene glycol monoethyl ether, diethylene glycol monomethyl ether, ethylene glycol diethyl ether, diethylene glycol dimethyl ether, or the like; a glycol ether acetate solvent, such as ethylene glycol acetate, ethylene glycol monoethyl ether acetate, diethylene glycol monoethyl ether acetate, diethylene glycol monobutyl ether acetate, or the like; a propylene glycol solvent, such as propylene glycol, or the like; a propylene glycol ether solvent, such as propylene glycol monomethyl ether, propylene glycol monoethyl ether, propylene glycol monopropyl ether, propylene glycol monobutyl ether, propylene glycol dimethyl ether, dipropylene glycol dimethyl ether, propylene glycol diethyl ether, dipropylene glycol diethyl ether, or the like; a propylene glycol ether acetate solvent, such as propylene glycol monomethyl ether acetate, dipropylene glycol monoethyl ether acetate, or the like; an amide solvent, such as N-methylpyrrolidone, dimethyl formamide, dimethyl acetamide, or the like; a ketone solvent, such as methylethylketone (MEK), methyl isobutyl ketone (MIBK), cyclohexanone, or the like; a petroleum solvent, such as toluene, xylene, solvent naphtha, or the like; an ester solvent, such as ethyl acetate, butyl acetate, ethyl lactate, ethyl 3-ethoxy propionate, or the like; an ether solvent, such as diethyl ether, dipropyl ether, dibutyl ether, or the like; chloroform, a C1 to C40 aliphatic hydrocarbon solvent (e.g., alkane, alkene, or alkyne), a halogen (e.g., chloro) substituted C1 to C40 aliphatic hydrocarbon solvent (e.g., dichloroethane, trichloromethane, or the like), a C6 to C40 aromatic hydrocarbon solvent (e.g., toluene, xylene, or the like), a halogen (e.g., chloro) substituted C6 to C40 aromatic hydrocarbon solvent; or a combination thereof.

In addition to the aforementioned components, the composition (or composite) of an embodiment may further include an additive such as a light diffusing agent, a leveling agent, a coupling agent, or a combination thereof. Components (binder, monomer, solvent, additives, thiol compound, cardo binder, or the like) included in the composition of an embodiment may be appropriately selected, and for specific details thereof, for example, US-2017-0052444-A1 may be referred to, which is incorporated herein in its entirety.

In the preparation of the composition according to an embodiment, each of the above-described components may be manufactured sequentially or simultaneously mixed, and the order thereof is not particularly limited.

The composition may provide a color conversion layer (or a patterned film of the composite) by (e.g., radical) polymerization. The color conversion layer (or the patterned film of the composite) may be produced using a photoresist composition. Referring to FIG. 2A, this method may include forming a film of the aforementioned composition on a substrate (S1); prebaking the film according to selection (S2); exposing a selected region of the film to light (e.g., having a wavelength of less than or equal to about 400 nm) (S3); and developing the exposed film with an alkali developing solution to obtain a pattern of a quantum dot-polymer composite (S4).

Referring to FIG. 2A, the aforementioned composition may be applied to a predetermined thickness on a substrate using an appropriate method such as spin coating or slit coating to form a film. The formed film may be optionally subjected to a pre-baking (PRB) step. The pre-baking may be performed by selecting an appropriate condition from known conditions of a temperature, time, an atmosphere, or the like.

The formed (or optionally prebaked) film may be exposed to light having a predetermined wavelength under a mask having a predetermined pattern (EXP). A wavelength and intensity of the light may be selected considering types and amounts of the photoinitiator, types, and amounts of the quantum dots, or the like.

The exposed film may then be treated with an alkali developing solution (e.g., dipping or spraying) to dissolve an unexposed region and obtain a desired pattern (DEV). The obtained pattern may be, optionally, post-exposure baked (POB) to improve crack resistance and solvent resistance of the pattern, for example, at a temperature of about 150°C to about 230°C for a predetermined time (e.g., greater than or equal to about 10 minutes, or greater than or equal to about 20

minutes) (S5).

When the color conversion layer or the patterned film of the nanoparticle composite has a plurality of repeating sections (that is, color conversion regions), each repeating section may be formed by preparing a plurality of compositions including quantum dots (e.g., red light emitting quantum dots, green light emitting quantum dots, or optionally, blue light emitting quantum dots) having desired luminous properties (photoluminescence peak wavelength or the like) and repeating the aforementioned pattern-forming process as many times as necessary (e.g., 2 times or more, or 3 times or more) for each composition, resultantly obtaining a nanoparticle-polymer composite having a desired pattern (S6). For example, the nanoparticle-polymer composite may have a pattern of at least two repeating color sections (e.g., RGB color sections). This nanoparticle-polymer composite pattern may be used as a photoluminescence type color filter in a display device.

The color conversion layer or patterned film of the semiconductor nanoparticle composite may be produced using an ink composition configured to form a pattern in an inkjet manner. Referring to FIG. 2B, such a method may include preparing an ink composition according to an embodiment, providing a substrate (e.g., with pixel areas patterned by electrodes and optionally banks or trench-type partition walls, or the like), and depositing an ink composition on the substrate (or the pixel area) to form, for example, a first composite layer (or first region). The method may include depositing an ink composition on the substrate (or the pixel area) to form, for example, a second composite layer (or second region). The first and second composite layers may be first and second quantum dot layers, respectively. The forming of the first composite layer and forming of the second composite layer may be simultaneously or sequentially performed.

The depositing of the ink composition may be performed using an appropriate liquid crystal discharger, for example an inkjet or nozzle printing system (having an ink storage and at least one print head). The deposited ink composition may provide a (first or second) composite layer through the solvent removal and polymerization by the heating. The method may provide a highly precise nanoparticle-polymer composite film or patterned film for a short time by the simple method.

In the semiconductor nanoparticle-polymer composite (e.g., first composite) of an embodiment, the (polymer) matrix may include the components described herein with respect to the composition. In the composite, an amount of the matrix, based on a total weight of the composite, may be greater than or equal to about 10 wt%, greater than or equal to about 20 wt%, greater than or equal to about 30 wt%, greater than or equal to about 40 wt%, greater than or equal to about 50 wt%, or greater than or equal to about 60 wt%. The amount of the matrix may be, based on a total weight of the composite, less than or equal to about 95 wt%, less than or equal to about 90 wt%, less than or equal to about 80 wt%, less than or equal to about 70 wt%, less than or equal to about 60 wt%, or less than or equal to about 50 wt%.

The (polymer) matrix may include a dispersant (e.g., a carboxylic acid group-including binder polymer), a polymerization product (e.g., an insulating polymer) of a polymerizable monomer including (at least one, for example, at least two, at least three, at least four, or at least five) carbon-carbon double bonds, a polymerization product of the polymerizable monomer and a polythiol compound having at least two thiol groups (e.g., at a terminal end), or a combination thereof. The matrix may include a linear polymer, a crosslinked polymer, or a combination thereof. The (polymer) matrix may not include a conjugated polymer (excluding cardo resin). The matrix may include a conjugated polymer.

The crosslinked polymer may include a thiol-ene resin, a crosslinked poly(meth)acrylate, a crosslinked polyurethane, a crosslinked epoxy resin, a crosslinked vinyl polymer, a crosslinked silicone resin, or a combination thereof. In an embodiment, the crosslinked polymer may be a polymerization product of the aforementioned polymerizable monomers and optionally a polythiol compound.

The linear polymer may include a repeating unit derived from a carbon-carbon unsaturated bond (e.g., a carbon-carbon double bond). The repeating unit may include a carboxylic acid group. The linear polymer may include an ethylene repeating unit.

The carboxylic acid group-containing repeating unit may include a unit derived from a monomer including a carboxylic acid group and a carbon-carbon double bond, a unit derived from a monomer having a dianhydride moiety, or a combination thereof.

The (polymer) matrix may include a carboxylic acid group-containing compound (e.g., a binder, a binder polymer, or a dispersant) (e.g., for dispersion of nanoparticles or a binder).

The first composite (or a film or pattern thereof) may have, for example, a thickness of less than or equal to about 30 micrometers (μm), less than or equal to about 25 μm, less than or equal to about 20 μm, less than or equal to about 15 μm, less than or equal to about 10 μm, less than or equal to about 8 μm, or less than or equal to about 7 μm to greater than about 2 μm, for example, greater than or equal to about 3 μm, greater than or equal to about 3.5 μm, greater than or equal to about 4 μm, greater than or equal to about 5 μm, greater than or equal to about 6 μm, greater than or equal to about 7 μm, greater than or equal to about 8 μm, greater than or equal to about 9 μm, or greater than or equal to about 10 μm.

The semiconductor nanoparticle(s), the composite (or pattern thereof) including the semiconductor nanoparticle(s), or a color conversion panel including the same may be included in an electronic device. Such an electronic device

may include a display device, a light emitting diode (LED), an organic light emitting diode (OLED), a quantum dot LED, a sensor, a solar cell, an imaging sensor, a photodetector, or a liquid crystal display device, but embodiments are not limited thereto. The aforementioned quantum dot (or the semiconductor nanoparticle) in an embodiment may be included in an electronic apparatus. Such an electronic apparatus may include, but is not limited to, a virtual reality device, an augmented reality device, a portable terminal device, a monitor, a notebook personal computer (PC), a television, an electric sign board, an electronic display board, a camera, a vehicle (e.g., a car), or the like, but embodiments are not limited thereto. The electronic apparatus may be a portable terminal device, a monitor, a laptop personal computer, or a television including a display device (or a light emitting device) including quantum dots. The electronic apparatus may be a camera or a mobile terminal device including an image sensor including quantum dots. The electronic apparatus may be a camera or a vehicle including a photodetector including quantum dots.

In an embodiment, an electronic device includes a color conversion layer, and the color conversion layer includes nanoparticles, and the nanoparticles include the semiconductor nanoparticle described herein. The electronic device includes a light emitting panel including a light source and a color conversion panel, the color conversion panel includes the color conversion layer, and the light source may be configured to provide incident light to the color conversion panel.

In an embodiment, a color conversion layer (e.g., a color conversion structure or a color conversion panel) includes a color conversion region including the semiconductor nanoparticle described herein. The color conversion panel may include a color conversion layer including a color conversion region and optionally a partition wall defining each region of the color conversion layer. The color conversion region may include a first region corresponding to a first pixel, and the first region may include the semiconductor nanoparticles or the semiconductor nanoparticle composite. In the color conversion panel of an embodiment, the semiconductor nanoparticle composite may be in the form of a patterned film. In another embodiment, the semiconductor nanoparticle composite may have a sheet form.

The first region may include a first composite, and the first composite may include a matrix and semiconductor nanoparticles dispersed in the matrix and may be configured to emit first light. An embodiment provides the semiconductor nanoparticles or a population thereof.

The color conversion layer (e.g., a color conversion structure) may include the semiconductor nanoparticle composite or a patterned film thereof according to an embodiment. FIG. 3A is a schematic cross-sectional view of a color conversion panel according to an embodiment. Referring to FIG. 3A, the color conversion panel may optionally further include a partition wall (e.g., a black matrix (BM), a bank, or a combination thereof) that defines each region of the color conversion layer (e.g., a color conversion structure). FIG. 3B illustrates an electronic device (or a display device) including a color conversion panel and a light source according to another embodiment. In the electronic device of an embodiment, a color conversion panel including a color conversion layer or a color conversion structure may be disposed on an LED on a chip (e.g., a micro LED on a chip). Referring to FIG. 3B, a circuit (e.g., Si driver integrated circuit (IC)) configured to drive the light source may be disposed under a light source (e.g., blue LED) configured to emit incident light (e.g., a blue light). The color conversion layer may include a first composite including a semiconductor nanoparticle emitting a first light (e.g., a green light), and a second composite including a semiconductor nanoparticle emitting a second light (e.g., a red light), or a third composite that emits or passes a third light (e.g., incident light or a blue light). A partition wall (PW) (e.g., including an inorganic material, such as silicon or silicon oxide, or based on an organic material), may be disposed between respective composites. The partition wall may include a trench hole, a via hole, or a combination thereof. A first optical element (e.g., an absorption type color filter) may be disposed on a light extraction surface of a color conversion layer. An additional optical element, such as a micro lens, may be further disposed on the first optical element.

The color conversion region may include a first region configured to emit the aforementioned first light (or green light) (e.g., by irradiation with an incident light). In an embodiment, the first region may correspond to a green pixel. The first region may include a first composite (e.g., a luminescence type composite). The first light may have a peak emission wavelength within a wavelength range to be described later. The first light will be described in more detail for the semiconductor nanoparticles described herein. The peak emission wavelength of the green light may be greater than or equal to about 500 nm, greater than or equal to about 501 nm, greater than or equal to about 504 nm, greater than or equal to about 505 nm, or greater than or equal to about 520 nm. The peak emission wavelength of the green light may be less than or equal to about 580 nm, less than or equal to about 560 nm, less than or equal to about 550 nm, less than or equal to about 530 nm, less than or equal to about 525 nm, less than or equal to about 520 nm, less than or equal to about 515 nm, or less than or equal to about 510 nm.

The color conversion region may further include a (e.g., one or more) second region that is configured to emit a second light (e.g., a red light) different from the first light (e.g., by irradiation with excitation light). The second region may include a second composite. The semiconductor nanoparticle composite in the second region may include a semiconductor nanoparticle (e.g., a quantum dot) being configured to emit a light of a different wavelength (e.g., a different color) from the semiconductor nanoparticle composite disposed in the first region.

The second light may be a red light having a peak emission wavelength of about 600 nm to about 650 nm (e.g., about 620 nm to about 650 nm). The color conversion panel may further include (one or more) third regions that emit or pass a third light (e.g., a blue light) different from the first light and the second light. An incident light may include the third

light (e.g., a blue light and optionally a green light). The third light may include a blue light having a peak emission wavelength of greater than or equal to about 380 nm (e.g., greater than or equal to about 440 nm, greater than or equal to about 445 nm, greater than or equal to about 450 nm, or greater than or equal to about 455 nm) to less than or equal to about 480 nm (e.g., less than or equal to about 475 nm, less than or equal to about 470 nm, less than or equal to about 465 nm, or less than or equal to about 460 nm).

In an embodiment, the color conversion panel or the color conversion layer may include a plurality of first regions, and the semiconductor nanoparticle composite may constitute a predetermined pattern to be respectively disposed in the first regions of the color conversion panel. The semiconductor nanoparticle composite (or a pattern thereof) may be prepared from the (ink) composition by any method, for example, in a photolithography manner or in an inkjet printing manner. Accordingly, an embodiment may relate to a composition including a semiconductor nanoparticle, which was described herein in further detail.

In an embodiment, the electronic device or the display device (e.g., display panel) may further include a color conversion layer (or a color conversion panel) and optionally, a light source. The light source may provide incident light to the color conversion layer or the color conversion panel. In an embodiment, the display panel may include a light emitting panel (or a light source), the aforementioned color conversion panel, and a light transmitting layer located between the aforementioned light emitting panel and the aforementioned color conversion panel. The color conversion panel may include a substrate, and the color conversion layer may be disposed on the substrate. (see FIG. 4A and FIG. 4B)

When present, the light source or the light emitting panel may provide an incident light to the color conversion layer or the color conversion panel. The incident light may have a peak emission wavelength of greater than or equal to about 440 nm, for example, greater than or equal to about 450 nm, and less than or equal to about 580 nm, for example, less than or equal to about 480 nm, less than or equal to about 470 nm, or less than or equal to about 460 nm.

In an embodiment, the electronic device (e.g., a photoluminescent device) may further include a sheet of the nanoparticle composite. Referring to FIG. 4B, the device 400 may include a backlight unit 410 and a liquid crystal panel 420, optionally wherein the backlight unit 410 may include a quantum dot polymer composite sheet (QD sheet). For example, the backlight unit 410 may have a structure that a reflector, a light guide plate (LGP), a light source (a blue LED or the like), the quantum dot polymer composite sheet (QD sheet), and an optical film (a prism, a double brightness enhance film (DBEF, or the like) may be stacked. The liquid crystal panel 420 may be disposed on the backlight unit 410 and have a structure where a thin film transistor (TFT), liquid crystals (LC), and a color filter are included between two polarizers (Pol). The quantum dot polymer composite sheet (QD sheet) may include semiconductor nanoparticles (e.g., quantum dots) emitting a red light and a green light after absorbing light from the light source. A blue light provided from the light source may be combined with the red light and the green light emitted from the respective semiconductor nanoparticles, while passing the quantum dot polymer composite sheet, and converted into a white light. The white light may be separated into a blue light, a green light, and a red light by a color filter in the liquid crystal panel, and then emitted to the outside for each pixel. Referring to Fig. 4D, the backlight unit (BLU) may be a direct type of a BLU without a light guide plate, and may include a plurality of LEDs (e.g., mini LEDs) and a photoconversion sheet or a QD sheet may be disposed on the BLU.

The color conversion panel may include a substrate, and the color conversion layer may be disposed on the substrate. The color conversion layer or the color conversion panel may include a patterned film of the nanoparticle composite. The patterned film may include a repeating section that is configured to emit light of a desired wavelength. The repeating section may include a second region. The second region may be a red light-emitting section. The repeating section may include a first region. The first region may be a green light-emitting section. The repeating section may include a third region. The third region may include a section that emits or transmits a blue light. Details of the first, second, and third regions are as described herein.

The light emitting panel or the light source may be an element emitting an incident light (e.g., an excitation light). The incident light may include a blue light, and, optionally, a green light. The light source may include an LED. The light source may include an organic LED (OLED). The light source may include a micro LED. On the front surface (light emitting surface) of the first region and the second region, an optical element to block (e.g., reflect or absorb) a blue light (and optionally a green light) for example, a blue light (and optionally a green light) blocking layer or a first optical filter that will be described herein may be disposed. In an embodiment, the light source may include an organic light emitting diode to emit a blue light and an organic light emitting diode to emit a green light, and a green light removing filter may be further disposed on a third region through which a blue light is transmitted.

The light emitting panel or the light source may include a plurality of light emitting units respectively corresponding to the first region and the second region, and the light emitting units may include a first electrode and a second electrode facing each other, and an (organic) electroluminescent layer located between the first electrode and the second electrode. The electroluminescent layer may include an organic light emitting material. For example, each light emitting unit of the light source may include an electroluminescent device (e.g., an organic light emitting diode (OLED)) structured to emit light of a predetermined wavelength (e.g., a blue light, a green light, or a combination thereof). Structures and materials of the electroluminescent device and the organic light emitting diode (OLED) are not particularly limited.

Hereinafter, the display panel and the color conversion panel will be described in further detail with reference to

the drawings.

Referring to FIGS. 4A and 4C, the display panel 1000 according to an embodiment may include a light emitting panel 40 and a color conversion panel 50. The display panel or the electronic device may further include a light transmitting layer 60 disposed between the light emitting panel 40 and the color conversion panel 50, and a binding material 70 binding the light emitting panel 40 and the color conversion panel 50. The light transmitting layer may include a passivation layer, a filling material, an encapsulation layer, or a combination thereof (not shown). A material for the light transmitting layer may be appropriately selected without particular limitation. The material for the light transmitting layer may be an inorganic material, an organic material, an organic/inorganic hybrid material, or a combination thereof.

The light emitting panel 40 and the color conversion panel 50 each may have a surface opposite the other, i.e., the two respective panels may face each other, with the light transmitting layer (or the light transmitting panel) 60 disposed between the two panels. The color conversion panel 50 may be disposed in a direction such that for example, light emitting from the light emitting panel 40 may irradiate the light transmitting layer 60. The binding material 70 may be disposed along edges of the light emitting panel 40 and the color conversion panel 50, and may be, for example, a sealing material.

FIG. 5A is a plan view of an embodiment of a pixel arrangement of a display panel. Referring to FIG. 5A, the display panel 1000 may include a display area 1000D displaying an image and a non-display area 1000P positioned in a peripheral area of the display area 1000D and disposed with a binding material.

The display area 1000D may include a plurality of pixels PX arranged along a row (e.g., an x direction), and a column (e.g., a y direction), and each representative pixel PX may include a plurality of sub-pixels $PX_1$, $PX_2$, and $PX_3$ expressing, e.g., displaying, different colors from each other. An embodiment may be idealized with a structure in which three sub-pixels $PX_1$, $PX_2$, and $PX_3$ are configured to provide a pixel. An embodiment may further include an additional sub-pixel, such as a white sub-pixel, and may further include, e.g., at least one, sub-pixel expressing, e.g., displaying the same colors. The plurality of pixels PX may be aligned, for example, in a Bayer matrix, a matrix sold under the trade designation PenTile, a diamond matrix, or the like, or a combination thereof.

The sub-pixels $PX_1$, $PX_2$, and $PX_3$ may express, e.g., display, three primary colors or a color of a combination of three primary colors, for example, may express, e.g., display, a color of red, green, blue, or a combination thereof. For example, the first sub-pixel $PX_1$ may express, e.g., display, a red color, and the second sub-pixel $PX_2$ may express, e.g., display, a green color, and the third sub-pixel $PX_3$ may express, e.g., display, a blue color.

In the drawing, all sub-pixels are idealized to have the same size, but these are not limited thereto, and at least one of the sub-pixels may be larger or smaller than other sub-pixels. In the drawing, all sub-pixels are idealized to have the same shape, but it is not limited thereto and at least one of the sub-pixels may have different shape from the other sub-pixels.

In the display panel or electronic device according to an embodiment, the light emitting panel may include a substrate and a TFT (e.g., an oxide-containing TFT, or the like) disposed on the substrate. A light emitting device (e.g., having a tandem structure, or the like) may be disposed on the TFT.

The light emitting device may include a light emitting layer (e.g., a blue light emitting layer, a green light emitting layer, or a combination thereof) located between the first electrode and the second electrode facing each other. A charge generation layer may be disposed between each of the light emitting layers. Each of the first electrode and the second electrode may be patterned with a plurality of electrode elements to correspond to the pixel. The first electrode may be an anode or a cathode. The second electrode may be a cathode or an anode.

The light emitting device may include an organic LED, a nanorod LED, a mini LED, a micro LED, or a combination thereof.

FIGS. 5B to 5E are cross-sectional views showing light emitting devices of an embodiment, respectively. In an embodiment, "a mini LED" may have a size of greater than or equal to about 100 micrometers, greater than or equal to about 150 micrometers, or greater than or equal to about 200 micrometers and less than or equal to about 1 millimeter, less than or equal to about 0.5 millimeters, less than or equal to about 0.15 millimeters, or less than or equal to about 0.12 millimeters, but is not limited thereto. In an embodiment, "a micro LED" may have a size of less than about 100 micrometers, less than or equal to about 50 micrometers, or less than or equal to about 10 micrometers. The size of the micro LED may be greater than or equal to about 0.1 micrometers, greater than or equal to about 0.5 micrometers, greater than or equal to about 1 micrometer, or greater than or equal to about 5 micrometers, but is not limited thereto.

Referring to FIG. 5B, the light emitting device 180 may include a first electrode 181 and a second electrode 182 facing each other; a light emitting layer 183 located between the first electrode 181 and the second electrode 182; and optionally auxiliary layers 184 and 185 located between the first electrode 181 and the light emitting layer 183, and located between the second electrode 182 and the light emitting layer 183, respectively.

The first electrode 181 and the second electrode 182 may be disposed to face each other along a thickness direction (for example, a z direction), and any one of the first electrode 181 and the second electrode 182 may be an anode and the other may be a cathode. The first electrode 181 may be a light transmitting electrode, a semi-transparent electrode, or a reflective electrode, and the second electrode 182 may be a light transmitting electrode or a semi-transparent electrode. The light transmitting electrode or semi-transparent electrode may be, for example, made of a thin single layer or

multiple layers of a metal thin film including conductive metal oxides, such as indium tin oxide (ITO), indium zinc oxide (IZO), zinc oxide (ZnO), tin oxide (SnO), aluminum tin oxide (AlTO), fluorine-doped tin oxide (FTO), or the like; or silver (Ag), copper (Cu), aluminum (Al), magnesium (Mg), magnesium-silver (Mg-Ag), magnesium-aluminum (Mg-Al), or a combination thereof. The reflective electrode may include a metal, a metal nitride, or a combination thereof, for example, silver (Ag), copper (Cu), aluminum (Al), gold (Au), titanium (Ti), chromium (Cr), nickel (Ni), an alloy thereof, a nitride thereof (e.g., TiN), or a combination thereof, but embodiments are not limited thereto.

The light emitting layer(s) 183 may include a first light emitting body emitting light with a blue emission spectrum, a second light emitting body emitting light with a green emission spectrum, or a combination thereof.

The blue emission spectrum may have a peak emission wavelength in a wavelength region of greater than or equal to about 400 nm to less than about 500 nm and within the range, in a wavelength region of about 410 nm to about 490 nm, about 420 nm to about 480 nm, about 430 nm to about 470 nm, about 440 nm to about 465 nm, about 445 nm to about 460 nm, or about 450 nm to about 458 nm.

The green emission spectrum may have a peak emission wavelength in a wavelength region of greater than or equal to about 500 nm to less than about 590 nm and within the range, in a wavelength region of about 510 nm to about 580 nm, about 515 nm to about 570 nm, about 520 nm to about 560 nm, about 525 nm to about 555 nm, about 530 nm to about 550 nm, or about 535 nm to about 545 nm.

For example, the light emitting layers 183 or the light emitting body included therein may include a phosphorescent material, a fluorescent material, or a combination thereof. For example, the light emitting body may include an organic light emitting body, wherein the organic light emitting body may be a low molecular compound, a polymer compound, or a combination thereof. Specific types of the phosphorescent material and the fluorescent material are not particularly limited but may be appropriately selected from known materials. For example, the light emitting body may include an inorganic light emitting body, and the inorganic light emitting body may be an inorganic semiconductor, a quantum dot, a perovskite, or a combination thereof. The inorganic semiconductor may include metal nitride, metal oxide, or a combination thereof. The metal nitride, the metal oxide, or the combination thereof may include a Group III metal, such as aluminum, gallium, indium, thallium, or the like, a Group IV metal or semimetal such as silicon, germanium, tin, or a combination thereof. In an embodiment, the light emitting body may include an inorganic light emitting body, and the light emitting device 180 may be a quantum dot light emitting diode, a perovskite light emitting diode, or a micro light emitting diode ($\mu$LED). Materials usable as the inorganic light emitting body may be selected appropriately.

In an embodiment, the light emitting device 180 may further include an auxiliary layer 184 and 185. The auxiliary layer 184 and 185 may be disposed between a first electrode 181 and a light emitting layer 183, and between a second electrode 182 and a light emitting layer 183, respectively. The auxiliary layer 184 and 185 may be a charge auxiliary layer for controlling injection and/or mobility of charges. The auxiliary layers 184 and 185 may include at least one layer or two layers, and for example, may include a hole injection layer, a hole transport layer, an electron blocking layer, an electron injection layer, an electron transport layer, a hole blocking layer, or a combination thereof. At least one of the auxiliary layers 184 and 185 may be omitted, if desired. The auxiliary layer may be formed of a material appropriately selected from materials known for an organic electroluminescent device, or the like.

The light emitting devices 180 disposed in each of the subpixels $PX_1$, $PX_2$, and $PX_3$ may be the same or different from each other. The light emitting devices 180 in each of the subpixels $PX_1$, $PX_2$, and $PX_3$ may emit a light having the same or different emission spectra. The light emitting devices 180 in each of the subpixels $PX_1$, $PX_2$, and $PX_3$ may emit, for example, light having a blue emission spectrum, light having a green emission spectrum, or a combination thereof. The light emitting devices 180 in each of the subpixels $PX_1$, $PX_2$, and $PX_3$ may be separated by a pixel defining layer (not shown).

Referring to FIG. 5C, the light emitting device 180 may be a light emitting device having a tandem structure, and may include a first electrode 181 and a second electrode 182 facing each other; a first light emitting layer 183a and a second light emitting layer 183b located between the first electrode 181 and the second electrode 182; a charge generation layer 186 located between the first light emitting layer 183a and the second light emitting layer 183b; and optionally auxiliary layers 184 and/or 185 located between the first electrode 181 and the first light emitting layer 183a, and/or between the second electrode 182 and the second light emitting layer 183b, respectively.

Details of the first electrode 181, the second electrode 182, and the auxiliary layers 184 and 185 are as described herein.

The first light emitting layer 183a and the second light emitting layer 183b may emit a light having the same or different emission spectra. In an embodiment, the first light emitting layer 183a or the second light emitting layer 183b may emit light having a blue emission spectrum or light having a green emission spectrum, respectively. The charge generation layer 186 may inject an electric charge into the first light emitting layer 183a and/or the second light emitting layer 183b, and may control a charge balance between the first light emitting layer 183a and the second light emitting layer 183b. The charge generation layer 186 may include, for example, an n-type layer and a p-type layer, and may include, for example, an electron transport material and/or a hole transport material including an n-type dopant and/or a p-type dopant. The charge generation layer 186 may include one layer or two or more layers.

Referring to FIG. 5D, a light emitting device (having a tandem structure) may include a first electrode 181 and a second electrode 182 facing each other; a first light emitting layer 183a, a second light emitting layer 183b, and a third light emitting layer 183c located between the first electrode 181 and the second electrode 182; a first charge generation layer 186a located between the first light emitting layer 183a and the second light emitting layer 183b; a second charge generation layer 186b located between the second light emitting layer 183b and the third light emitting layer 183c; and optionally, auxiliary layers 184 and/or 185 located between the first electrode 181 and the first light emitting layer 183a, and/or between the second electrode 182 and the third light emitting layer 183c, respectively.

Details of the first electrode 181, the second electrode 182, and the auxiliary layers 184 and 185 are as described herein.

The first light emitting layer 183a, the second light emitting layer 183b, and the third light emitting layer 183c may emit a light having the same or different emission spectra. The first light emitting layer 183a, the second light emitting layer 183b, and the third light emitting layer 183c may emit a blue light. In an embodiment, the first light emitting layer 183a and the third light emitting layer 183c may emit light of a blue emission spectrum, and the second light emitting layer 183b may emit light of a green emission spectrum. In another embodiment, the first light emitting layer 183a and the third light emitting layer 183c may emit light of a green emission spectrum, and the second light emitting layer 183b may emit light of a blue emission spectrum.

The first charge generation layer 186a may inject an electric charge into the first light emitting layer 183a and/or the second light emitting layer 183b, and may control charge balances between the first light emitting layer 183a and the second light emitting layer 183b. The second charge generation layer 186b may inject an electric charge into the second light emitting layer 183b and/or the third light emitting layer 183c, and may control charge balances between the second light emitting layer 183b and the third light emitting layer 183c. Each of the first and second charge generation layers 186a and 186b may include one layer or two or more layers, respectively.

Referring to FIG. 5E, in an embodiment, the light emitting device 180 may include a light emitting layer 183, a first electrode 181, a second electrode 182, and a plurality of nanostructures 187 arranged in the light emitting layer 183.

One of the first electrode 181 and the second electrode 182 may be an anode and the other may be a cathode. The first electrode 181 and the second electrode 182 may be an electrode patterned according to a direction of an arrangement of the plurality of nanostructures 187, and may include, for example, a conductive oxide such as indium tin oxide (ITO), indium zinc oxide (IZO), zinc oxide (ZnO), tin oxide (SnO), aluminum tin oxide (AlTO), fluorine-doped tin oxide (FTO), or the like; or silver (Ag), copper (Cu), aluminum (Al), gold (Au), titanium (Ti), chromium (Cr), nickel (Ni), an alloy thereof, a nitride thereof (e.g., TiN); or a combination thereof, but embodiments are not limited thereto.

The light emitting layer 183 may include a plurality of nanostructures 187, and each of the subpixels $PX_1$, $PX_2$, and $PX_3$ may include a plurality of nanostructures 187. In an embodiment, the plurality of nanostructures 187 may be arranged in one direction, but embodiments are not limited thereto. The nanostructures 187 may be a compound-containing semiconductor that is configured to emit light of a predetermined wavelength for example with an application of an electric current, and may be, for example, a linear nanostructure, such as a nanorod or a nanoneedle. A diameter or a long diameter of the nanostructures 187 may be, for example, several nanometers to several hundreds of nanometers, and aspect ratios of the nanostructures 187 may be greater than about 1, greater than or equal to about 1.5, greater than or equal to about 2.0, greater than or equal to about 3.0, greater than or equal to about 4.0, greater than or equal to about 4.5 or greater than or equal to about 5.0 to less than or equal to about 20, for example, greater than about 1 to about 20, greater than or equal to about 1.5 to about 20, greater than or equal to about 2.0 to about 20, greater than or equal to about 3.0 to about 20, greater than or equal to about 4.0 to about 20, greater than or equal to about 4.5 to about 20, or greater than or equal to about 5.0 to about 20.

Each of the nanostructures 187 may include a p-type region 187p, an n-type region 187n, and a multiple quantum well region 187i, and may be configured to emit light from the multiple quantum well region 187i. The nanostructure 187 may include, for example, gallium nitride (GaN), indium gallium nitride (InGaN), aluminum gallium nitride (AlGaN), or a combination thereof, and may have, for example, a core-shell structure.

The plurality of nanostructures 187 may each emit light having the same or different emission spectra. In an embodiment, the nanostructure may emit light of a blue emission spectrum, for example, light of a blue emission spectrum having a peak emission wavelength in a wavelength region of greater than or equal to about 400 nm to less than 500 nm, about 410 nm to about 490 nm, or about 420 nm to about 480 nm.

FIG. 6 is a schematic cross-sectional view of a device (or a display panel) according to an embodiment. Referring to FIG. 6, the light source (or the light emitting panel) may include an organic light emitting diode that emits a blue light (B) (and optionally a green light (G)). The organic light emitting diode (OLED) may include at least two pixel electrodes 90a, 90b, 90c formed on the substrate 100, pixel defining layers 150a, 150b formed between the adjacent pixel electrodes 90a, 90b, 90c, organic light emitting layers 140a, 140b, 140c formed on each pixel electrode 90a, 90b, 90c, and a common electrode layer 130 formed on the organic light emitting layer 140a, 140b, 140c. A thin film transistor (TFT) and a substrate may be disposed under the organic light emitting diode (OLED), which are not shown. Pixel areas of the OLED may be disposed corresponding to the first, second, and third regions described herein. In an embodiment, the color conversion

panel and the light emitting panel may be separated as shown in FIG. 6. In an embodiment, the color conversion panel may be stacked directly on the light emitting panel.

A laminated structure including the semiconductor nanoparticle composite pattern 170 (e.g., a first region 11 or R including red light emitting semiconductor nanoparticle, a second region 21 or G including green light emitting semiconductor nanoparticle, and a third region 31 or B including or not including a semiconductor nanoparticle, e.g., a blue light emitting semiconductor nanoparticle) and the substrate 240 may be disposed on the light source. The blue light emitted from the light source may enter the first region and second region and may emit a red light and a green light, respectively. The blue light emitted from the light source may pass through the third region. An element (first optical filter 160 or excitation light blocking layer) configured to block the excitation light may be disposed between the semiconductor nanoparticle composite layers R and G and the substrate, if desired. In an embodiment, the excitation light may include a blue light and a green light, and a green light blocking filter (not shown) may be added to the third region. The first optical filter or the excitation light blocking layer will be described in more detail herein.

Such a (display) device may be produced by separately producing the aforementioned laminated structure and LED or OLED (e.g., emitting a blue light) and then combining the laminated structure and LED or OLED. The (display) device may be produced by directly forming the semiconductor nanoparticle composite pattern on the LED or OLED.

In the color conversion panel or a display device, a substrate may be a substrate including an insulation material. The substrate may include glass; a polymer, such as a polyester (e.g., poly(ethylene terephthalate) (PET), poly(ethylene naphthalate) (PEN), or the like), a polycarbonate, a polyacrylate; a polysiloxane (e.g., polydimethylsiloxane (PDMS), or the like); an inorganic material such as $Al_2O_3$, ZnO, or the like; or a combination thereof, but embodiments are not limited thereto. A thickness of the substrate may be appropriately selected taking into consideration a substrate material but is not particularly limited. The substrate may have flexibility. The substrate may have a transmittance of greater than or equal to about 50%, greater than or equal to about 60%, greater than or equal to about 70%, greater than or equal to about 80%, or greater than or equal to about 90% for light emitted from the semiconductor nanoparticle.

A wire layer including a thin film transistor or the like may be formed on the substrate. The wire layer may further include a gate line, a sustain voltage line, a gate insulating film, a data line, a source electrode, a drain electrode, a semiconductor layer, a protective layer, or the like. The detailed structure of the wire layer may vary depending on an embodiment. The gate line and the sustain voltage line may be electrically separated from each other, and the data line may be insulated, crossing the gate line and the sustain voltage line. The gate electrode, the source electrode, and the drain electrode may form a control terminal, an input terminal, and an output terminal of the thin film transistor, respectively. The drain electrode may be electrically connected to the pixel electrode that will be described herein.

The pixel electrode may function as an electrode (e.g., anode) of the display device. The pixel electrode may be formed of a transparent conductive material, such as indium tin oxide (ITO) or indium zinc oxide (IZO). The pixel electrode may be formed of a material having a light blocking property, such as gold (Au), platinum (Pt), nickel (Ni), tungsten (W), chromium (Cr), molybdenum (Mo), iron (Fe), cobalt (Co), copper (Cu), palladium (Pd), or titanium (Ti). The pixel electrode may have a two-layered structure where the transparent conductive material and the material having light blocking properties are stacked sequentially.

Between two adjacent pixel electrodes, a pixel define layer (PDL) may overlap with a terminal end of the pixel electrode to divide the pixel electrode into a pixel unit. The pixel define layer is an insulating layer which may electrically block the at least two pixel electrodes.

The pixel define layer may cover a portion of the upper surface of the pixel electrode, and the remaining region of the pixel electrode where it is not covered by the pixel define layer may provide an opening. An organic light emitting layer that will be described herein may be formed on the region defined by the opening.

The organic light emitting layer may define each pixel area by the aforementioned pixel electrode and the pixel define layer. In other words, one pixel area may be defined as an area where it is formed with one organic light emitting unit layer which is contacted with one pixel electrode divided by the pixel define layer. In the display device according to an embodiment, the organic light emitting layer may be defined as a first pixel area, a second pixel area, and a third pixel area, and each pixel area may be spaced apart from each other leaving a predetermined interval by the pixel define layer.

In an embodiment, the organic light emitting layer may emit a third light belonging to a visible light region or belonging to an ultraviolet (UV) region. Each of the first to the third pixel areas of the organic light emitting layer may emit a third light. In an embodiment, the third light may be a light having a higher energy in a visible light region, and for example, may be a blue light (and optionally a green light). In an embodiment, all pixel areas of the organic light emitting layer may be designed to emit the same light, and each pixel area of the organic light emitting layer may be formed of materials that are the same or similar or may show the same or similar properties. Thus, a process of forming the organic light emitting layer may be simplified, and the display device may be easily applied for, e.g., made by, a large scale/large area process. However, the organic light emitting layer according to an embodiment is not necessarily limited thereto, but the organic light emitting layer may be designed to emit at least two different lights, e.g., at least two different colored lights.

The organic light emitting layer may include an organic light emitting unit layer in each pixel area, and each organic light emitting unit layer may further include an auxiliary layer (e.g., a hole injection layer, a hole transport layer, an

electron transport layer, or the like) besides the light emitting layer.

The common electrode may function as a cathode of the display device. The common electrode may be formed of a transparent conductive material, such as indium tin oxide (ITO) or indium zinc oxide (IZO). The common electrode may be formed on the organic light emitting layer and may be integrated therewith.

A planarization layer or a passivation layer (not shown) may be formed on the common electrode. The planarization layer may include a (e.g., transparent) insulating material for ensuring electrical insulation with the common electrode.

In an embodiment, the display device may further include a lower substrate, a polarizing plate disposed under the lower substrate, and a liquid crystal layer disposed between the laminated structure and the lower substrate, and in the laminated structure, the photoluminescence layer (i.e., light emitting layer) may be disposed to face the liquid crystal layer. The display device may further include a polarizing plate located between the liquid crystal layer and the light emitting layer. The light source may further include LED, and, if desired, a light guide plate.

In an embodiment, the display device (e.g., a liquid crystal display device) are illustrated with a reference to a drawing. FIG. 7A is a schematic cross-sectional view showing a liquid crystal display device according to an embodiment. Referring to FIG. 7A, the display device of an embodiment may include a liquid crystal panel 200, a polarizing plate 300 disposed under the liquid crystal panel 200, and a backlight unit disposed under the polarizing plate 300.

The liquid crystal panel 200 may include a lower substrate 210, a stacked structure, and a liquid crystal layer 220 disposed between the stack structure and the lower substrate. The stack structure may include a transparent substrate 240, a first optical filter layer 310, a photoluminescent layer 230 including a pattern of a semiconductor nanoparticle polymer composite, and a second optical filter layer 311.

The lower substrate 210, also referred to as an array substrate, may be a transparent insulating material substrate. The substrate may be as described herein. A wire plate 211 may be provided on an upper surface of the lower substrate 210. The wire plate 211 may include a plurality of gate wires (not shown) and data wires (not shown) that define a pixel area, a thin film transistor disposed adjacent to a crossing region of gate wires and data wires, and a pixel electrode for each pixel area, but embodiments are not limited thereto. Details of such a wire plate are not particularly limited.

A liquid crystal layer 220 may be provided on the wire plate 211. The liquid crystal panel 200 may include an alignment layer 221 on and under the liquid crystal layer 220 to initially align the liquid crystal material included therein. Details (e.g., a liquid crystal material, an alignment layer material, a method of forming liquid crystal layer, a thickness of liquid crystal layer, or the like) of the liquid crystal layer and the alignment layer are not particularly limited.

A lower polarizing plate 300 may be provided under the lower substrate. Materials and structures of the polarizing plate 300 are not particularly limited. A backlight unit (e.g., emitting a blue light) may be disposed under the polarizing plate 300. An upper optical element or the polarizing plate 300 may be provided between the liquid crystal layer 220 and the transparent substrate 240, but is not limited thereto. For example, the upper polarizing plate may be disposed between the liquid crystal layer 220 and the photoluminescent layer 230. The polarizing plate may be any polarizer that can be used in a liquid crystal display device. The polarizing plate may be triacetyl cellulose (TAC) having a thickness of less than or equal to about 200 $\mu$m, but is not limited thereto. In another embodiment, the upper optical element may be a coating that controls a refractive index without a polarization function.

The backlight unit may include a light source 110. The light source may emit a blue light or a white light. The light source may include, but is not limited to, a blue LED, a white LED, a white OLED, or a combination thereof.

The backlight unit may further include a light guide plate 120. In an embodiment, the backlight unit may be of an edge type. For example, the backlight unit may include a reflector (not shown), a light guide plate (not shown) provided on the reflector and providing a planar light source to the liquid crystal panel 200, and/or at least one optical sheet (not shown) on the light guide plate, for example, a diffusion plate, a prism sheet, and the like, but the present disclosure is not limited thereto. The backlight unit may not include a light guide plate. In an embodiment, the backlight unit may be direct lighting. For example, the backlight unit may have a reflector (not shown) and a plurality of fluorescent lamps on the reflector at regular intervals, or may have an LED operating substrate on which a plurality of light emitting diodes, a diffusion plate thereon, and optionally at least one optical sheet may be disposed. Details (e.g., each component of a light emitting diode, a fluorescent lamp, a light guide plate, various optical sheets, and a reflector) of such a backlight unit are known and are not particularly limited.

A black matrix 241 may be provided under the transparent substrate 240 and may have openings and hide a gate line, a data line, and a thin film transistor of the wire plate on the lower substrate. For example, the black matrix 241 may have a grid shape. The photoluminescent layer 230 may be provided in the opening of the black matrix 241 and has a nanoparticle-polymer composite pattern including a first region R configured to emit a first light (e.g., a red light), a second region G configured to emit a second light (e.g., a green light), and a third region B configured to emit/transmit a third light, for example a blue light. If desired, the photoluminescent layer may further include at least a fourth region. The fourth region may include a quantum dot that emits light of a different color from the light emitted from the first to third regions (e.g., cyan, magenta, and yellow light).

In the photoluminescent layer 230, sections forming the pattern may be repeated corresponding to pixel areas

formed on the lower substrate. A transparent common electrode 231 may be provided on the photoluminescent layer 230.

The third region (B) configured to emit/transmit a blue light may be a transparent color filter that does not change the emission spectrum of the light source. In this case, the blue light emitted from the backlight unit may enter in a polarized state and may be emitted through the polarizing plate and the liquid crystal layer as is. If needed, the third region may include a quantum dot emitting a blue light.

As described herein, if desired, the display device or light emitting device according to an embodiment may further include an excitation light blocking layer or a first optical filter layer (hereinafter, referred to as a first optical filter layer). The first optical filter layer may be disposed between the bottom surface of the first region (R) and the second region (G) and the substrate (e.g., the upper substrate 240) or on the upper surface of the substrate. The first optical filter layer may be a sheet having an opening in a portion corresponding to a pixel area (third region) displaying blue, and thus may be formed in portions corresponding to the first and second regions. That is, the first optical filter layer may be integrally formed at positions other than the position overlapped with the third region as shown in FIGS. 3A, 3B, 6 and/or 7A, but is not limited thereto. Two or more first optical filter layers may be spaced apart from each other at positions overlapped with the first and second regions, and optionally, the third region. When the light source includes a green light emitting device, a green light blocking layer may be disposed on the third region.

The first optical filter layer may block light, for example, in a predetermined wavelength region in the visible light region and may transmit light in the other wavelength regions, and for example, it may block a blue light (or a green light) and may transmit light except the blue light (or the green light). The first optical filter layer may transmit, for example, a green light, a red light, and/or a yellow light that is a mixed color thereof. The first optical filter layer may transmit a blue light and block a green light, and may be disposed on the blue light emitting pixel.

The first optical filter layer may substantially block excitation light and transmit light in a desired wavelength region. The transmittance of the first optical filter layer for the light in a desired wavelength range may be greater than or equal to about 70%, greater than or equal to about 80%, greater than or equal to about 90%, or even about 100%.

The first optical filter layer configured to selectively transmit a red light may be disposed at a position overlapped with the red light emitting section, and the first optical filter layer configured to selectively transmit a green light may be disposed at a position overlapped with the green light emitting section. The first optical filter layer may include a first filter region that blocks (e.g., absorbs) the blue light and the red light and selectively transmits light of a predetermined range (e.g., greater than or equal to about 500 nm, greater than or equal to about 510 nm, or greater than or equal to about 515 nm to less than or equal to about 550 nm, less than or equal to about 545 nm, less than or equal to about 540 nm, less than or equal to about 535 nm, less than or equal to about 530 nm, less than or equal to about 525 nm, or less than or equal to about 520 nm); a second filter region that blocks (e.g., absorbs) a blue light and a green light and selectively transmits light of a predetermined range (e.g., greater than or equal to about 600 nm, greater than or equal to about 610 nm, or greater than or equal to about 615 nm to less than or equal to about 650 nm, less than or equal to about 645 nm, less than or equal to about 640 nm, less than or equal to about 635 nm, less than or equal to about 630 nm, less than or equal to about 625 nm, or less than or equal to about 620 nm); or the first filter region and the second filter region. In an embodiment, the light source may emit a blue and a green mixed light, and the first optical filter layer may further include a third filter region that selectively transmits a blue light and blocks a green light.

The first filter region may be disposed at a position overlapped with the green light emitting section. The second filter region may be disposed at a position overlapped with the red light emitting section. The third filter region may be disposed at a position overlapped with the blue light emitting section.

The first filter region, the second filter region, and, optionally, the third filter region may be optically isolated. Such a first optical filter layer may contribute to improvement of color purity of the display device.

The display device may further include a second optical filter layer (e.g., a recycling layer of red/green light or yellow light) that is disposed between the photoluminescent layer and the liquid crystal layer (e.g., between the photoluminescent layer and the upper polarizing plate), transmits at least a portion of the third light (excitation light), and reflects at least a portion of the first light and/or the second light. The first light may be a red light, the second light may be a green light, and the third light may be a blue light. The second optical filter layer may transmit only the third light (B) in a blue light wavelength region having a wavelength region of less than or equal to about 500 nm and light in a wavelength region of greater than about 500 nm, which is green light (G), yellow light, red light (R), or the like, may be not passed through the second optical filter layer and reflected. The reflected green light and red light may pass through the first and second regions to be emitted to the outside of the display device.

The second optical filter layer or the first optical filter layer may be formed as an integrated layer having a relatively planar surface.

The first optical filter layer may include a polymer thin film including a dye and/or a pigment absorbing light in a wavelength which is to be blocked. The second optical filter layer or the first optical filter layer may include a single layer having a low refractive index, and may be, for example, a transparent thin film having a refractive index of less than or equal to about 1.4:1, less than or equal to about 1.3, or less than or equal to about 1.2. The second optical filter layer or the first optical filter layer having a low refractive index may include, for example, a porous silicon oxide, a porous organic material,

a porous organic-inorganic composite, or the like, or a combination thereof.

The first optical filter layer or the second optical filter layer may include a plurality of layers having different refractive indexes. The first optical filter layer or the second optical filter layer may be formed by laminating two layers having different refractive indexes. For example, the first/second optical filter layer may be formed by alternately laminating a material having a high refractive index and a material having a low refractive index.

In an embodiment, a method of manufacturing an electronic device may include obtaining (or providing) a light emitting panel; obtaining (or providing) a color conversion panel including the color conversion layer; and combining the light emitting panel and the color conversion panel. (See FIG. 7B)

In an embodiment, the electronic device may include a light emitting device (e.g., an electroluminescent device) including the nanoparticles described above. FIG. 7C is a schematic cross-sectional view of a light emitting device (electroluminescent device) according to an embodiment. Referring to FIG. 7C, the light emitting device may include an anode 1 and a cathode 5 facing each other; a quantum dot light emitting layer 3 disposed between the anode and the cathode, including a plurality of quantum dots; and a hole auxiliary layer 2 located between the anode and the quantum dot light emitting layer. The hole auxiliary layer may further include a hole injecting layer (HIL), a hole transporting layer (HTL), an electron blocking layer (EBL), or a combination thereof. The hole auxiliary layer may include any organic/inorganic material having hole characteristics. The quantum dot light emitting device may further include an electron auxiliary layer 4 located between the cathode and the quantum dot light emitting layer. The electron auxiliary layer may include an electron injecting layer (EIL), an electron transporting layer (ETL), a hole blocking layer (HBL), or a combination thereof. The electron auxiliary layer may include any organic/inorganic material having electronic properties.

Hereinafter, the exemplary embodiments are illustrated in further detail with reference to examples. However, embodiments of the present disclosure are not limited to the examples.

EXAMPLES

Analysis Methods

[1] Photoluminescence Analysis

A photoluminescence (PL) spectrum of the nanoparticles produced and a composite including the same was obtained using a Hitachi F-7000 spectrophotometer at an excitation wavelength of 450 nm.

[2] ICP-AES Analysis

Inductively coupled plasma atomic emission spectroscopy (ICP-AES) analysis was performed using a Shimadzu ICPS-8100.

[3] Blue Light Absorbance, Quantum efficiency, and Light Conversion Efficiency (CE) of the composite

An amount of incident light of a wavelength of 450 nm (B) was measured by using an integrating sphere or an integrating hemisphere of an absolute quantum efficiency-measuring device (e.g., QE-2100, Otsuka Electronics Co., Ltd.). Subsequently, a semiconductor nanoparticle (quantum dot, QD) polymer composite was placed in the integrating (hemi)sphere, and then, the incident light was irradiated to measure an amount of first light from the composite (A), and an amount of the incident light passing the composite (B'), respectively.

Using the measured amounts, an incident light absorbance, the light conversion efficiency (for example, an internal quantum efficiency) and a quantum efficiency (for example, an external quantum efficiency) were calculated according to Equation 2, Equation 3 and Equation 6:

$$\text{Equation 2:} \quad \text{Internal Quantum efficiency (\%)} = [A/(B-B')] \times 100\%$$

$$\text{Equation 3:} \quad \text{External Quantum efficiency (\%)} = [A/B] \times 100\%$$

$$\text{Equation 6:} \quad \text{Incident light absorbance (\%)} = [(B-B')/B] \times 100\%$$

wherein, in Equation 2, Equation 3 and Equation 6,

A is an amount of a first light emitted from the first composite,

B is an amount of incident light provided to the first composite, and
B' is an amount of incident light passing through the first composite.

[4] Process Maintenance Percentage (i.e., process retention rate)

The semiconductor nanoparticle-polymer composite obtained by polymerization was heat-treated at 180°C for 30 minutes, and a process maintenance percentage was measured according to the following equation (Equation 4):

Equation 4

$$\text{Process Maintenance percentage (\%)} = [IQE2/IQE1] \times 100\%$$

wherein in Equation 4, IQE1 is the internal quantum efficiency of the semiconductor nanoparticle-polymer composite before the heat treatment after polymerization, and IQE2 is the internal quantum efficiency of the semiconductor nanoparticle-polymer composite after heat treatment.

[5] TGA-Mass Analysis

(1) TGA was performed under nitrogen gas using a Trios V3.2 system (TA Instruments) at a heating rate of 10 °C/min from 25 °C to 600 °C. The weight loss from 25 °C to 600 °C was measured as an organic content.
(2) Mass spectrometry was performed using Process Eye Professional (MKS Instruments).

[6] TEM Analysis

Transmission electron microscopy images of the prepared nanocrystals were obtained using a Tecnai F30 electron microscope.

[7] UV-Vis Absorption Spectrum Analysis

UV-Vis absorption spectrum analysis was performed using a UV-Vis spectrophotometer (Cary 5000, Agilent Technologies).

[8] XRD Analysis

XRD analysis was performed using a Philips X'Pert PRO instrument at 3 kilowatts (kW) power.

[9] XPS Analysis

XPS analysis was performed at 0.4 eV using a VersaProbe instrument.

Example 1:

[1] Formation of a first semiconductor nanocrystal (or core)

Sulfur was dissolved in oleylamine to prepare a 1 molar (M) sulfur precursor solution (hereinafter, abbreviated as "sulfur precursor"). In a 100 milliliters (mL) reaction flask, octadecene (ODE), oleylamine, silver acetate, indium acetate, and gallium acetylacetonate were added and vacuum-treated at room temperature for 10 minutes. Nitrogen gas is introduced into the reaction flask, and the sulfur precursor and dodecanethiol were added to the flask. The flask was heated at a reaction temperature of 210°C, and a reaction proceeded for 60 minutes. After decreasing the temperature of the flask to 180°C, trioctylphosphine (TOP) was added to the flask. Afterward, the mixture was cooled to room temperature and ethanol (a non-solvent) were added to facilitate precipitation. The obtained first semiconductor nanocrystals (or core) were separated and recovered by centrifugation and re-dispersed in toluene.
The molar ratio of the silver precursor, the indium precursor, the gallium precursor, and the sulfur precursor used was 0.8: about 1:1.1:4.

[2] Formation, Separation, and Washing of the first particle

Gallium bromide was dissolved in trioctylphosphine to prepare a 1 molar (M) gallium precursor solution (hereinafter referred to as the first gallium precursor). A dispersion of a silver compound was prepared by dispersing a silver compound (silver acetate, 0.06 M) in oleylamine.

In a flask, dimethylthiourea (DMTU) as a first sulfur precursor, oleylamine, and octadecene were added, and vacuum-treated at 120°C for 10 minutes. After replacing the atmosphere inside the reaction flask with $N_2$, the mixture was heated to 240°C (first injection temperature), followed by the addition of the first gallium precursor, a first semiconductor nanocrystal, and the dispersion of the silver compound. Then, the reaction mixture was heated to 260°C (first reaction temperature) and reacted for 180 minutes (first reaction time). The reaction solution was cooled to 180°C, and trioctylphosphine was added. Afterward, the mixture was cooled to room temperature. An antisolvent (ethanol) was added to the room-temperature reaction mixture to promote precipitation of the resulting first particles. The obtained first particles were collected by centrifugation and redispersed in toluene. Precipitation and separation (centrifugation) were repeated using ethanol as a washing solvent.

The silver compound was used in an amount of approximately 4 mol% relative to the gallium precursor. The mole ratio of the first gallium precursor to the first sulfur precursor was 0.72:1 (gallium precursor : sulfur precursor).

[3] Gallium bromide and gallium chloride were each dissolved in a trioctylphosphine solution to prepare 1 M solutions (hereinafter, the second gallium precursor). A silver compound dispersion was prepared by dispersing a silver compound (silver acetate, 0.06 M) in oleylamine.

Dimethylthiourea (DMTU) as a second sulfur precursor, oleylamine, and octadecene were placed into a flask and vacuum-treated at 120°C for 10 minutes. After replacing the atmosphere in the reaction flask with $N_2$, the mixture was heated to 240 °C (second injection temperature), and then the second gallium precursor, the first particles, and the silver compound dispersion were added. Thereafter, the reactor was heated to 260 °C (second reaction temperature) and reacted for 200 minutes. The reactor temperature was lowered to 180 °C and trioctylphosphine was added, and then the mixture was cooled to room temperature to obtain a crude solution including semiconductor nanoparticles.

The silver compound was used in an amount of approximately 5 mol% relative to the gallium precursor. In the second gallium precursor, the amount of gallium chloride per 1 mol of gallium bromide was approximately 0.3 moles.

The molar ratio of the second gallium precursor to the second sulfur precursor used was 0.75:1 (second gallium precursor : sulfur precursor). The amount of the second gallium precursor was approximately 0.81 mol per 1 mol of the first gallium precursor. Per 1 mol of the indium precursor added for core synthesis, the amount of the gallium precursor used in the subsequent process was set to approximately 388 moles.

[4] Trifluoroacetic acid ($CF_3COOH$, TFA, dipole moment 2.26 debye (D), supplier: Sigma-Aldrich) was added to the crude solution at room temperature in an amount of 10 mL per 100 mL of reaction solution (the content of semiconductor nanoparticles was approximately 0.28 g), and acid treatment was performed by stirring for 60 minutes.

Ethanol in an amount of 3 times the volume of the crude solution and toluene in an amount of 0.3 times the volume of the crude solution were added to the acid-treated crude solution to promote precipitation of the semiconductor nanoparticles, and washing was subsequently performed by stirring for 1 minute. The precipitated particles after washing were separated by centrifugation and dispersed in toluene.

ICP-AES analysis performed on the obtained final semiconductor nanoparticles confirmed that the molar ratio of gallium to indium was approximately 22:1.

Photoluminescence spectroscopy analysis was performed on each of the acid-treated crude solution (before washing) and the toluene dispersion (after washing), and the results are summarized in Table 1.

Comparative Example 1:

Except that acid treatment was not performed, semiconductor nanoparticles were obtained in the same manner as in Example 1.

ICP-AES analysis performed on the obtained final semiconductor nanoparticles confirmed that the molar ratio of gallium to indium was approximately 22:1.

Photoluminescence spectroscopy analysis was performed on each of the crude solution (before washing) and the toluene dispersion (after washing), and the results are summarized in Table 1.

Comparative Example 2

Except that acetic acid (AcOH, dipole moment 1.68 D) was used in place of trifluoroacetic acid to perform the acid treatment, semiconductor nanoparticles were obtained in the same manner as in Example 1.

Photoluminescence spectroscopy analysis was performed on each of the acid-treated crude solution (before washing) and the toluene dispersion (after washing), and the results are summarized in Table 1.

Comparative Example 3

Except that butyric acid (BTA, dipole moment 0.93 D) was used in place of trifluoroacetic acid to perform the acid treatment, semiconductor nanoparticles were obtained in the same manner as in Example 1.
Photoluminescence spectroscopy was performed on each of the acid-treated crude solution (before washing) and the toluene dispersion (after washing), and the results are summarized in Table 1.

Comparative Example 4

Except that oleic acid (OA, dipole moment 1.18 D) was used in place of trifluoroacetic acid to perform the acid treatment, semiconductor nanoparticles were obtained in the same manner as in Example 1.
Photoluminescence spectroscopy was performed on each of the acid-treated crude solution (before washing) and the toluene dispersion (after washing), and the results are summarized in Table 1.

Table 1

| | Acid compound | Crude solution | | After washing | |
|---|---|---|---|---|---|
| | | QY | Trap emission | QY | Trap emission |
| Comp. Example 1 | Not used | 78.2% | 9.2% | 76.2% | 8.5% |
| Comp. Example 2 | AcOH | 83.7% | 8.8% | 79.2% | 8.2% |
| Comp. Example 3 | BTA | 82.6% | 8.7% | 78.5% | 8.1% |
| Comp. Example 4 | OA | 82.5% | 8.6% | 78.1% | 8.2% |
| Example 1 | TFA | 92.1% | 5.5% | 90.2% | 5.1% |

QY: Quantum yield

From the results of Table 1, it can be confirmed that the semiconductor nanoparticles of Example 1 exhibit significantly improved luminous efficiency and significantly reduced trap emission compared with the semiconductor nanoparticles of Comparative Example 1 due to the acid treatment. In contrast, the semiconductor nanoparticles of Comparative Examples 2 to 4 may exhibit an increased luminous efficiency in the crude solution state by the acid treatment compared with the semiconductor nanoparticles of Comparative Example 1; however, the increased luminous efficiency was found to be drastically reduced by washing. In addition, it can be confirmed that the semiconductor nanoparticles of Comparative Examples 2 to 4 exhibit reduced trap emission by the acid treatment compared with Comparative Example 1; however, the trap emission of the semiconductor nanoparticles of Comparative Examples 2 to 4 is still significantly more than that of the semiconductor nanoparticles of Example 1.

Experimental Example 1: UV-Vis Absorption Spectroscopy

UV-Vis absorption spectrum analysis was performed on the semiconductor nanoparticles obtained in Comparative Example 1 and those obtained in Example 1, and the results were summarized in Table 2.

Table 2

| | Comp. Example 1 | Example 1 |
|---|---|---|
| A450 | 0.09 | 0.08 |
| A315 | 1.13 | 2.48 |
| A370 | 1.03 | 0.49 |
| A450/A315 | 0.08 | 0.03 |
| A450/A370 | 0.08 | 0.16 |

A450: absorbance at a wavelength of 450 nm (arbitrary unit (a.u.))
A315: absorbance at a wavelength of 315 nm (a.u.)
A370: absorbance at a wavelength of 370 nm (a.u.)

A450/A315: a value obtained by dividing absorbance at 450 nm with absorbance at 315 nm
A450/A370: a value obtained by dividing absorbance at 450 nm with absorbance at 370 nm

For AIGS QDs having a Ga:In ratio greater than 19:1, the UV spectrum in the crude state shows a peak near 370 nm due to Ga by-products, whereas after acid treatment the 370-nm by-product peak disappears and a peak at 315 nm is generated.

Experimental Example 2: TGA-Mass Analysis

TGA-Mass analysis was performed on the semiconductor nanoparticles obtained in Comparative Example 1 and Example 1, and the results were summarized in FIGS. 8A and 8B.
From the results of FIG. 8A, it can be confirmed that the semiconductor nanoparticles of Example 1 exhibit an increased residue content (82.22 wt%) and a reduced organic content due to the acid treatment compared with the nanoparticles of Comparative Example 1, and that a new peak is formed at 285.64°C along with a peak shift.
From the results of FIG. 8B, it can also be confirmed that a carboxylic acid fragment (m/z = 45) is detected between 250°C and 300°C.

Experimental Example 3: TEM Analysis

TEM analysis was performed on the semiconductor nanoparticles obtained in Comparative Example 1 and Example 1, and the results were summarized in FIGS. 9A and 9B, respectively.
From FIGS. 9A and 9B, it can be confirmed that, compared with the semiconductor nanoparticles of Comparative Example 1, the semiconductor nanoparticles of Example 1 show clearer lattice fringes in the TEM image because the surface by-products were reduced by the acid treatment.

Comparative Example 5

[1] A first semiconductor nanocrystal was prepared in the same manner as in Example 1.
[2] Gallium chloride was dissolved in trioctylphosphine to prepare a 1 M gallium precursor-containing solution (gallium precursor). A dispersion of a silver compound (silver acetate, 0.06 M) was prepared by dispersing the silver compound in oleylamine.
Dimethylthiourea (DMTU), oleylamine, and octadecene were placed in a flask and subjected to vacuum treatment at 120°C for 10 minutes. After replacing the atmosphere in the reaction flask with $N_2$, the mixture was heated to 240°C (a predetermined temperature), and the gallium precursor, the first semiconductor nanocrystal, and the silver compound dispersion were added. The reactor was then heated to 260°C and reacted for 200 minutes. The reaction mixture was cooled to 180°C, trioctylphosphine was added, and then the mixture was cooled to room temperature. A nonsolvent (ethanol) was added to promote precipitation of the resulting semiconductor nanoparticles, and the particles were recovered by centrifugation and redispersed in toluene.
The molar ratio of the gallium precursor to the sulfur precursor used was 0.72:1 (gallium precursor : sulfur precursor). The silver compound was used in an amount of approximately 5 mol% relative to the gallium precursor. Per 1 mol of the indium precursor used in the core synthesis, the amount of the gallium precursor used in the subsequent process was approximately 70 moles.
[3] ICP-AES analysis of the obtained final semiconductor nanoparticles confirmed that the Ga:In molar ratio was approximately 5:1.

Photoluminescence spectroscopy analysis confirmed that the quantum yield was 81%.

Experimental Example 4: Preparation of Composite and Comparison of Emission Efficiency

The semiconductor nanoparticle prepared in Example 1 or Comparative Example 5 was mixed with a binder (a quaternary copolymer of methacrylic acid, benzyl methacrylate, hydroxyethylmethacrylate, and styrene, having an acid value of 130 milligrams (mg) potassium hydroxide per gram (KOH/g), and a molecular weight of 8000 grams per mole) solution (in propylene glycol monomethyl ether acetate (PGMEA), at a concentration 30 wt%), to obtain a semiconductor nanoparticle-binder dispersion, respectively.
To each of semiconductor nanoparticle-binder dispersion, hexaacrylate with the following structure as a photopolymerizable monomer, an oxime-ester compound as an initiator, $TiO_2$ nanoparticle as a metal oxide fine particle,

and PGMEA were added and mixed together to provide a composition.

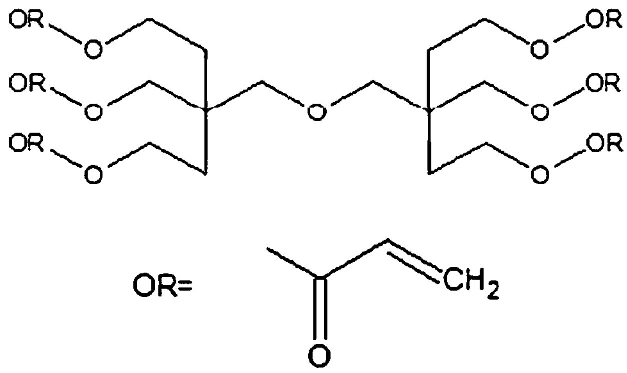

The compositions thus prepared included 20 wt% of semiconductor nanoparticles based on a total solid weight thereof, respectively.

The photosensitive composition was spin-coated onto a glass substrate at 600 rpm for 5 seconds to obtain a film. The obtained film was prebaked (PRB) at 100°C for 2 minutes. Light (wavelength: 395 nm; intensity: 4 J) was irradiated onto the prebaked film, and the film was then heat-treated (POB) at 180°C for 30 minutes to obtain a composite (thickness: approximately 7 μm).

It was confirmed that the composites including the semiconductor nanoparticles of the examples all exhibited an incident-light absorption rate of 90% or higher.

For the obtained composite thin film, process maintenance percentage was measured, and the results were summarized in Table 3 below.

Table 3

| Semiconductor nanoparticle in the composite | Process maintenance percentage |
|---|---|
| Example 1 | Greater than or equal to 98% (98% to 100%) |
| Comp. Example 5 | 75% |

From the results of Table 3, it can be confirmed that the semiconductor nanoparticles of the embodiments having a mole ratio of gallium to indium (Ga:In) of greater than or equal to about 20:1 can exhibit significantly higher process stability compared to the nanoparticles of Comparative Example 5 having a mole ratio of gallium to indium (Ga:In) of less than about 20:1 (e.g., 5:1).

Experimental Example 5: XRD analysis results

XRD analysis was performed on the semiconductor nanoparticles obtained in Example 1 and the semiconductor nanoparticles obtained in Comparative Example 1, and the results were shown in FIG. 10.

From the results of FIG. 10, it can be confirmed that the semiconductor nanoparticles of Comparative Example 1 include a plurality of Ga byproduct peaks (asterisks), whereas the nanoparticles obtained in Example 1 have such byproducts removed.

Experimental Example 6: XPS analysis results

XPS analysis was performed on the semiconductor nanoparticles obtained in Example 1 and the semiconductor nanoparticles obtained in Comparative Example 1, and the results were shown in FIGS. 11 to 15.

From the results of FIGS. 11 to 15, it can be confirmed that, in the semiconductor nanoparticles of Example 1, an F 1s peak (or its maximum intensity) appears at 687.37 eV. It can also be confirmed that the Ga, In, Ag, and S peaks exhibit a tendency of shifting in binding energy (e.g., a shift to higher energy).

The Ga 2p peak was confirmed to shift to a high binding energy (approximately 0.725 eV) due to the oxygen of TFA. The Ag 3d peak was confirmed to shift by 0.425 eV to a high binding energy. The sulfur peak (e.g., S 2p peak) was also confirmed to shift by 0.425 eV to a high binding energy.

In an embodiment, a method of preparing a semiconductor nanoparticle includes, in a medium including an organic solvent, combining a first semiconductor nanocrystal including silver, a Group 13 element, and a chalcogen

element or a first particle including the same; a sulfur precursor; and a gallium precursor; and

heating the medium to a reaction temperature to form a second semiconductor nanocrystal including sulfur and gallium on the first semiconductor nanocrystal or the first particle, and the method further includes adding an acid compound to the medium, wherein the acid compound has a dipole moment of greater than or equal to about 2 and less than or equal to about 5.

In an embodiment, the Group 13 element includes indium and gallium, the chalcogen element includes sulfur, and a mole ratio of gallium to indium (Ga:In) in the semiconductor nanoparticle is greater than or equal to about 19.7:1.

In an embodiment, the gallium precursor includes gallium bromide and optionally gallium chloride.

In an embodiment, the method includes combining, in the medium, the first particle, the sulfur precursor, and the gallium precursor, and the first particle includes a second semiconductor nanocrystal that is disposed on the first semiconductor nanocrystal and includes sulfur and gallium, and forming the first particle includes combining, in a first medium including a first organic solvent, the first semiconductor nanocrystal, a first sulfur precursor, a first gallium precursor, and optionally a first silver compound; heating the first medium to a first reaction temperature; and separating a particle formed in the first medium.

In an embodiment, forming the first particle further includes washing the separated first particle with an alcohol solvent of C1 to C10.

In an embodiment, the acid compound includes a carboxylic acid, a sulfonic acid, or a combination thereof, including halogen.

In an embodiment, the acid compound includes trichloroacetic acid, trifluoroacetic acid, chlorosulfonic acid, p-toluenesulfonic acid, trichloromethyl(chloromethyl)propanoic acid, trichloromethylpropanoic acid, or a combination thereof. In an embodiment, the acid compound includes two or more of the foregoing acids.

In an embodiment, the acid compound is added to the medium during formation of the second semiconductor nanocrystal or after completion of the formation of the second semiconductor nanocrystal.

In an embodiment, the method includes stirring, after adding the acid compound to the medium, for a time of greater than or equal to about 10 minutes and less than or equal to about 10 hours.

In an embodiment, a semiconductor nanoparticle includes silver, indium, gallium, and sulfur. A mole ratio of gallium to indium (Ga:In) in the semiconductor nanoparticle is greater than or equal to about 20:1 and less than or equal to about 40:1,

and the semiconductor nanoparticle has a quantum yield of greater than or equal to about 90% and less than or equal to about 100%.

In an embodiment, the semiconductor nanoparticle includes silver, indium, gallium, and sulfur, the mole ratio of gallium to indium (Ga:In) in the semiconductor nanoparticle is greater than or equal to about 20:1 and less than or equal to about 40:1, and the semiconductor nanoparticle includes fluorine, chlorine, bromine, or a combination thereof.

In an embodiment, the semiconductor nanoparticle has a quantum yield of greater than or equal to about 92% and less than or equal to about 98%.

In an embodiment, the mole ratio of gallium to indium in the semiconductor nanoparticle is greater than or equal to about 20.5:1 and less than or equal to about 35:1.

In an embodiment, the semiconductor nanoparticle further includes an acid compound having a dipole moment of greater than or equal to about 2 debye.

In an embodiment, the semiconductor nanoparticle further includes a halogen and a carboxylic acid moiety.

In an embodiment, the semiconductor nanoparticle further includes fluorine and a carboxylic acid moiety.

In an embodiment, the semiconductor nanoparticle has, in a thermogravimetric analysis result, a residue amount of greater than or equal to about 80 wt%.

In an embodiment, the semiconductor nanoparticle has a trap-emission percentage obtained by the following expression of less than or equal to about 8%:

Trap-emission percentage = [trap-emission area of an emission spectrum / total area of the emission spectrum] $\times$ 100%, where the trap emission area refers to an area of a trap emission region, and the trap-emission region refers to a region of greater than or equal to about the peak emission wavelength + 50 nm.

In an embodiment, the semiconductor nanoparticle is configured to emit green light,

and the green light has a full width at half maximum of greater than or equal to about 2 nm and less than or equal to about 35 nm.

An electronic device of an embodiment includes a color conversion layer,

the color conversion layer includes nanoparticles, and the nanoparticles include the semiconductor nanoparticle.

In an embodiment, the electronic device includes a light emitting panel including a light source and a color conversion panel, the color conversion panel includes the color conversion layer, and the light source is configured to

provide incident light to the color conversion panel.

In an embodiment, a method of manufacturing an electronic device including a color conversion layer includes providing a light emitting panel; providing a color conversion panel including the color conversion layer; and combining the light emitting panel and the color conversion panel, where the color conversion layer includes a semiconductor nanoparticle, and the semiconductor nanoparticle includes silver, indium, gallium, and sulfur, a mole ratio of gallium to indium (Ga/In) in the semiconductor nanoparticle is greater than or equal to about 20:1 and less than or equal to about 40:1, and the semiconductor nanoparticle has a quantum yield of greater than or equal to about 90% and less than or equal to about 100%.

While this disclosure has been described in connection with what is presently considered to be practical embodiments, it is to be understood that the present subject matter is not limited to the disclosed exemplary embodiments. On the contrary, it is intended to cover various modifications and equivalent arrangements included within the scope of the appended claims.

## Claims

**1.** A method of manufacturing a semiconductor nanoparticle, the method comprising:

combining, in a medium including an organic solvent, a sulfur precursor; a gallium precursor; and a first semiconductor nanocrystal including silver, a Group 13 element, and a chalcogen element, or a first particle including the first semiconductor nanocrystal; and
heating the medium to a reaction temperature to form a second semiconductor nanocrystal including sulfur and gallium on the first semiconductor nanocrystal or the first particle, and
adding an acid compound to the medium, wherein the acid compound has a dipole moment of greater than or equal to 2 debye and less than or equal to 5 debye.

**2.** The method of claim 1,
wherein the Group 13 element includes indium and gallium, the chalcogen element includes sulfur, and a mole ratio of gallium to indium in the semiconductor nanoparticle is greater than or equal to 19.7:1.

**3.** The method of claim 1 or 2,
wherein the gallium precursor includes gallium bromide and optionally gallium chloride.

**4.** The method of any preceding claim,

wherein the method includes combining, in the medium, the first particle, the sulfur precursor, and the gallium precursor,
and the first particle further includes the second semiconductor nanocrystal disposed on the first semiconductor nanocrystal and including sulfur and gallium,
and forming the first particle includes combining, in a first medium including a first organic solvent, the first semiconductor nanocrystal, a first sulfur precursor, a first gallium precursor, and optionally a first silver compound; heating the first medium to a first reaction temperature; and separating a particle formed in the first medium to provide a separated first particle,
and optionally further comprising washing the separated first particle with an alcohol solvent of C1 to C10.

**5.** The method of any preceding claim,
wherein the acid compound comprises a carboxylic acid comprising a halogen, a 5 sulfonic acid, or a combination thereof.

**6.** The method of any preceding claim,
wherein the acid compound includes trichloroacetic acid, trifluoroacetic acid, chlorosulfonic acid, p-toluenesulfonic acid, 3,3,3-trichloro-2-(trichloromethyl)propanoic acid, 3,3,3-trichloromethylpropanoic acid, 3,3,3-trichloropropanoic acid, or a combination thereof.

**7.** The method of any preceding claim,
wherein the acid compound is added to the medium during formation of the second semiconductor nanocrystal or after completion of formation of the second semiconductor nanocrystal.

**8.** The method of any preceding claim,
wherein the method further comprises stirring, after adding the acid compound to the medium, for a time of greater than or equal to 10 minutes and less than or equal to 10 hours.

**9.** A semiconductor nanoparticle,

wherein the semiconductor nanoparticle includes silver, indium, gallium, and sulfur,
a mole ratio of gallium to indium (Ga/In) in the semiconductor nanoparticle is greater than or equal to 20:1 and less than or equal to 40:1,
and the semiconductor nanoparticle has a quantum yield of greater than or equal to 90% and less than or equal to 100%.

**10.** The semiconductor nanoparticle of claim 9,
wherein the mole ratio of gallium to indium is greater than or equal to 20.5:1 and less than or equal to 35:1.

**11.** The semiconductor nanoparticle of claim 9 or 10, wherein the semiconductor nanoparticle further includes an acid compound having a dipole moment of greater than or equal to 2 debye.

**12.** The semiconductor nanoparticle of any of claims 9 to 11, wherein the semiconductor nanoparticle further includes either a halogen and a carboxylic acid moiety or a fluorine and a carboxylic acid moiety.

**13.** The semiconductor nanoparticle of any of claims 9 to 12, wherein the semiconductor nanoparticle has, in a thermogravimetric analysis result, a residue amount of greater than or equal to 80 weight percent.

**14.** The semiconductor nanoparticle of any of claims 9 to 13, wherein the semiconductor nanoparticle has a trap-emission percentage obtained by the following expression of less than or equal to 8%:

Trap-emission percentage = [trap-emission area of an emission spectrum / total area of the emission spectrum] $\times$ 100,

where the trap emission area refers to an area of a trap emission region, and a trap-emission region refers to a region of the emission spectrum at wavelengths greater than or equal to peak emission wavelength plus 50 nanometers; and/or.
wherein the semiconductor nanoparticle is configured to emit green light,
and the green light has a full width at half maximum of greater than or equal to about 2 nanometers and less than or equal to about 35 nanometers.

**15.** An electronic device,

wherein the electronic device includes a color conversion layer,
the color conversion layer includes a semiconductor nanoparticle according to any of claims 10 to 14,
preferably wherein the electronic device further includes a light emitting panel including a light source and a color conversion panel,
the color conversion panel includes the color conversion layer,
and the light source is configured to provide incident light to the color conversion panel.

FIG. 1

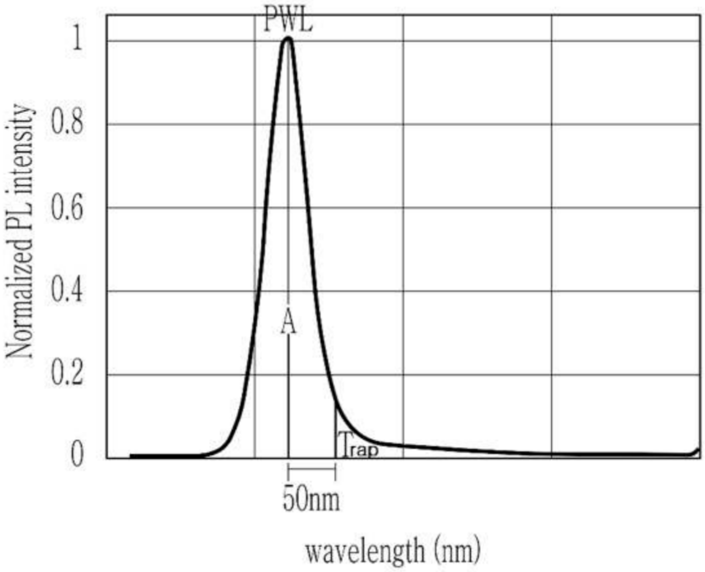
PWL
1
0.8
0.6
0.4
0.2
0
Normalized PL intensity
A
Trap
50nm
wavelength (nm)

FIG. 2 A

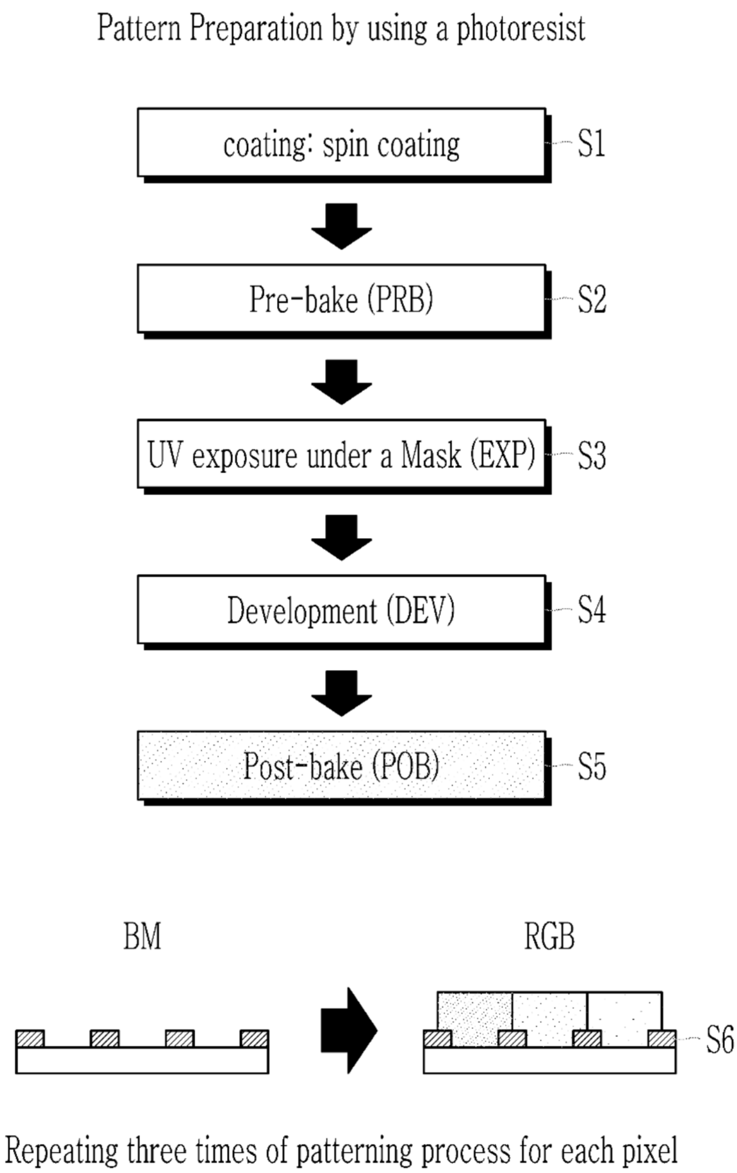
Pattern Preparation by using a photoresist
coating: spin coating
S1
Pre-bake (PRB)
S2
UV exposure under a Mask (EXP)
S3
Development (DEV)
S4
Post-bake (POB)
S5
BM
RGB
S6
Repeating three times of patterning process for each pixel

FIG. 2B

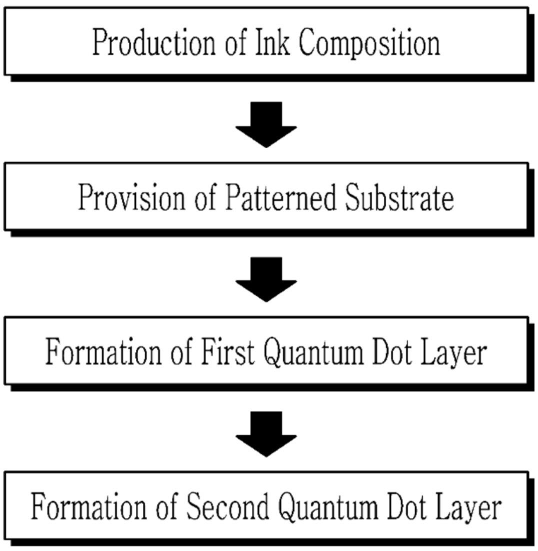
Production of Ink Composition
Provision of Patterned Substrate
Formation of First Quantum Dot Layer
Formation of Second Quantum Dot Layer

FIG. 3A

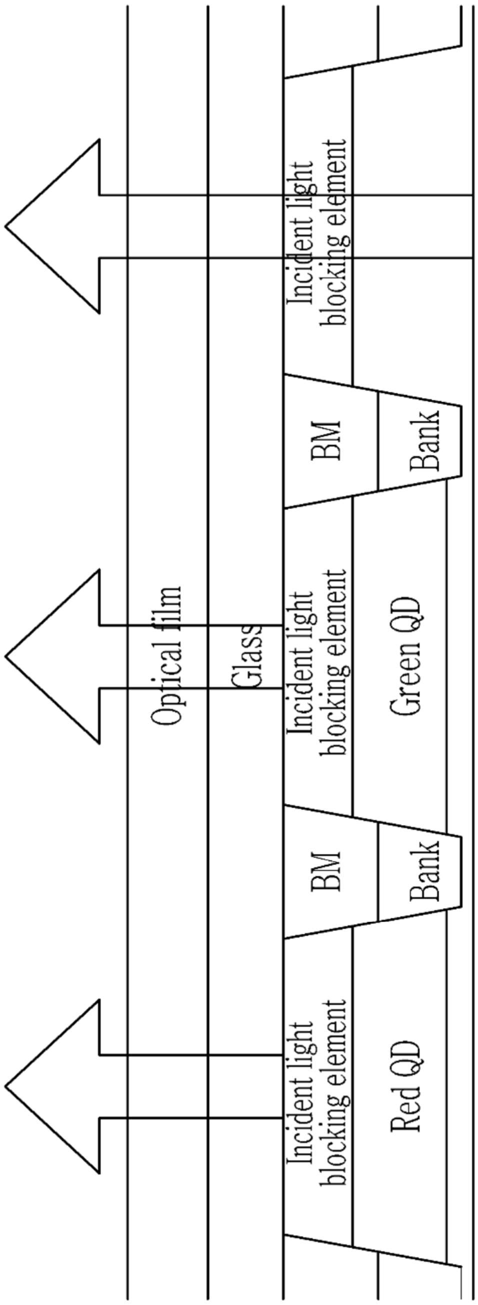
Optical film
Glass
Incident light blocking element
Red QD
BM
Bank
Incident light blocking element
Green QD
BM
Bank
Incident light blocking element

FIG. 3B

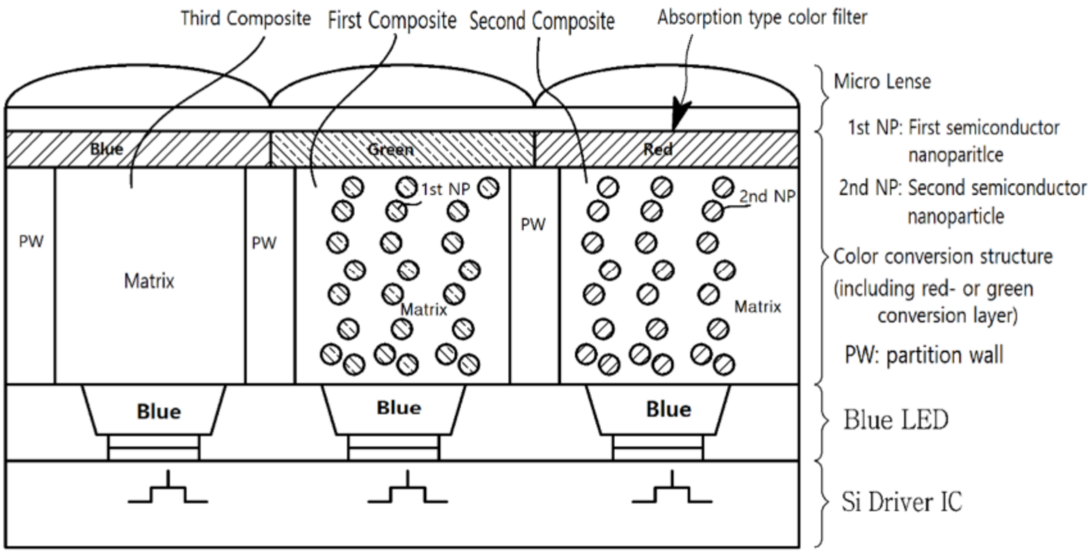
Third Composite
First Composite
Second Composite
Absorption type color filter
Micro Lense
1st NP: First semiconductor nanoparitlce
2nd NP: Second semiconductor nanoparticle
Color conversion structure (including red- or green conversion layer)
PW: partition wall
Blue LED
Si Driver IC
Blue
Green
Red
PW
Matrix
1st NP
2nd NP
Blue
Blue
Blue

FIG. 4A

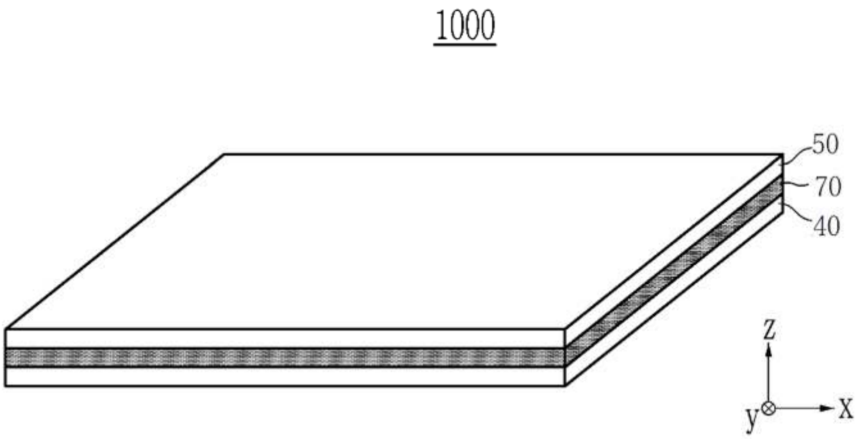

FIG.4B

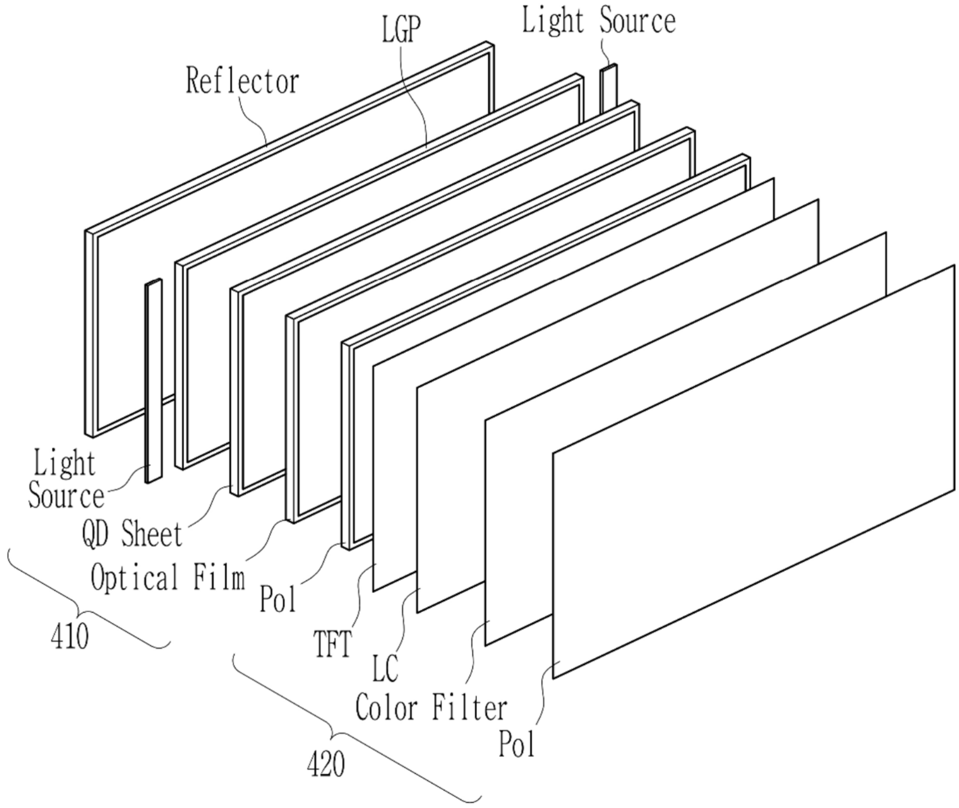
LGP
Light Source
Reflector
Light
Source
QD Sheet
Optical Film
Pol
410
TFT
LC
Color Filter
Pol
420

FIG. 4C

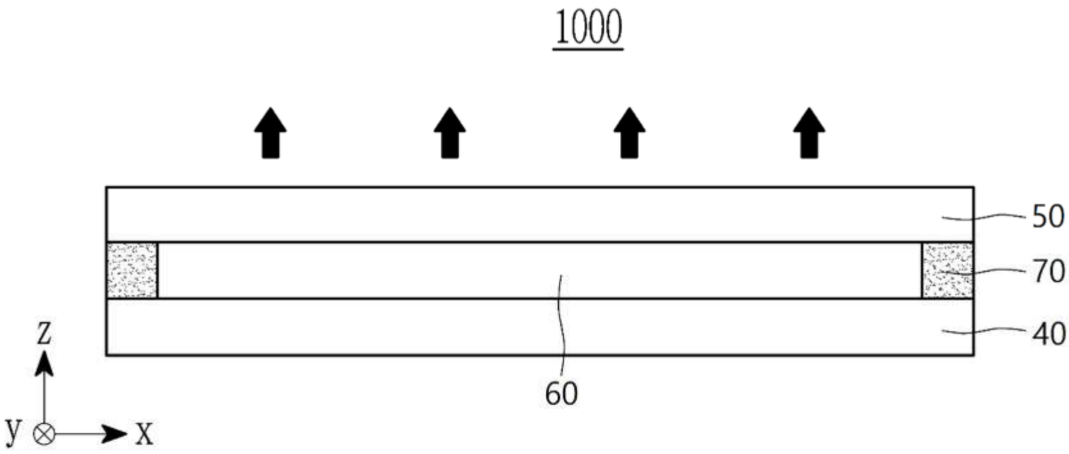
1000
50
70
40
60
z
y
x

FIG. 4D

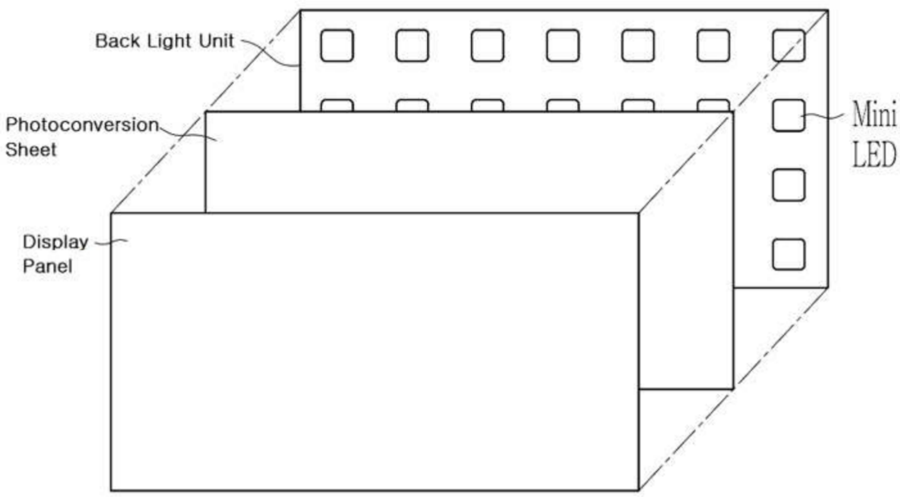
Back Light Unit
Photoconversion Sheet
Display Panel
Mini LED

FIG. 5A

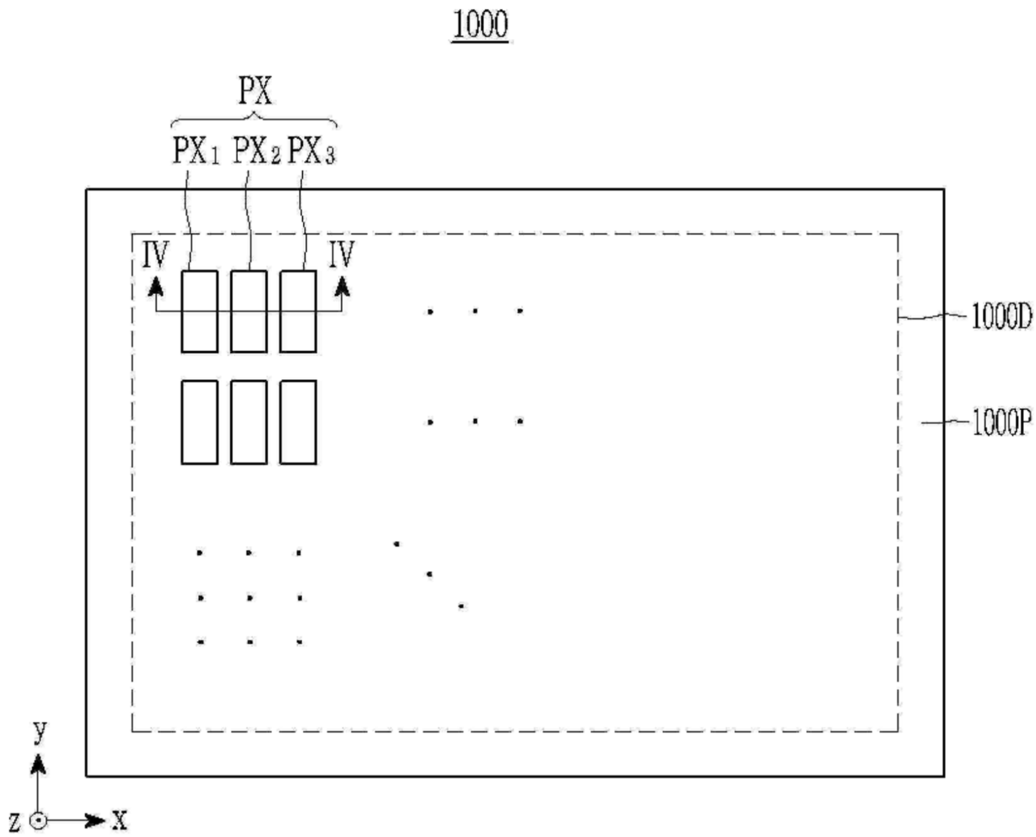
1000
PX
PX1 PX2 PX3
IV
IV
1000D
1000P
y
z
x

FIG. 5B

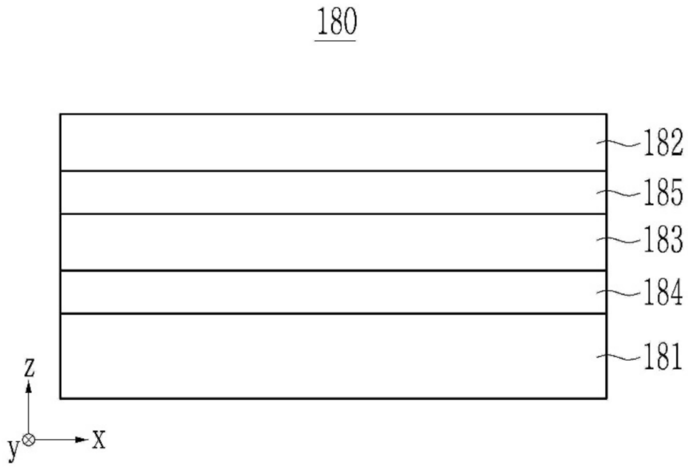
180
182
185
183
184
181
z
y
x

FIG. 5C

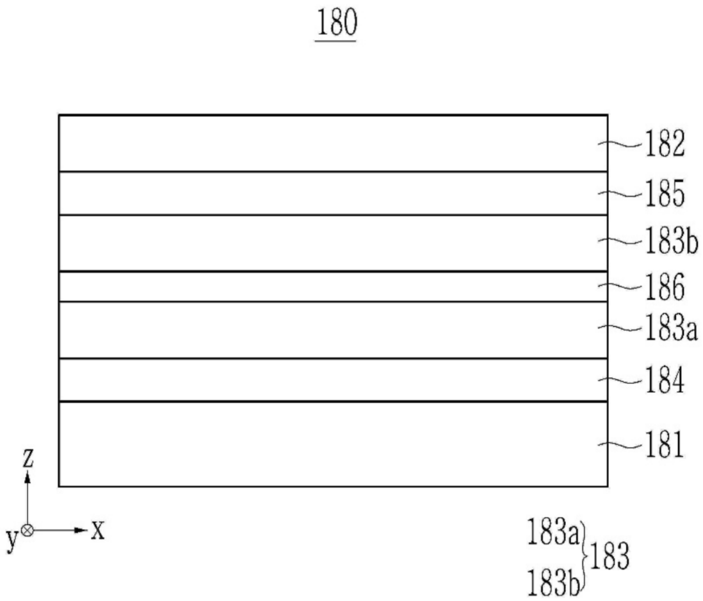
180
182
185
183b
186
183a
184
181
z
y
x
183a
183b
183

FIG. 5D

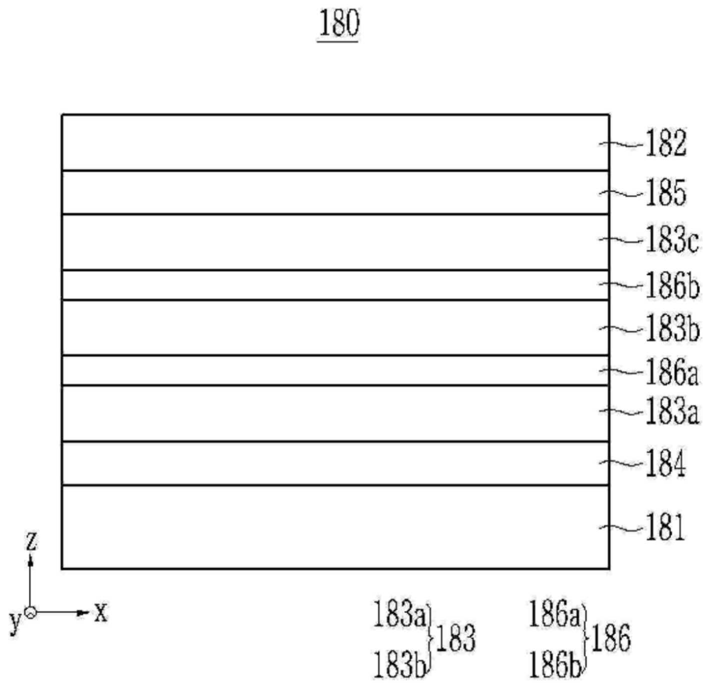
180
182
185
183c
186b
183b
186a
183a
184
181
z
y
x
183a
183b
183
186a
186b
186

FIG. 5E

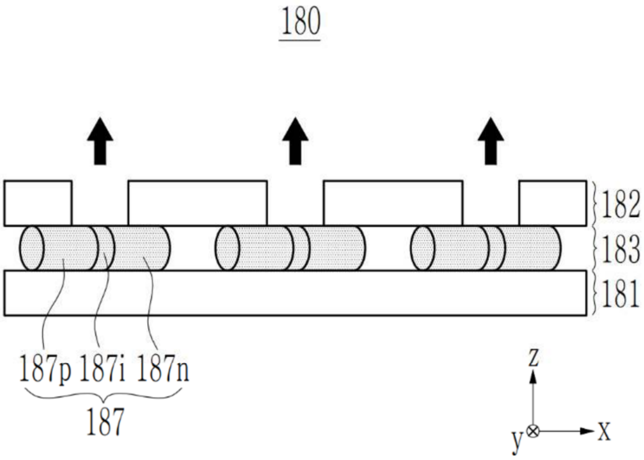

FIG. 6

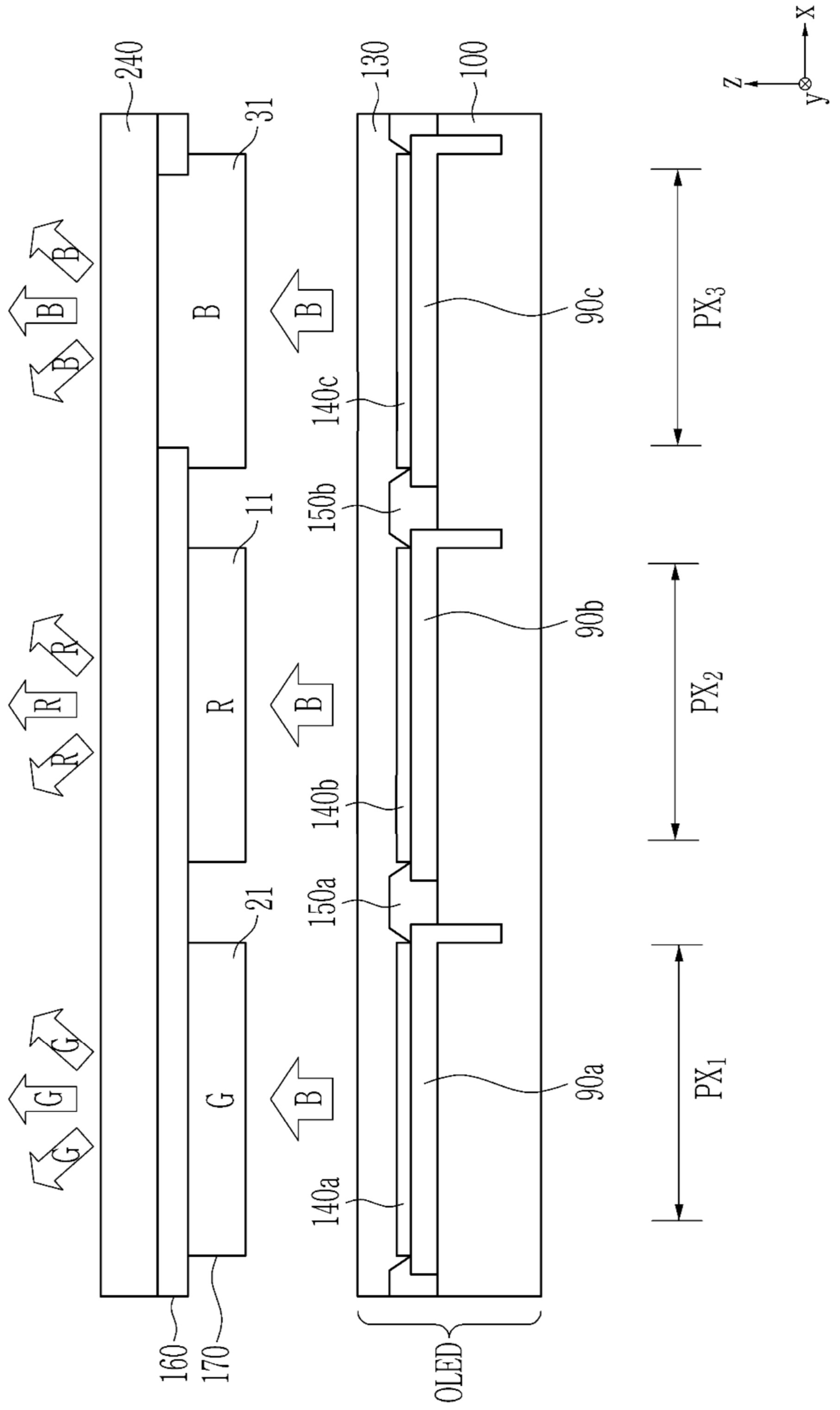
240
31
11
21
160
170
B
R
G
130
100
140c
150b
140b
150a
140a
90c
90b
90a
PX3
PX2
PX1
OLED
x
y
z

FIG. 7A

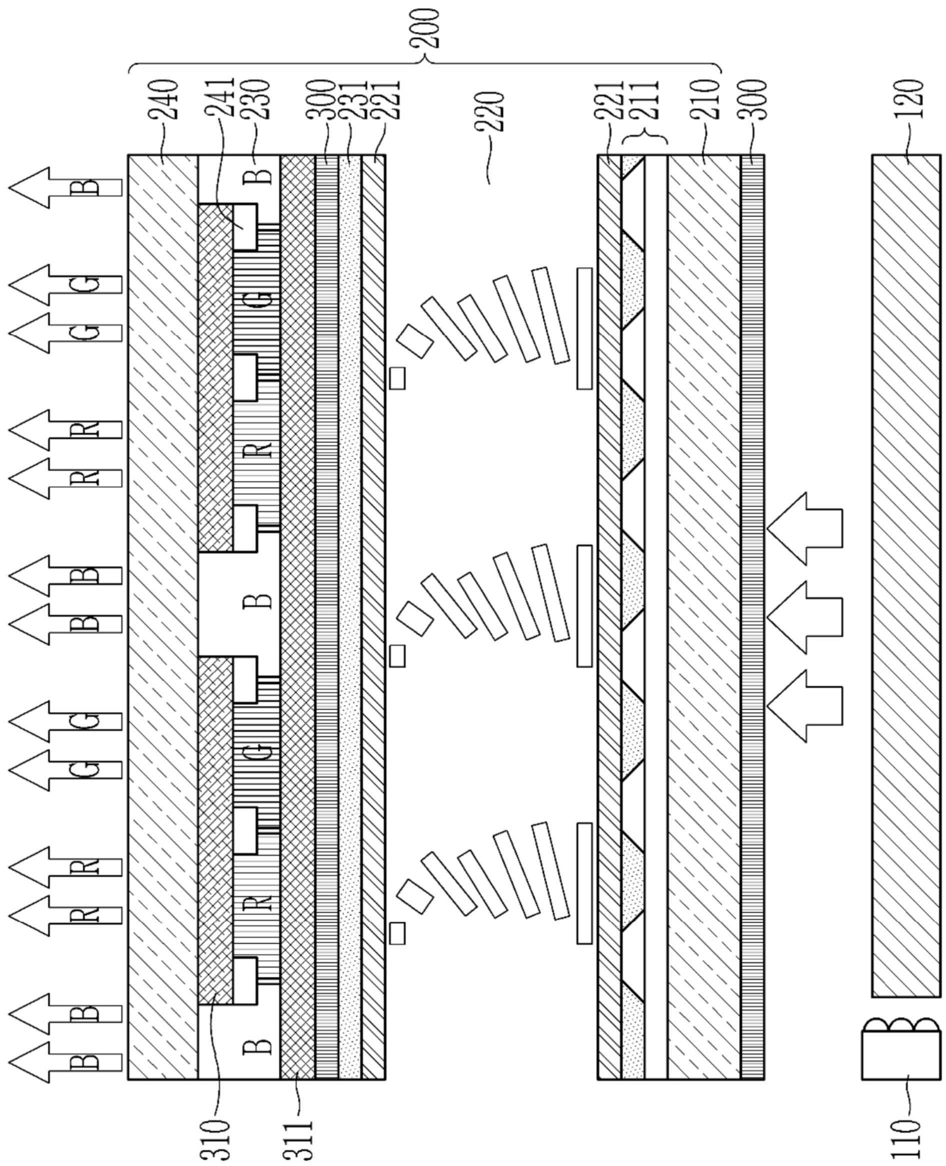
200
240
241
230
300
231
221
220
221
211
210
300
120
310
311
110
B
G
R

FIG. 7B

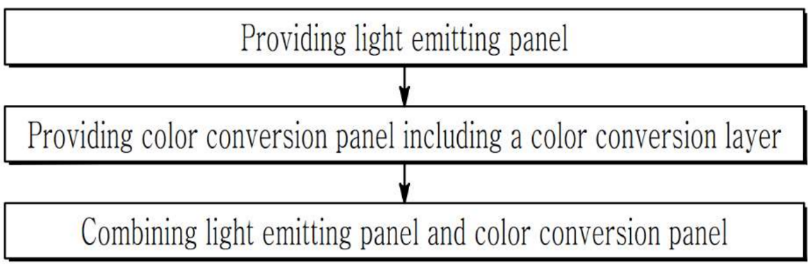
Providing light emitting panel
Providing color conversion panel including a color conversion layer
Combining light emitting panel and color conversion panel

FIG. 7C

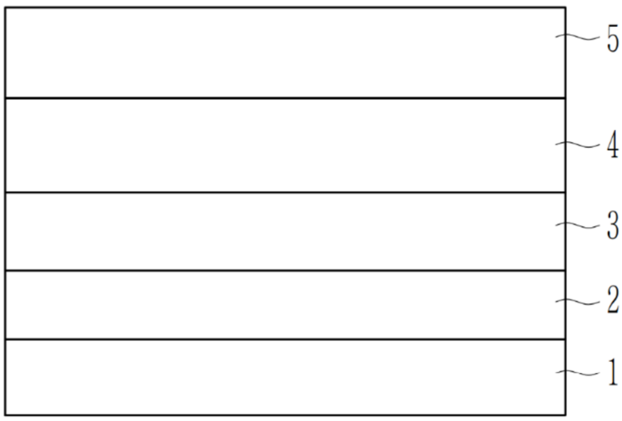

FIG. 8A

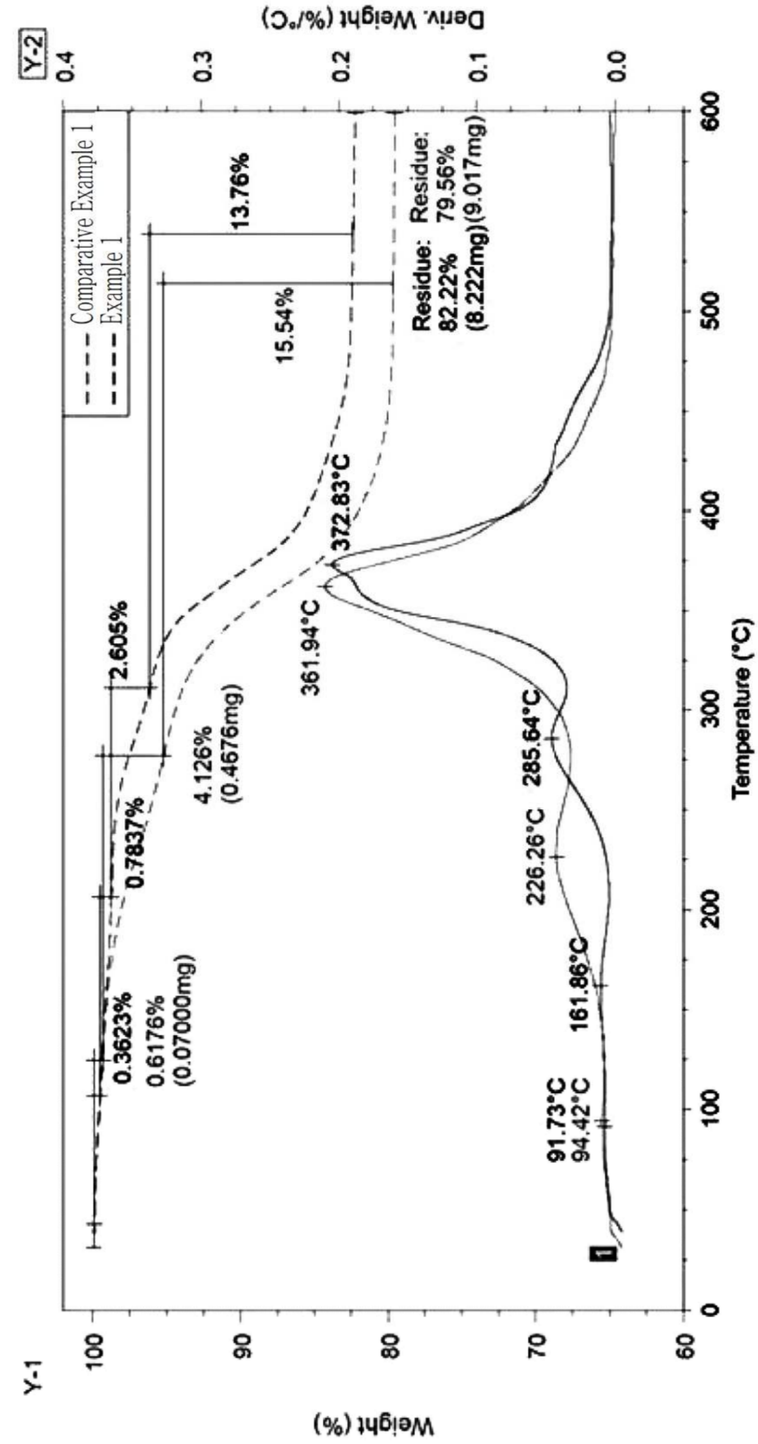

Y-1
Weight (%)
Y-2
Deriv. Weight (%/°C)
Temperature (°C)
Comparative Example 1
Example 1
0.3623%
0.6176%
(0.07000mg)
0.7837%
4.126%
(0.4676mg)
2.605%
15.54%
13.76%
Residue:
82.22%
(8.222mg)
Residue:
79.56%
(9.017mg)
91.73°C
94.42°C
161.86°C
226.26°C
285.64°C
361.94°C
372.83°C

FIG. 8B

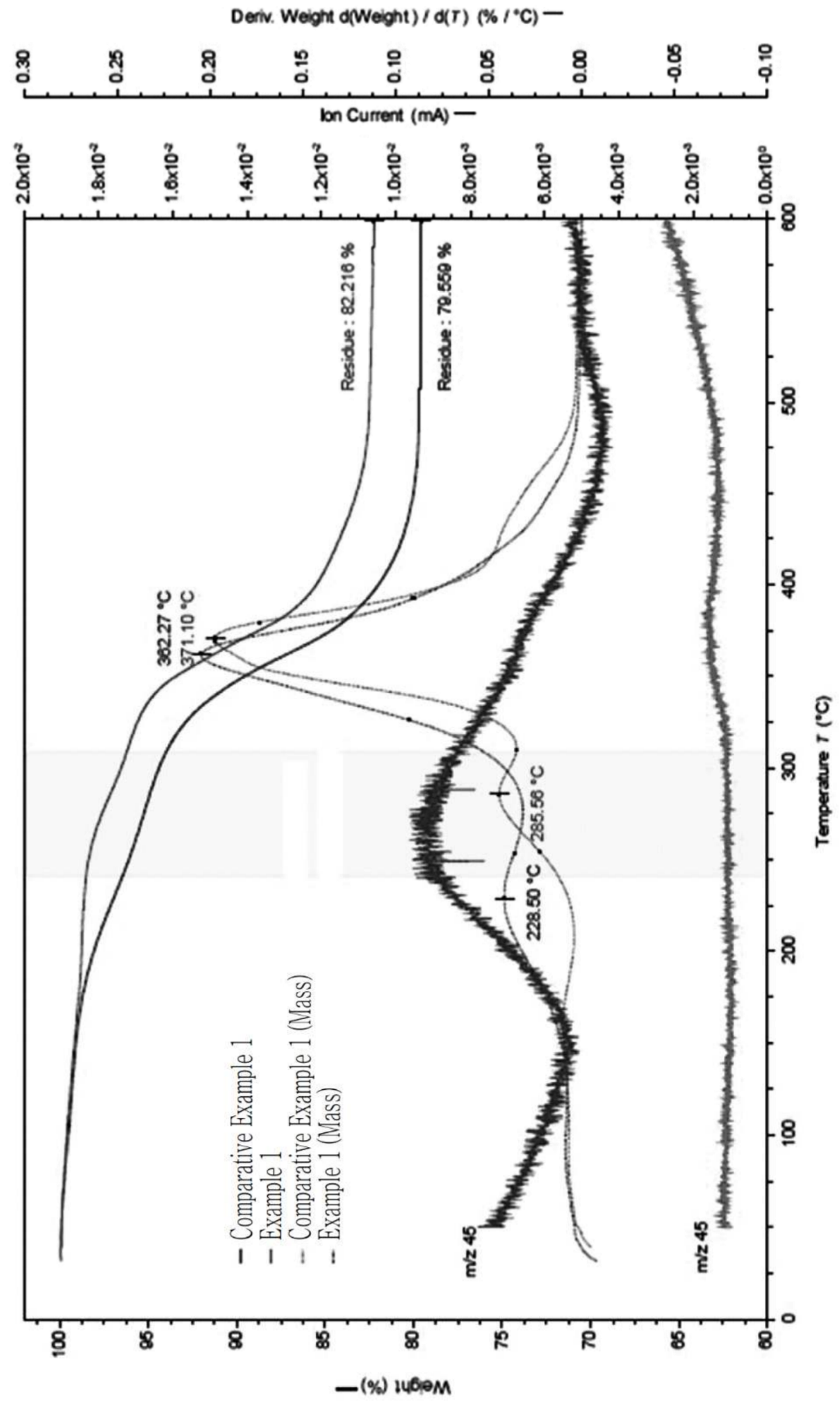
Deriv. Weight d(Weight) / d(T) (% / °C)
Ion Current (mA)
Weight (%)
Temperature T (°C)
Comparative Example 1
Example 1
Comparative Example 1 (Mass)
Example 1 (Mass)
Residue : 82.216 %
Residue : 79.559 %
362.27 °C
371.10 °C
285.56 °C
228.50 °C
m/z 45
m/z 45

FIG. 9A

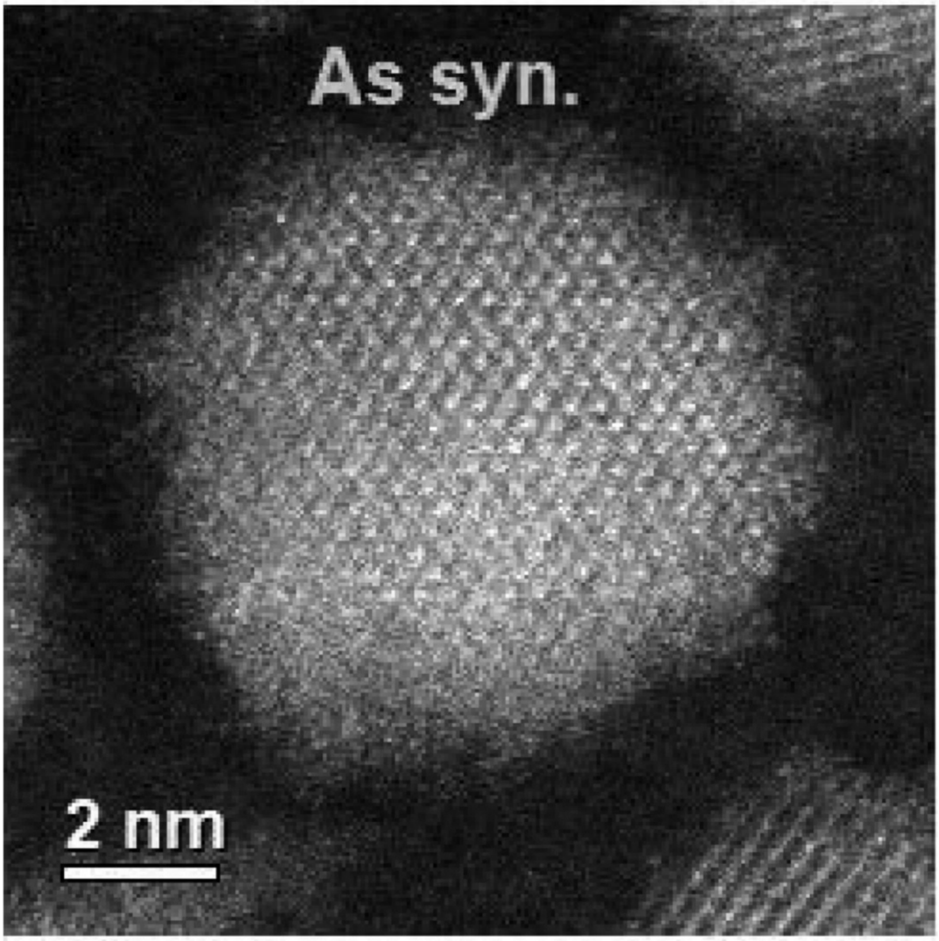

FIG. 9B

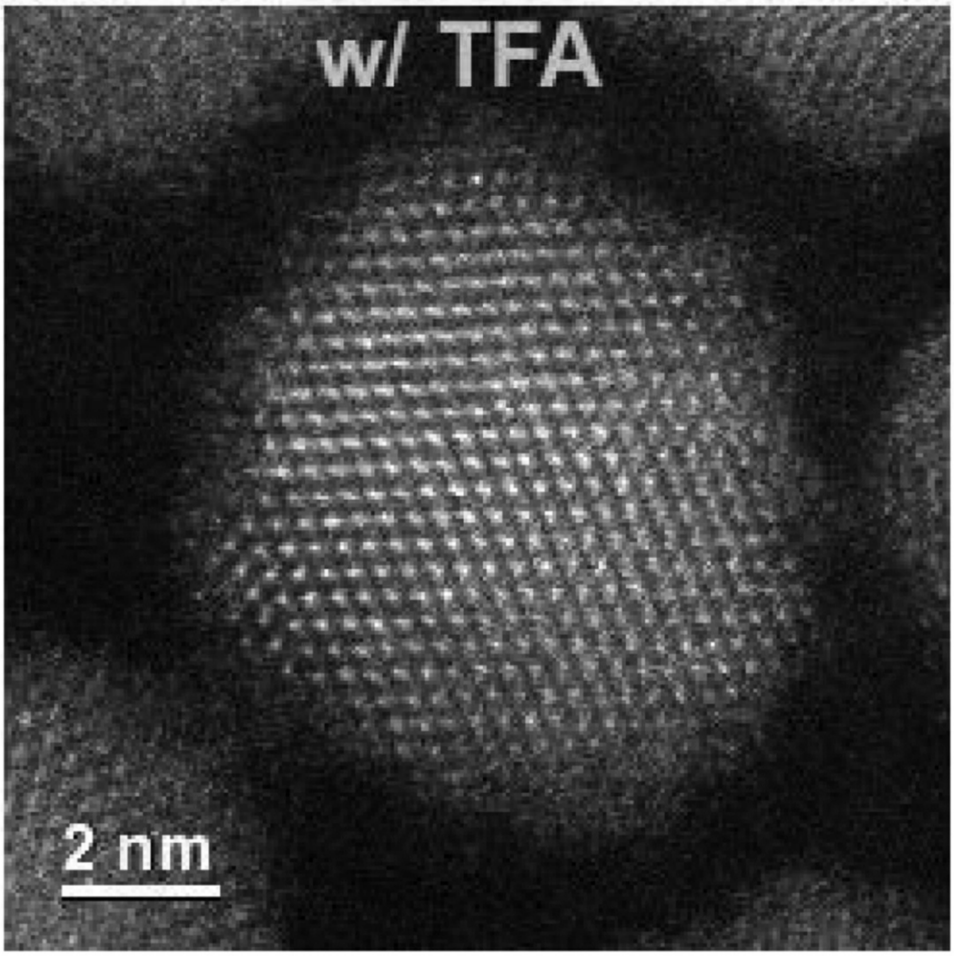

FIG. 10

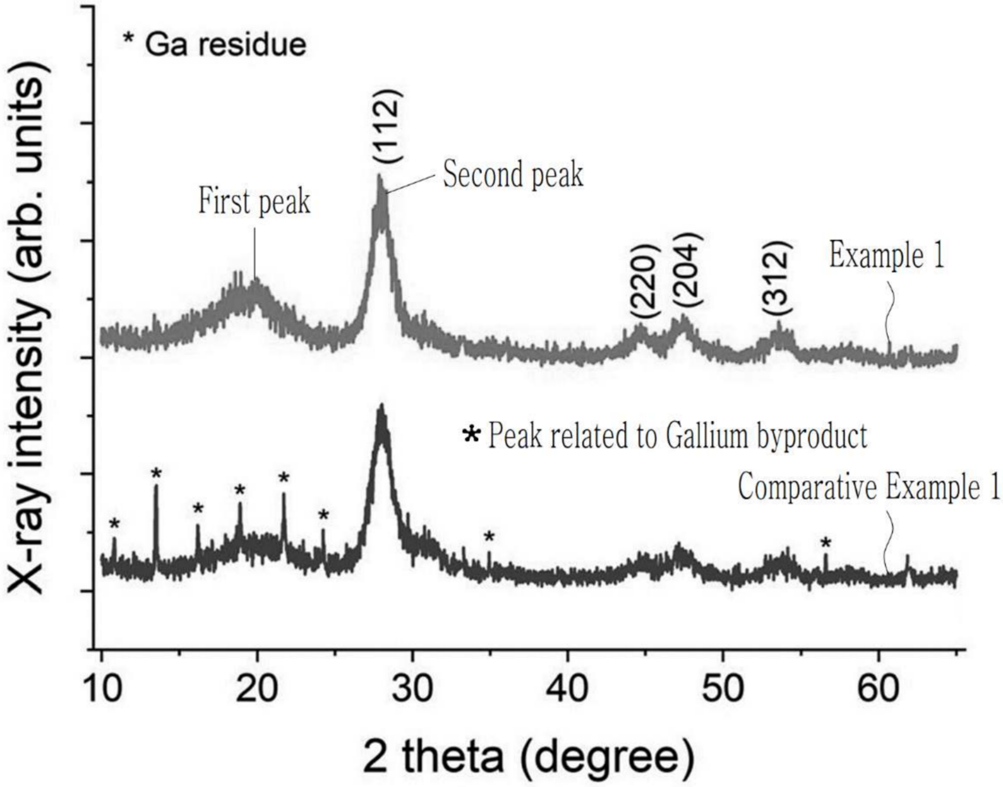
* Ga residue
X-ray intensity (arb. units)
First peak
(112)
Second peak
(220)
(204)
(312)
Example 1
* Peak related to Gallium byproduct
Comparative Example 1
10
20
30
40
50
60
2 theta (degree)

FIG. 11

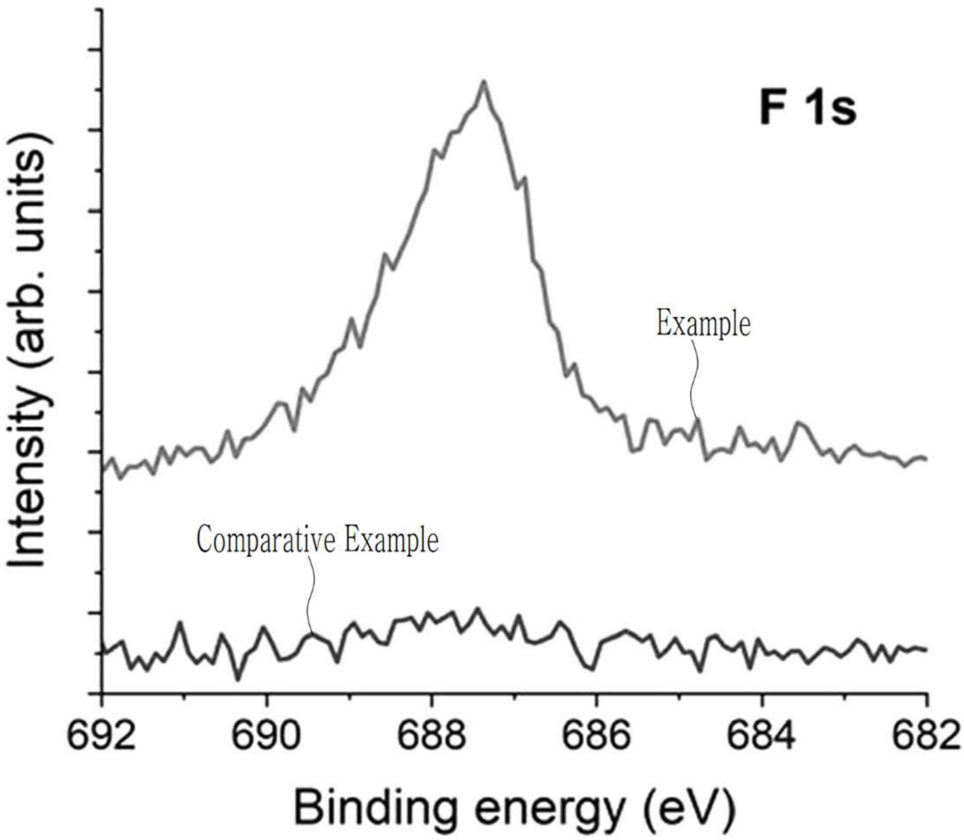
F 1s
Example
Comparative Example
Intensity (arb. units)
692
690
688
686
684
682
Binding energy (eV)

FIG. 12

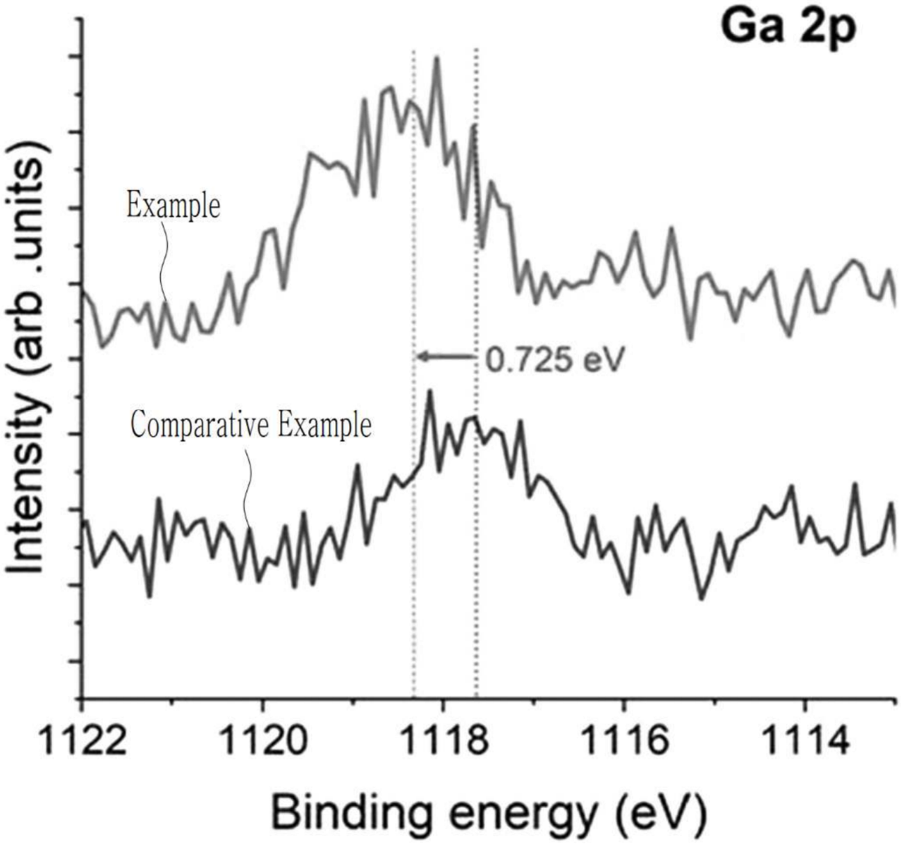
Ga 2p
Example
Comparative Example
0.725 eV
Intensity (arb .units)
1122
1120
1118
1116
1114
Binding energy (eV)

FIG. 13

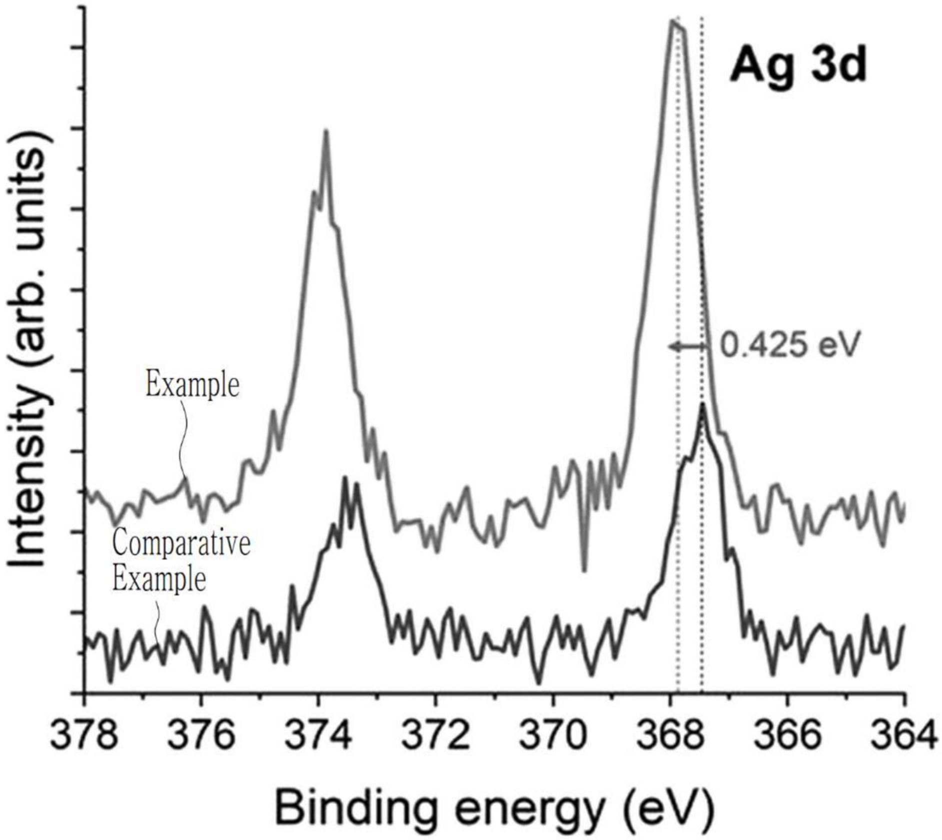
Ag 3d
0.425 eV
Example
Comparative Example
Intensity (arb. units)
378
376
374
372
370
368
366
364
Binding energy (eV)

FIG. 14

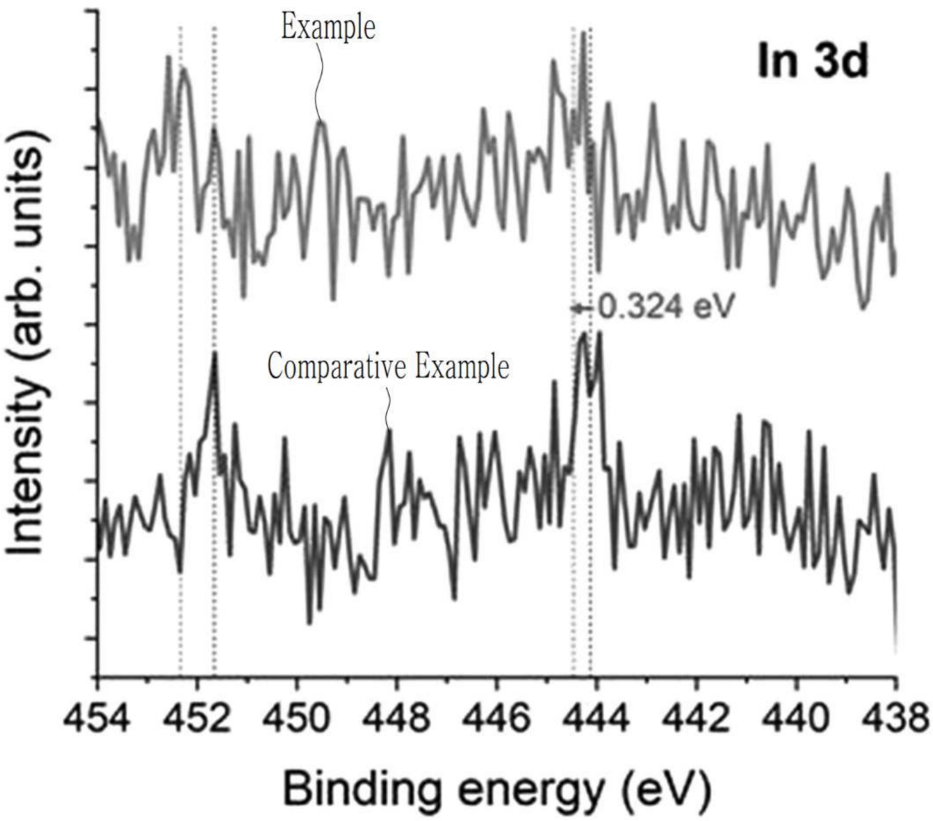
Example
In 3d
0.324 eV
Comparative Example
Intensity (arb. units)
454
452
450
448
446
444
442
440
438
Binding energy (eV)

FIG. 15

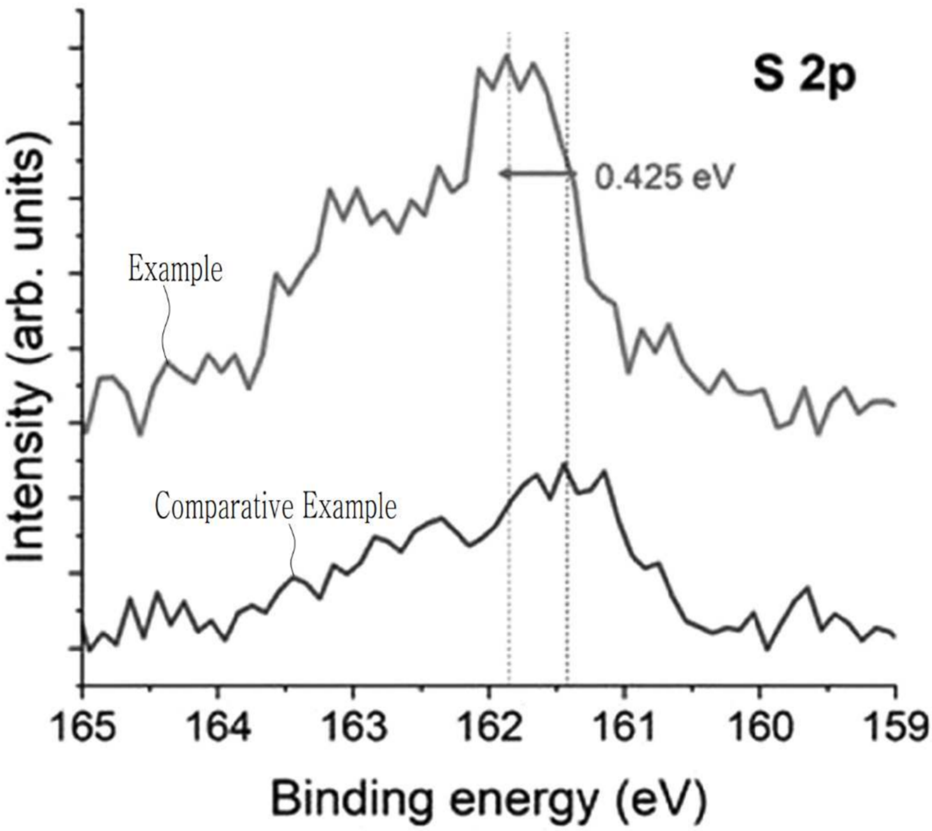
S 2p
0.425 eV
Example
Comparative Example
Intensity (arb. units)
165
164
163
162
161
160
159
Binding energy (eV)

European Patent Office

# EUROPEAN SEARCH REPORT

Application Number
EP 26 15 1090

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X<br>A | US 2024/079518 A1 (MISHIMA AKIO [JP] ET AL) 7 March 2024 (2024-03-07)<br>* Claims 1-11; [0046], [0081], [0097]; [0109]-[0112]; Examples 1-5 *<br>----- | 9,10, 12-15<br>1-8,11 | INV.<br>C09K11/02<br>C09K11/62 |
| | | | TECHNICAL FIELDS SEARCHED (IPC) |
| | | | C09K |

The present search report has been drawn up for all claims

1

| Place of search | Date of completion of the search | Examiner |
|---|---|---|
| The Hague | 20 April 2026 | Mehdaoui, Imed |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
.......................................................................................................
& : member of the same patent family, corresponding document

EPO FORM 1503 03.82 (P04C01)

# ANNEX TO THE EUROPEAN SEARCH REPORT ON EUROPEAN PATENT APPLICATION NO.

EP 26 15 1090

This annex lists the patent family members relating to the patent documents cited in the above-mentioned European search report. The members are as contained in the European Patent Office EDP file on
The European Patent Office is in no way liable for these particulars which are merely given for the purpose of information.

20-04-2026

| Patent document cited in search report | Publication date | Patent family member(s) | Publication date |
|---|---|---|---|
| US 2024079518 A1 | 07-03-2024 | CN 116981753 A | 31-10-2023 |
| | | CN 120555055 A | 29-08-2025 |
| | | EP 4269533 A1 | 01-11-2023 |
| | | JP 7639830 B2 | 05-03-2025 |
| | | JP 7790613 B2 | 23-12-2025 |
| | | JP 2025078645 A | 20-05-2025 |
| | | JP 2026002930 A | 08-01-2026 |
| | | JP WO2022138905 A1 | 30-06-2022 |
| | | KR 20230125272 A | 29-08-2023 |
| | | US 2024079518 A1 | 07-03-2024 |
| | | WO 2022138905 A1 | 30-06-2022 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 20170052444 A1